(19) Europäisches Patentamt
European Patent Office
Office européen des brevets

(11) **EP 3 247 771 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **16703729.0**

(22) Anmeldetag: **20.01.2016**

(51) Int Cl.:
***C09K 11/06*** *(2006.01)* ***H01L 51/50*** *(2006.01)*
***H01L 51/00*** *(2006.01)*

(86) Internationale Anmeldenummer:
**PCT/EP2016/051153**

(87) Internationale Veröffentlichungsnummer:
**WO 2016/116517 (28.07.2016 Gazette 2016/30)**

(54) **PYRIDINE UND DEREN DERIVATE ALS BAUSTEINE ZUR VERWENDUNG IN OPTOELEKTRONISCHEN BAUELEMENTEN**

PYRIDINES AND DERIVATIVES THEREOF AS COMPONENTS FOR USE IN OPTOELECTRONIC COMPONENTS

PYRIDINES ET LEURS DÉRIVÉS EN TANT QUE CONSTITUANTS UTILISABLES DANS DES COMPOSANTS OPTOÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2015 EP 15151870**
**20.05.2015 DE 102015107994**

(43) Veröffentlichungstag der Anmeldung:
**29.11.2017 Patentblatt 2017/48**

(73) Patentinhaber: **CYNORA GMBH**
**76646 Bruchsal (DE)**

(72) Erfinder:
- **AMBROSEK, David**
**10437 Berlin (DE)**
- **DANZ, Michael**
**76344 Eggenstein-Leopoldshafen (DE)**
- **FLÜGGE, Harald**
**76135 Karlsruhe (DE)**
- **FRIEDRICHS, Jana**
**76137 Karlsruhe (DE)**
- **GRAB, Tobias**
**76133 Karlsruhe (DE)**
- **JACOB, Andreas**
**30449 Hannover (DE)**
- **SEIFERMANN, Stefan**
**77815 Bühl (DE)**
- **VOLZ, Daniel**
**76137 Karlsruhe (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**WO-A1-2010/090925 WO-A1-2016/046077**
**WO-A2-2006/010637 US-A1- 2011 306 922**
**US-A1- 2012 153 272**

- **Minoru Ishikura ET AL: "An efficient synthesis of 3-heteroarylpyridines via diethyl-(3-pyridyl)-borane", Synthesis, 1. Januar 1984 (1984-01-01), Seiten 936-938, XP055026581, Gefunden im Internet: URL:https://www.thieme-connect.com/products/ejournals/pdf/10.1055/s-1984-31026.pdf [gefunden am 2012-05-09]**
- **HIROKI UOYAMA ET AL: "Highly efficient organic light-emitting diodes from delayed fluorescence", NATURE, Bd. 492, Nr. 7428, 12. Dezember 2012 (2012-12-12), Seiten 234-238, XP055048388, ISSN: 0028-0836, DOI: 10.1038/nature11687**
- **GEORGE R. NEWKOME ET AL: "Synthesis of 2,2'-Bipyridines: Versatile Building Blocks for Sexy Architectures and Functional Nanomaterials", EUROPEAN JOURNAL OF ORGANIC CHEMISTRY, Bd. 2004, Nr. 2, 1. Januar 2004 (2004-01-01), Seiten 235-254, XP055268284, DE ISSN: 1434-193X, DOI: 10.1002/ejoc.200300399**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 247 771 B1

## Beschreibung

Die Erfindung betrifft rein organische Moleküle und deren Verwendung in organischen lichtemittierenden Dioden (OLEDs) und in anderen optoelektronischen Bauelementen. Anspruch 1 betrifft organische Moleküle aufweisend eine Struktur der Formel 3b,

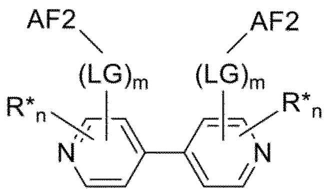

**Formel 3b**

Anspruch 6 betrifft die Verwendung derartiger organischer Moleküle, Anspruch 10 betrifft ein optoelektronisches Bauelement, aufweisend ein derartiges organisches Molekül und Anspruch 17 betrifft ein Verfahren zur Herstellung des optoelektronischen Bauelements.

## Stand der Technik

In den letzten Jahren hat sich die auf OLED (organische lichtemittierende Dioden) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik. Aus diesem Grund wird bezüglich der Entwicklung neuer Materialien intensive Forschung betrieben.

OLEDs sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass zumindest theoretisch alle Exzitonen in Licht umgewandelt werden können. Bei diesen Materialien handelt es sich in der Regel um Übergangsmetall-Komplexverbindungen, in denen das Metall aus der dritten Periode der Übergangsmetalle gewählt wird. Hierbei werden vorwiegend sehr teure Edelmetalle wie Iridium, Platin oder auch Gold eingesetzt. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Neben den Kosten ist auch die Stabilität der Materialien zum Teil nachteilig für die Verwendung.

Eine neue Generation von OLEDs basiert auf der Ausnutzung von verzögerter Fluoreszenz (TADF: thermally activated delayed fluorescence oder auch singlet harvesting). Hierbei können beispielsweise Cu(I)-Komplexe verwendet werden, die aufgrund eines geringen Energieabstandes zwischen dem untersten Triplett-Zustand $T_1$ und dem darüberliegenden Singulett-Zustand $S_1$ ($\Delta E(S_1-T_1)$ Triplett-Exitonen thermisch in einen Singulett-Zustand rückbesetzen können. Neben der Verwendung von Übergangsmetallkomplexen können auch rein organische Moleküle diesen Effekt ausnutzen.

Einige solcher TADF-Materialien wurden bereits in ersten optoelektronischen Bauelementen eingesetzt. Die bisherigen Lösungen weisen jedoch Nachteile und Probleme auf: Die TADF-Materialien weisen in den optoelektronischen Bauelementen oftmals keine ausreichende Langzeitstabilität, keine ausreichende thermische oder keine ausreichende chemische Stabilität gegenüber Wasser und Sauerstoff auf. Außerdem sind nicht alle wichtigen Emissionsfarben verfügbar. Weiterhin sind einige TADF-Materialien nicht verdampfbar und dadurch für den Einsatz in kommerziellen optoelektronischen Bauteilen nicht geeignet. Auch weisen einige TADF-Materialien keine passende Energielagen zu den weiteren im optoelektronischen Bauteil verwendeten Materialien (z.B. HOMO-Energien von TADF-Emittern von größer gleich - 5,9 eV) auf. Nicht mit allen TADF-Materialien lassen sich ausreichend hohe Effizienzen der optoelektronischen

Bauelemente bei hohen Stromdichten bzw. hohe Leuchtdichten erreichen. Weiterhin sind die Synthesen einiger TADF-Materialien aufwendig.

Aus dem Dokumente WO 2010/090925 A1 sind organische Moleküle bekannt.

## Beschreibung

Die Beschreibung betrifft in einem Aspekt die Bereitstellung von organischen Molekülen, die eine Struktur der Formel 1 aufweisen oder eine Struktur der Formel 1 haben:

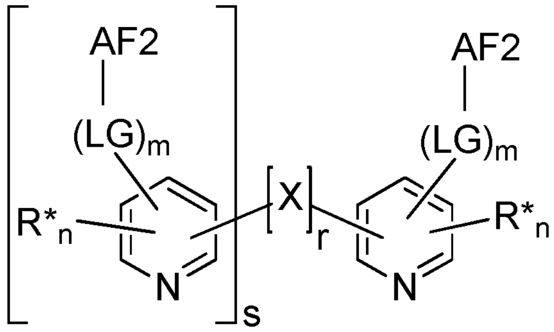

**Formel 1**

und wobei gilt:

X ist $SO_2$, CO oder eine C-C-Einfachbindung;
m ist 0 oder 1;
n ist 1, 2 oder 3;
r ist 0 oder 1;
s ist 0 oder 1;
LG ist eine divalente Linkergruppe, ausgewählt aus:

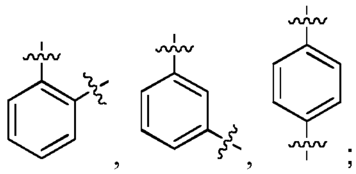

oder LG ist eine Element-Element-Einfachbindung.

Es gilt die Einschränkung, dass die Erfindung keine 2,2'-Bipyridin-Derivate umfasst, das heißt, dass bei s gleich 1, r gleich 1 und X gleich einer C-C-Einfachbindung die Anbindung der beiden Pyridinringe aneinander mindestens bei einem Pyridinring nicht über ein zum N-Atom benachbartes C-Atom erfolgt.

AF2 ist eine elektronendonierende chemische Einheit, beschrieben durch die Formel 2 und aufweisend ein konjugiertes System, insbesondere mindestens sechs in Konjugation stehende π-Elektronen (z. B. in Form mindestens eines aromatischen Systems);

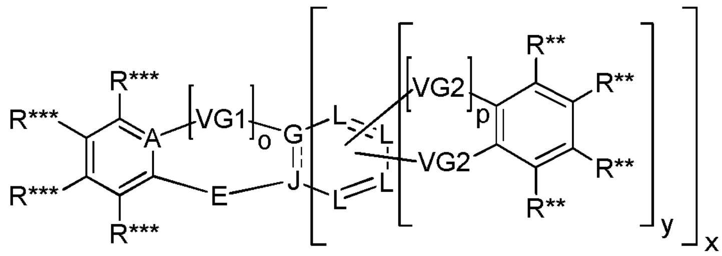

**Formel 2**

wobei gilt:

x ist 0 oder 1;

y ist 0 oder1, wobei bei x = 0 immer auch y = 0 ist;

o ist 0 oder 1;

p ist 0 oder 1;

A ist CR*** wenn o = 0, ansonsten C;

VG1 ist eine verbrückende Gruppe und ist ausgewählt aus der Gruppe bestehend aus

- NR**, $CR^{**}_2$, O, S und einer C-C-Einfachbindung, oder
- NR**, $CR^{**}_2$, O, S, einer C-C-Einfachbindung, BR**, AsR**, $SiR^{**}_2$, $GeR^{**}_2$,

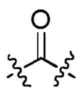, 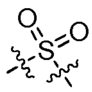, 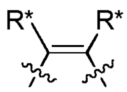, 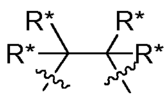, 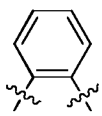, 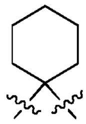, 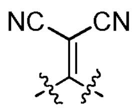, 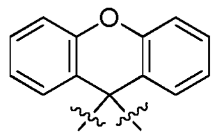,

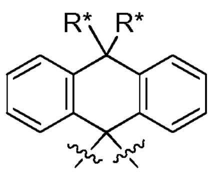, 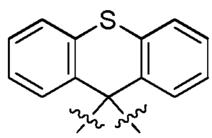 und 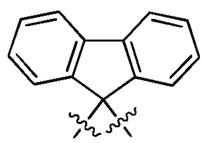,

wenn x = 1 und gleichzeitig y = 0;

VG2 = verbrückende Gruppe ist bei jedem Auftreten unabhängig voneinander $CR^{**}_2$, NR**, O, S oder eine C-C-Einfachbindung, wobei nicht zwei Einheiten VG2 gleichzeitig gleich eine C-C-Einfachbindung sind;

E ist NR**

, 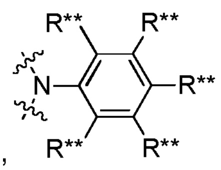,

O oder S;

G ist C wenn o = 1 und gleichzeitig x = 1; G ist CR** wenn o = 0 und gleichzeitig x = 1; G ist CR** oder $CR**_2$, wenn o = 1 und gleichzeitig x = 0; G ist R* wenn o = 0 und gleichzeitig x = 0; G ist CR**, $CR**_2$, N oder NR* wenn x = 0 und gleichzeitig VG1 eine C-C-Einfachbindung ist;

J ist C wenn x = 1; J ist CR**, $CR**_2$ oder NR** wenn x = 0;

L ist CR*** wenn y = 0; L ist CR** oder C (bei kovalenter Bindung zu VG2) wenn y = 1;

R*** ist R** oder ist ausgewählt aus den folgenden Einheiten, wobei maximal zwei der Reste R*** gleichzeitig gleich einer der folgenden Einheiten sind:

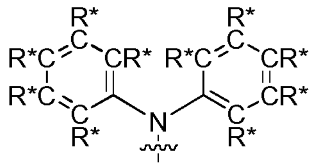
,
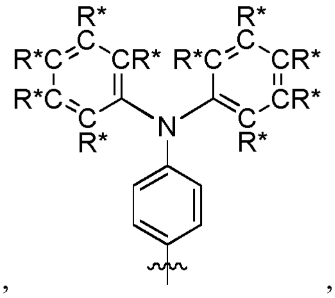
,
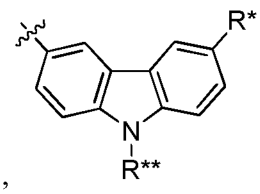
,
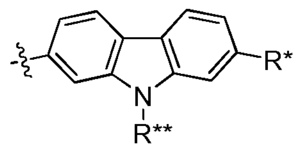
,
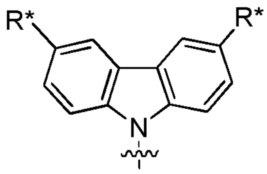
,
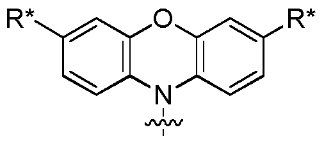
,
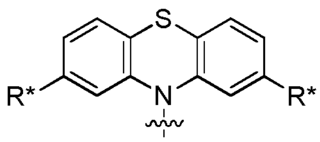
,
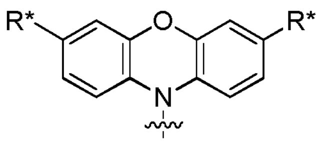
,
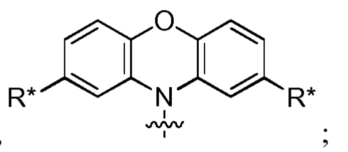
;

R** ist bei jedem Auftreten unabhängig voneinander ein Rest R* und/oder markiert die Anknüpfungsstelle an die Linkergruppe LG bzw. bei m = 0 an die Pyridineinheit der Formel 1;

R* ist bei jedem Auftreten unabhängig voneinander ausgewählt aus der Gruppe bestehend aus H, Deuterium, Phenyl, Naphthyl, $N(R^2)_2$, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $S(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, -C=N-, -C(=O)O-, -C(=O)N($R^3$)-, -P(=O)($R^7$)-, -As(=O)($R^7$)-, -P(=S)($R^7$), -As(=S)($R^7$)-, -S(=0)-, $-S(=O)_2-$, $-NR^2-$, - O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein monozyklisches aliphatisches oder aromatisches Ringsystem mit insgesamt fünf oder sechs Ringgliedern bilden. In einer Ausführungsform ist das Ringsystem, das gebildet werden kann, ein aliphatisches Ringsystem.

$R^2$ ist bei jedem Auftreten unabhängig voneinander ausgewählt aus der Gruppe bestehend aus H, Deuterium,

Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $As(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden.

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

$R^4$ ist bei jedem Auftreten unabhängig voneinander ausgewählt aus der Gruppe bestehend aus H, Deuterium, Phenyl, Naphthyl, $N(R^2)_2$, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, $-As(=O)(R^7)-$, $-P(=S)(R^7)$, - $As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden.

$R^5$ ist bei jedem Auftreten unabhängig voneinander ausgewählt aus der Gruppe bestehend aus Phenyl, Naphthyl, $CF_3$, $C(=O)R^3$, $P(=O)(R^7)_2$, $As(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, - $As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden.

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch-$Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, $-As(=O)(R^7)-$, $-P(=S)(R^7)$, - $As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen,

die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden.

$R^7$ ist bei jedem Auftreten unabhängig voneinander ausgewählt aus der Gruppe bestehend aus, Phenyl, Naphthyl, $N(R^2)_2$, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden.

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden.

$R^9$ ist bei jedem Auftreten unabhängig voneinander ausgewählt aus der Gruppe bestehend aus H, Deuterium, Phenyl, Naphthyl, $N(R^2)_2$, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, -C=N-, -C(=O)O-, - $C(=O)N(R^3)-$, $-P(=O)(R^7)-$, $-As(=O)(R^7)-$, $-P(=S)(R^7)$, $-As(=S)(R^7)-$, -S(=0)-, $-S(=O)_2-$, $-NR^2-$, - O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind insbesondere N, O, und S. Werden in der Beschreibung der vorliegenden Erfindung andere Definitionen angegeben, beispielsweise bezüglich der Zahl der aromatischen Ringatome oder der enthaltenen Heteroatome, so gelten diese anderen Definitionen.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol,

Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind insbesondere ausgewählt aus, N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (insbesondere weniger als 10% der verschiedenen Atome), wie z. B. ein sp3-hybridisiertes C-, Si-, oder N-Atom, ein sp2-hybridisiertes C-, N- oder O-Atom oder ein sp-hybridisiertes C-Atom, verbunden sein können. So sollen beispielsweise auch Systeme wie 9,9'-Diarylfluoren, Triarylamin, Diarylether, Stilben etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.

In einer weiteren Ausführungsform der Beschreibung weist das organische Molekül eine der durch die Formeln 1a oder 1b beschriebenen Strukturen auf:

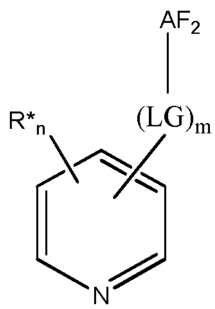

**Formel 1a**

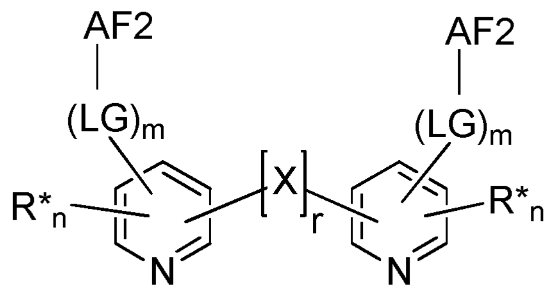

**Formel 1b**

wobei die unter Formel 1 genannten Definitionen gelten.

Der Teil des Moleküls der Formel 1, 1a oder 1b, der nicht eine AF2 darstellt wird in der vorliegenden Anmeldung auch mit AF1 bezeichnet.

In einer Ausführungsform sind die chemischen Einheiten AF2 ausgewählt aus den in Tabelle 1 aufgeführten Strukturen. Mögliche Anknüpfungspunkte einer chemischen Einheit AF2 an eine Linkergruppe LG bzw. an die Pyridineinheit sind mit Kleinbuchstaben bezeichnet.

**Tabelle 1:** Mögliche Einheiten AF2. Mögliche Anknüpfungspunkte einer chemischen Einheit AF2 an eine Linkergruppe LG bzw. an die Pyridineinheit sind mit Kleinbuchstaben bezeichnet.

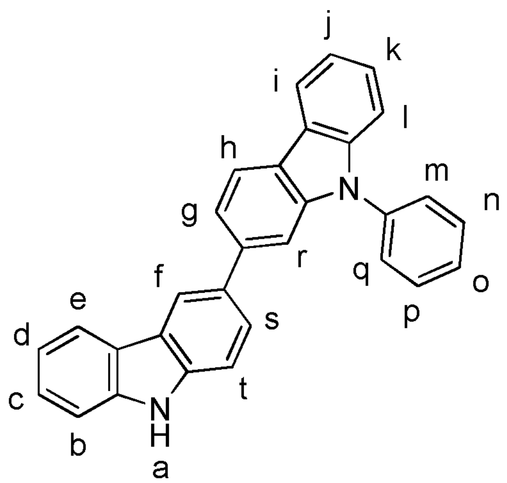

1

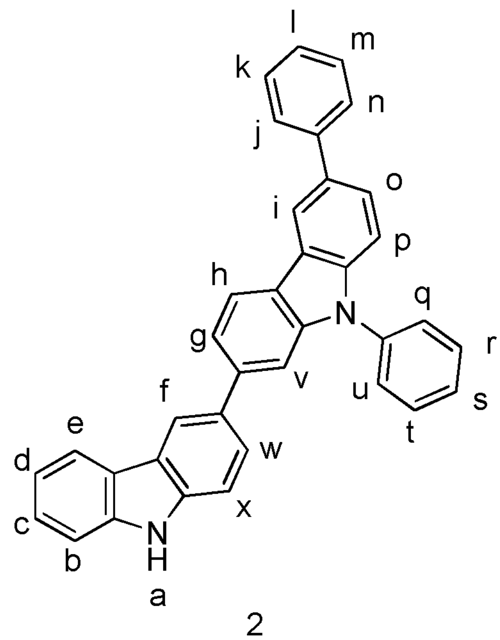

2

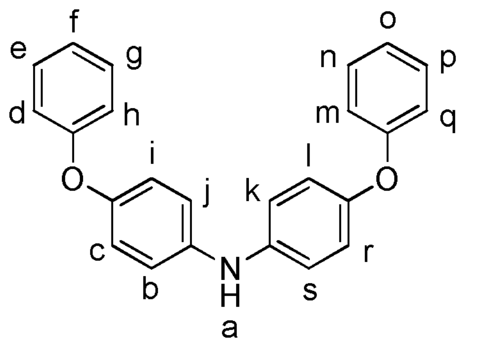

3

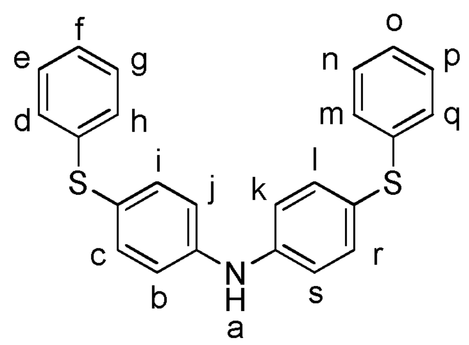

4

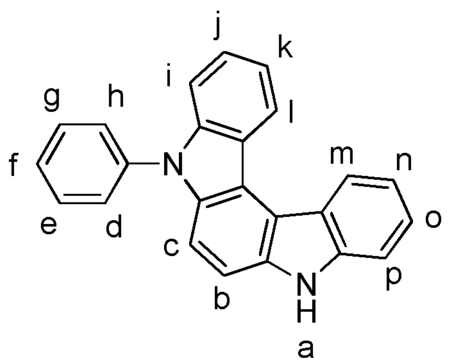

6

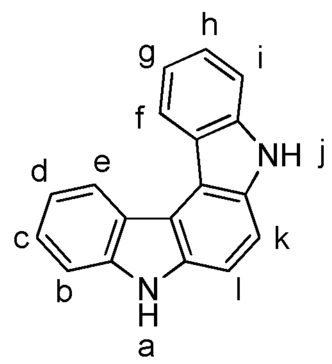

7

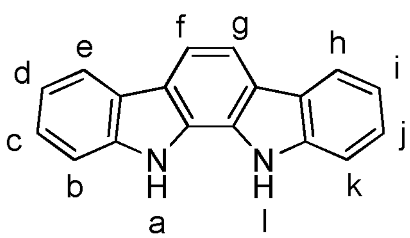

8

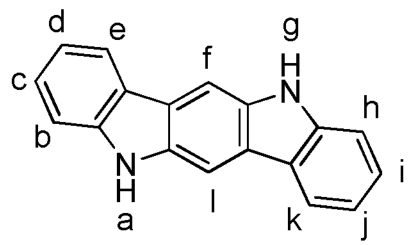

10

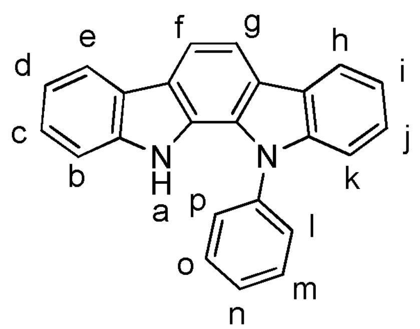

21

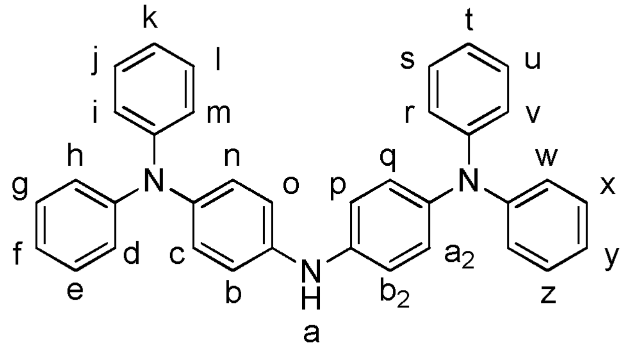

22

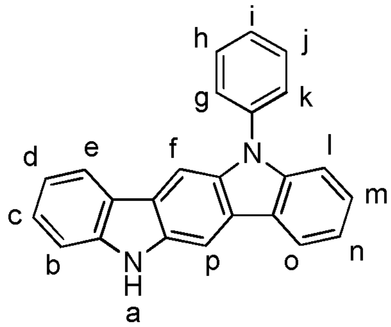
24

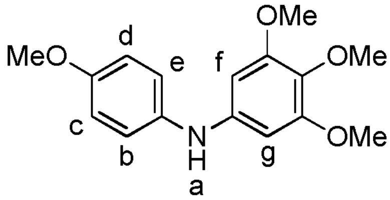
26

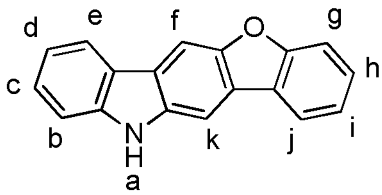
30

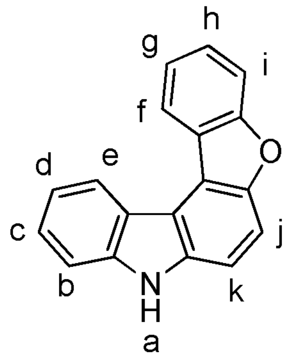
31

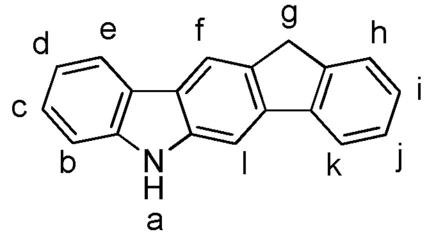
33

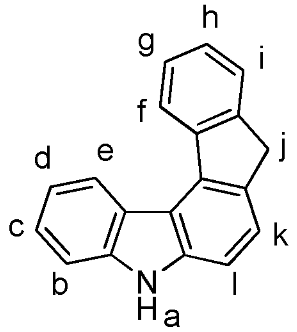
34

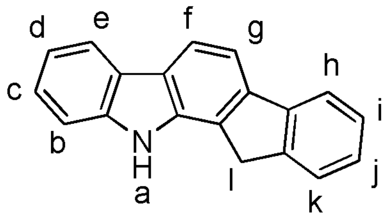
35

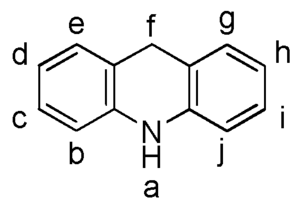
39

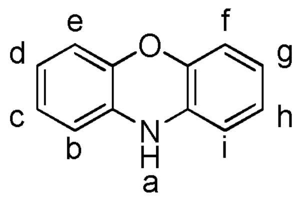
41

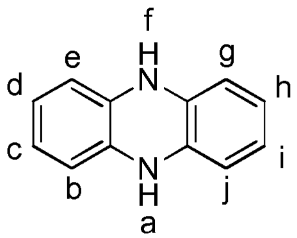
49

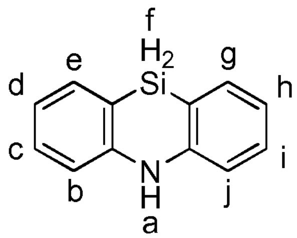
53

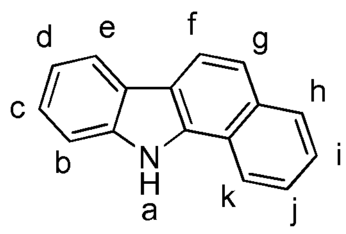
54

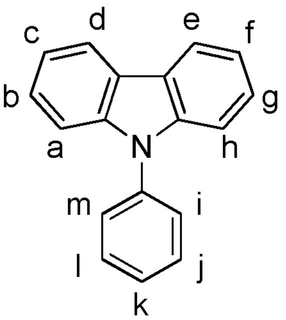

55

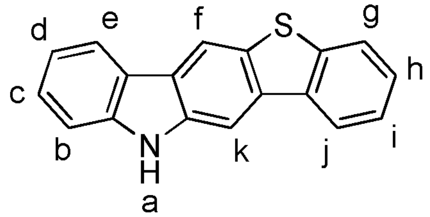

58

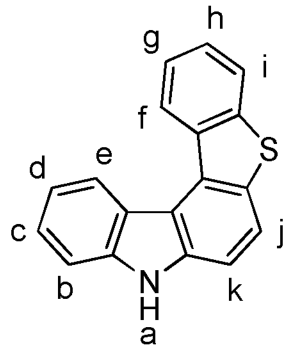

59

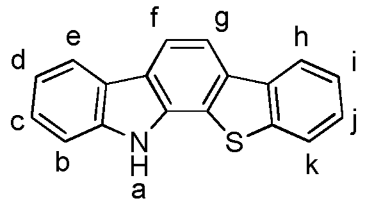

60

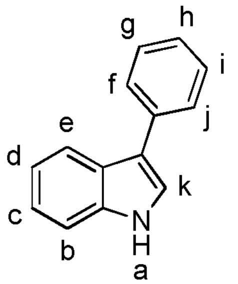

63

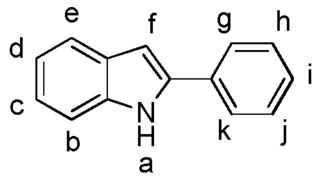

64

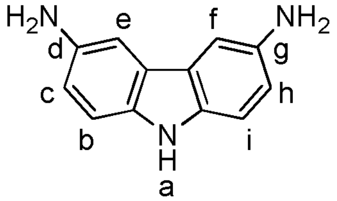

66

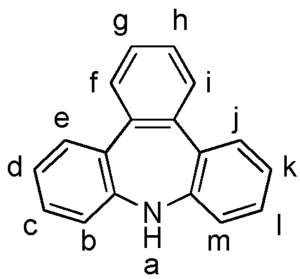

71

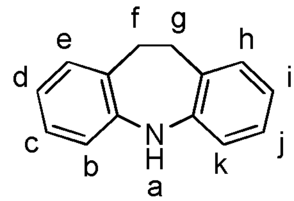

72

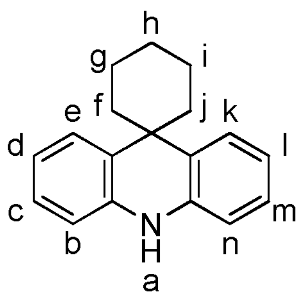

73

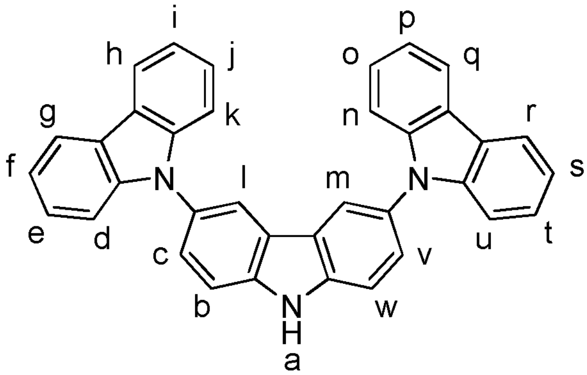

74

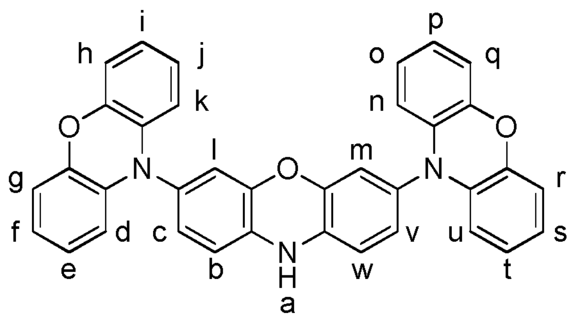
75

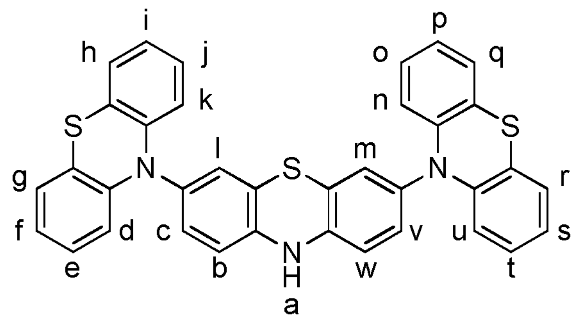
76

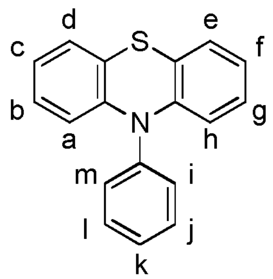
77

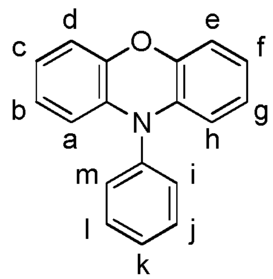
78

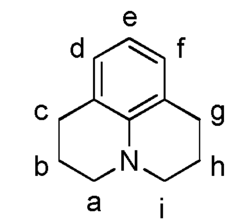
91

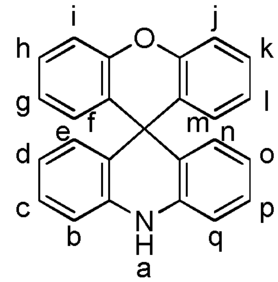
94

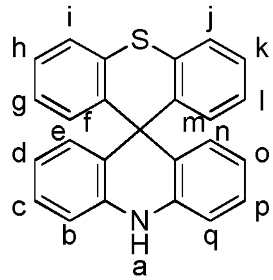
95

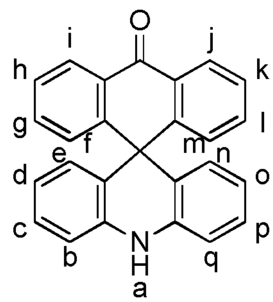
96

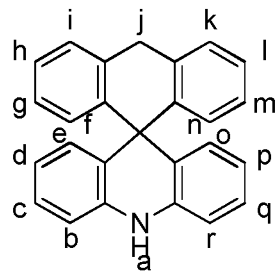
97

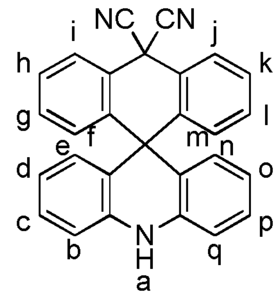
98

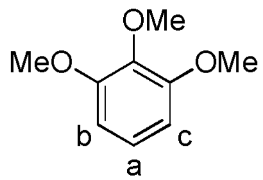
120

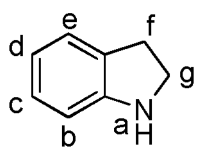
128

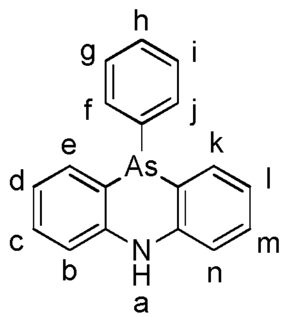
149

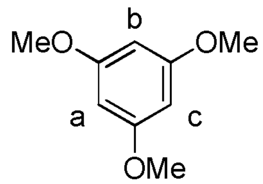
156

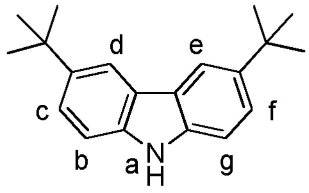

200

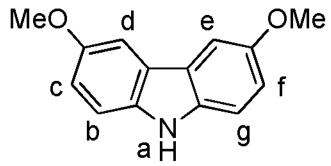

199

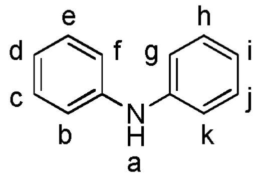

223

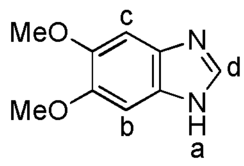

242

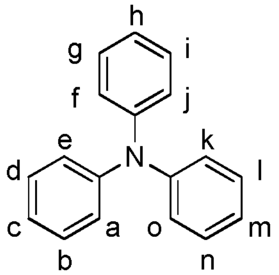

317

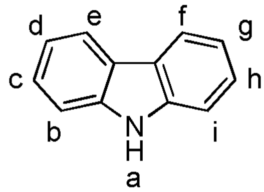

328

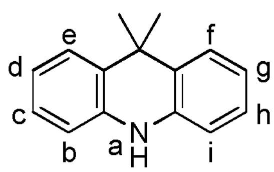

337

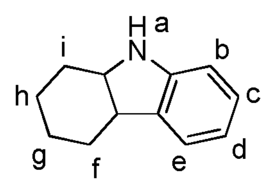

339

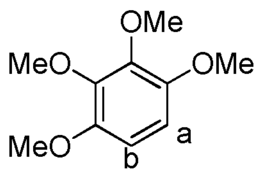

344

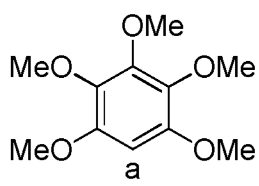

345

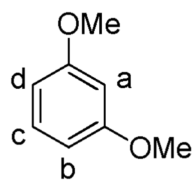

347

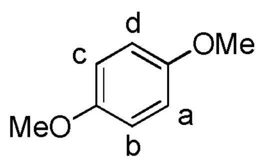

348

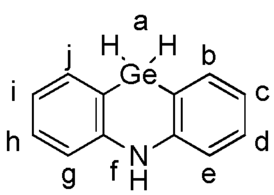

354

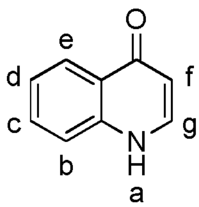

360

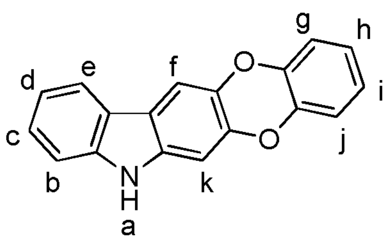

377

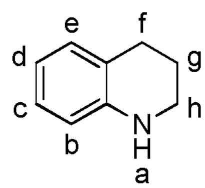

383

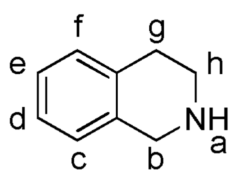

384

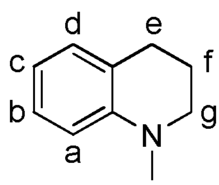

387

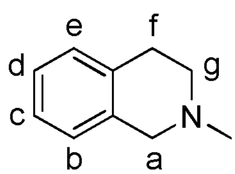

388

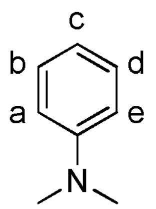

404

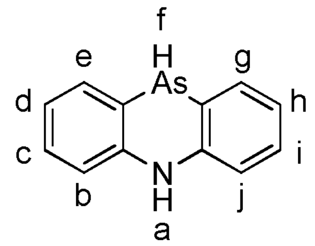

405

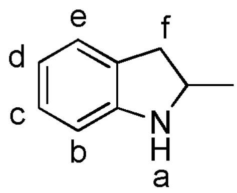

406

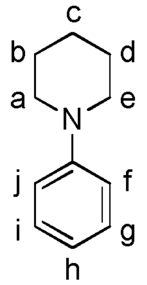

407

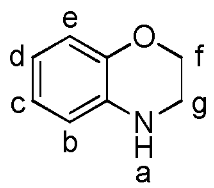

410

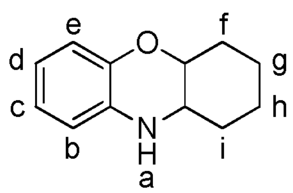

411

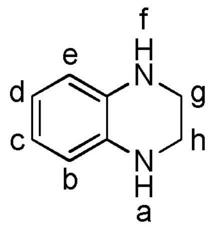

413

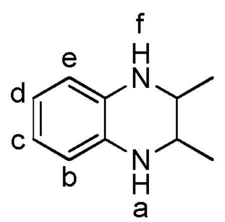

414

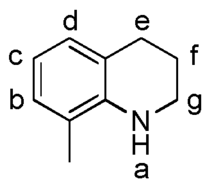

417

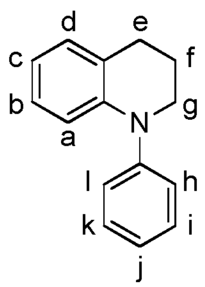

418

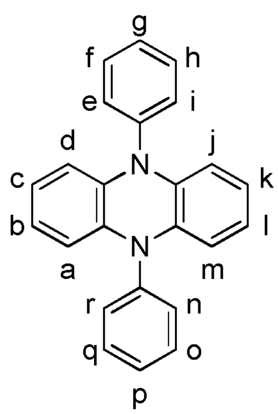

425

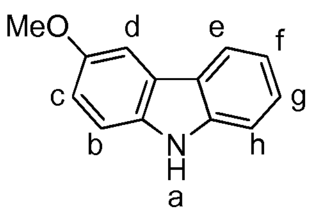

436

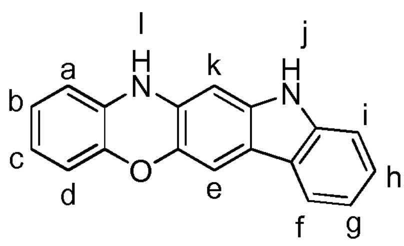

477

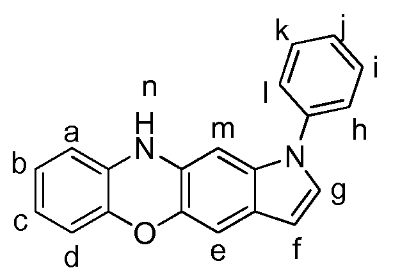

478

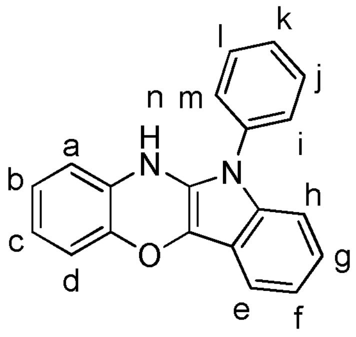

479

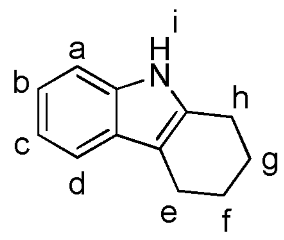

481

In einer Ausführungsform sind die mit Kleinbuchstaben bezeichneten Positionen der Tabelle 1 mit weiteren Resten R* funktionalisiert.

In einer weiteren Ausführungsform der Beschreibung weisen die Moleküle gemäß der Beschreibung eine Struktur der Formel 3a, 3c oder 3d auf oder haben eine Struktur der Formeln 3a, 3c oder 3d, die erfindungsgemäßen organischen Moleküle weisen eine Struktur der Formel 3b auf oder haben eine Struktur der Formeln 3b, wobei für n, m und AF2, LG und R* die unter Formel 1 angeführten Spezifikationen gelten.

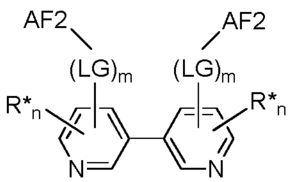

**Formel 3a**

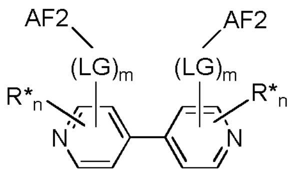

**Formel 3b**

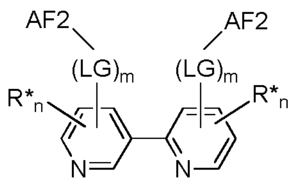

**Formel 3c**

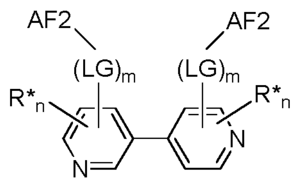

**Formel 3d**

Erfindungsgemäß gilt:

m ist 0 oder 1;
n ist 1, 2 oder 3;
LG ist eine divalente Linkergruppe, ausgewählt aus der Gruppe bestehend aus:

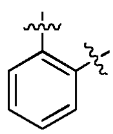
,
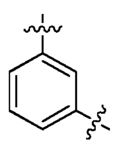
,
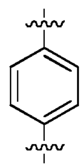
;

oder LG ist eine Element-Element-Einfachbindung;
wobei AF2 eine Struktur der Formel 2 aufweist:

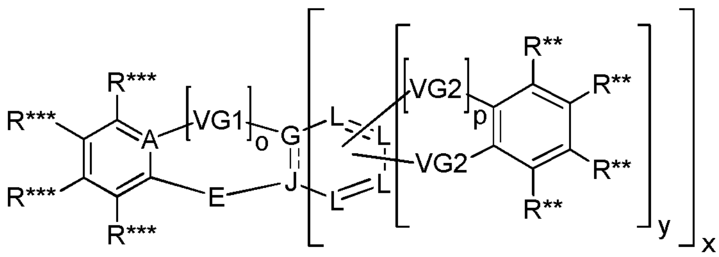

**Formel 2**

wobei gilt:

x ist 1;

y ist 0;

o ist 0 oder 1;

A ist CR*** wenn o = 0, ansonsten C;

VG1 ist eine verbrückende Gruppe und ist ausgewählt aus der Gruppe bestehend aus

- NR**, CR**$_2$, O, S, eine C-C-Einfachbindung, BR**, AsR**, SiR**$_2$, GeR**$_2$,

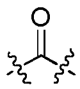, 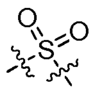, 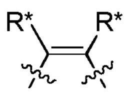, 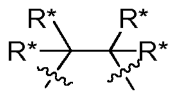, 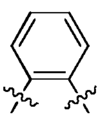, 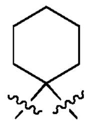, 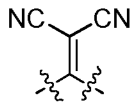, 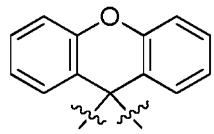,

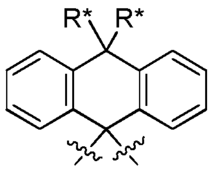, 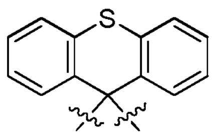 und 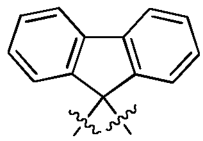;

E ist NR**,

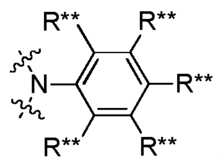,

O oder S;

G ist C wenn o = 1; G ist CR** wenn o = 0;

J ist C;

L ist CR***;

R*** ist R** oder ist ausgewählt aus den folgenden Einheiten, wobei maximal zwei der Reste R*** gleichzeitig gleich einer der folgenden Einheiten sind:

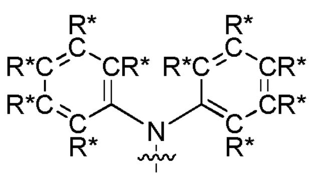, 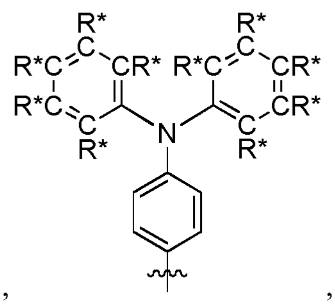, 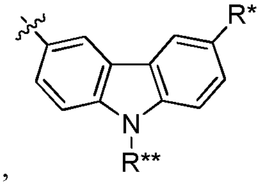, 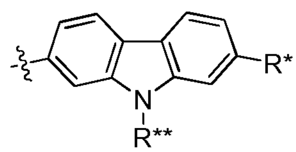,

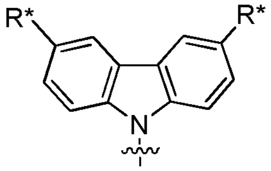, 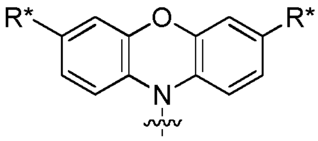, 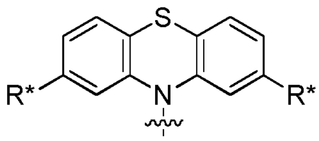,

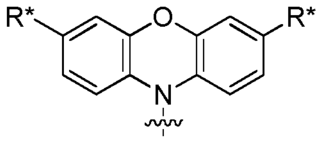, 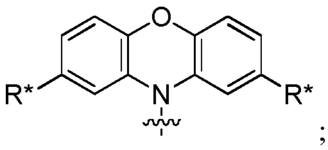;

R** ist bei jedem Auftreten unabhängig voneinander ein Rest R* und/oder markiert die Anknüpfungsstelle an die Linkergruppe LG oder bei m = 0 an die Pyridineinheit der Formel 3b;

R* ist bei jedem Auftreten unabhängig voneinander ausgewählt aus der Gruppe bestehend aus H, Deuterium, Phenyl, Naphthyl, $N(R^2)_2$, -SCN, $-CF_3$, $-NO_2$, $Si(R^4)_3$, eine lineare Alkyl-, Alkoxy- oder Thioalkoxygruppe mit 1 bis 40 C-Atomen, die jeweils mit einem oder mehreren Resten $R^9$ substituiert sein kann, wobei eine benachbarte $CH_2$-Gruppe durch $-Si(R^4)_2-$, - $Ge(R^4)_2-$, $-Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme;

$R^2$ ist bei jedem Auftreten unabhängig voneinander ausgewählt aus der Gruppe bestehend aus H, Deuterium, Phenyl, Naphthyl, $CF_3$, $Si(R^4)_3$, eine lineare Alkyl-, Alkoxy- oder Thioalkoxygruppe mit 1 bis 40 C-Atomen die jeweils mit einem oder mehreren Resten $R^9$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme;

$R^4$ ist bei jedem Auftreten unabhängig voneinander ausgewählt aus der Gruppe bestehend aus H, Deuterium, Phenyl, Naphthyl, $N(R^2)_2$, $CF_3$, OH, eine lineare Alkyl-, Alkoxy- oder Thioalkoxygruppe mit 1 bis 40 C-Atomen, die jeweils mit einem oder mehreren Resten $R^9$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können;

$R^9$ ist bei jedem Auftreten unabhängig voneinander ausgewählt aus der Gruppe bestehend aus H, Deuterium, Phenyl, Naphthyl, $N(R^2)_2$, $CF_3$, $NO_2$, OH, $Si(R^4)_3$, eine lineare Alkyl-, Alkoxy- oder Thioalkoxygruppe mit 1 bis 40 C-Atomen, die jeweils mit einem oder mehreren Resten $R^8$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme.

In einer weiteren Ausführungsform weisen auf oder haben erfindungsgemäße Moleküle insbesondere eine Struktur der Formeln 3.1, 3.2, 3.5 und 3.6. Dabei können optional sämtliche $C_{sp2}$-H-Gruppen auch $C_{sp2}$-R* -Gruppen sein.

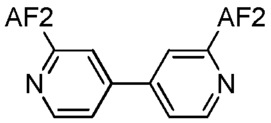

**3.1**

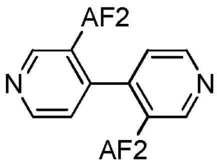

**3.2**

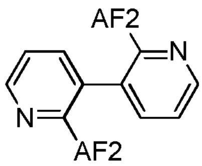

**3.3**

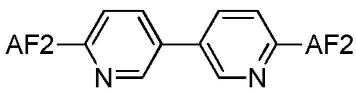

**3.4**

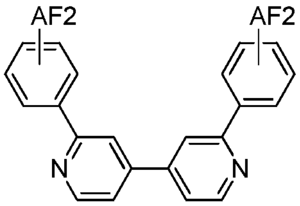

**3.5**

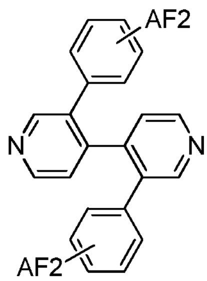

**3.6**

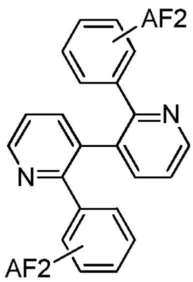

**3.7**

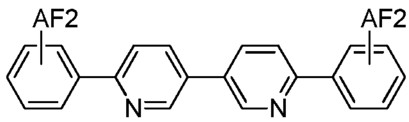

**3.8**

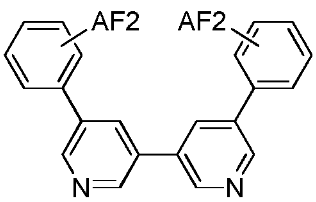

**3.9**

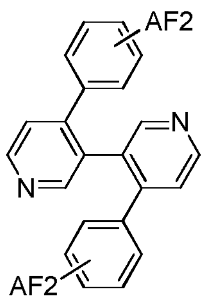

**3.10**

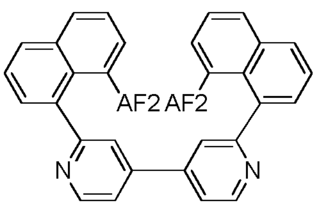

**3.11**

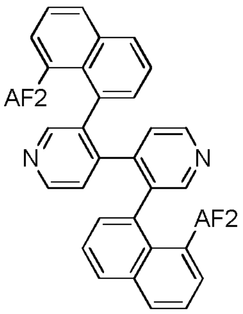

**3.12**

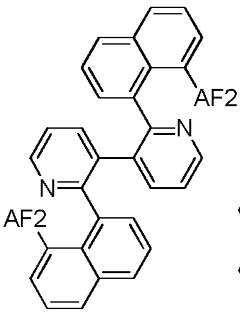

**3.13**

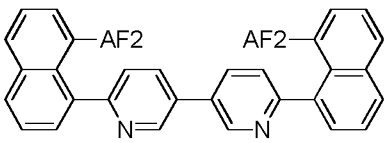

**3.13**

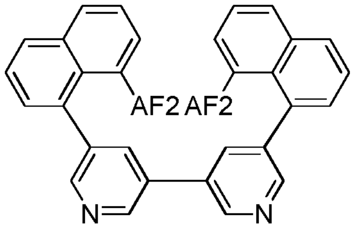

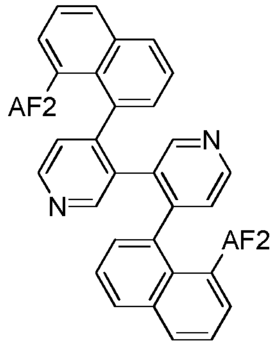

**3.14** **3.15**

In einer weiteren Ausführungsform werden die in erfindungsgemäßen Molekülen enthaltenen chemischen Einheiten AF2 durch die Formel 4 beschrieben;

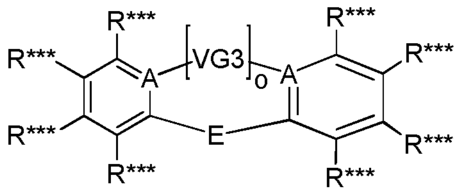

**Formel 4**

wobei gilt:

o ist 0, 1;

A ist CR*** wenn o = 0, ansonsten C;

VG3 = verbrückende Gruppe ist NR**, $CR^{**}_2$, O, S oder eine C-C-Einfachbindung,

E ist NR** oder

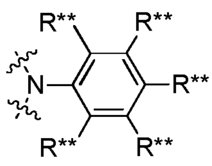

;

R*** ist R** oder ist ausgewählt aus den folgenden Einheiten, wobei maximal zwei der Reste R*** gleichzeitig gleich einer der folgenden Einheiten sind:

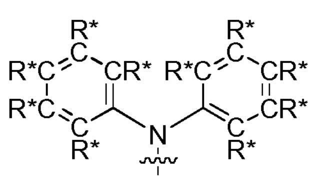

,

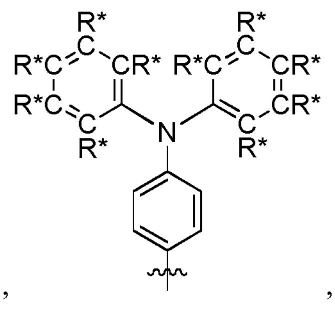

,

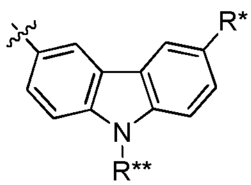

,

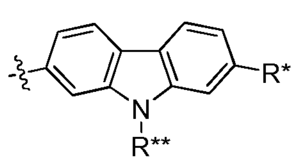

,

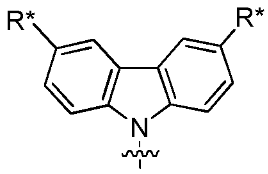 , 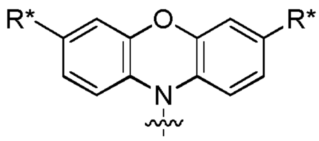 , 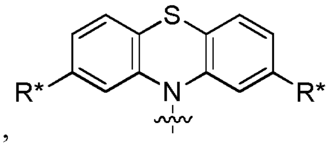 ,

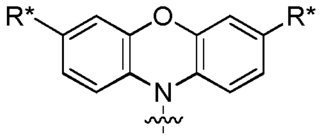 , 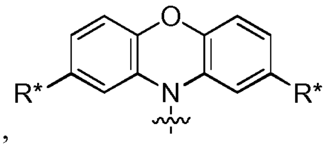 ;

und wobei für R** und R* die unter Formel 1 genannten Definitionen gelten.

Beispiele für nicht-erfindungsgemäße organische Moleküle sind in Tabelle 2 dargestellt. Beispiele für erfindungsgemäße organische Moleküle sind in Tabelle 2a dargestellt. Berechnete Werte für den Singulett-Triplett-Abstand in der Geometrie des SO-Grundzustands sind in Klammern unter der entsprechenden Molekülstruktur vermerkt.

**Tabelle 2:** Beispiele für nicht-erfindungsgemäße organische Moleküle.

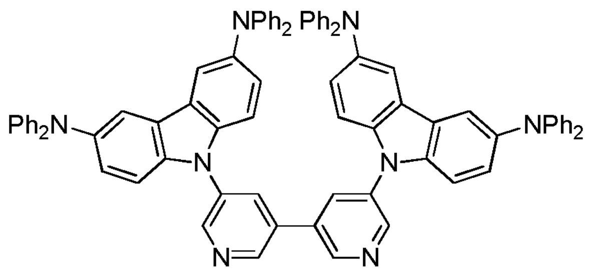 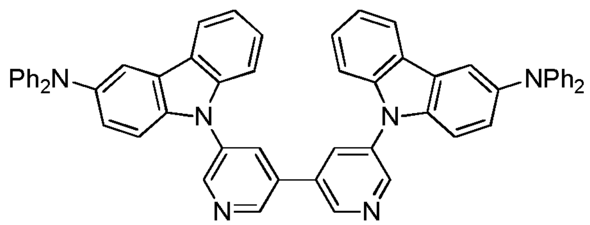

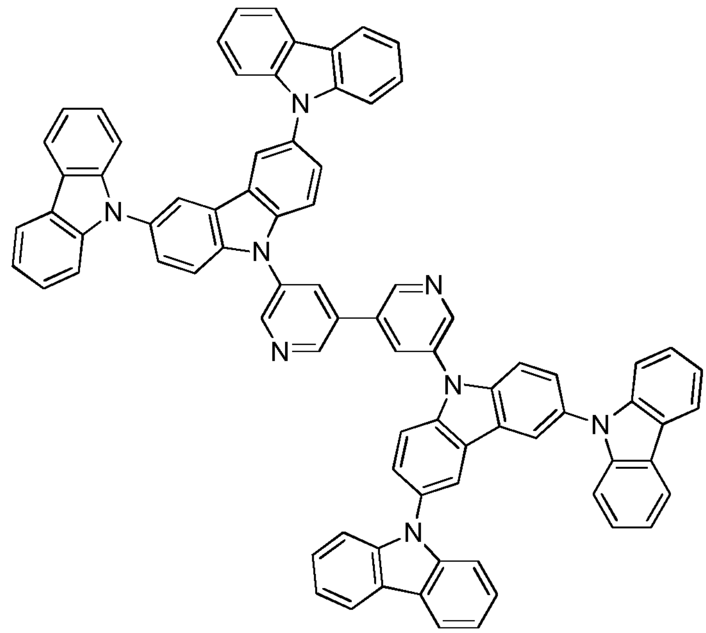 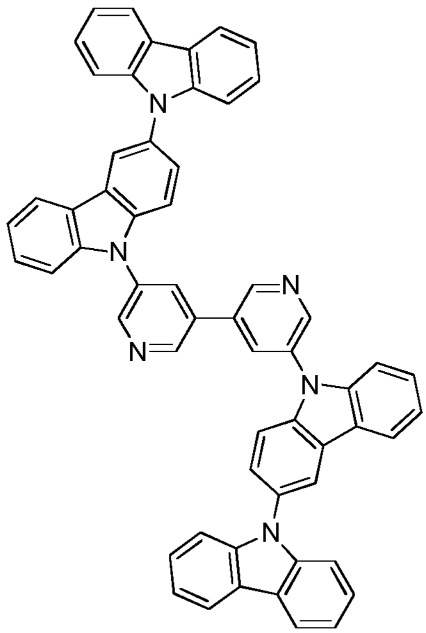

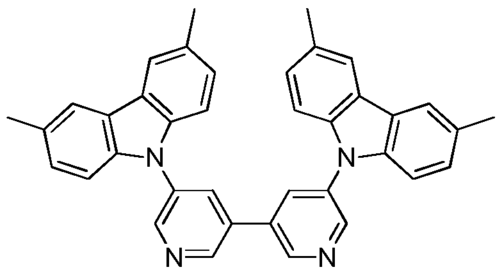

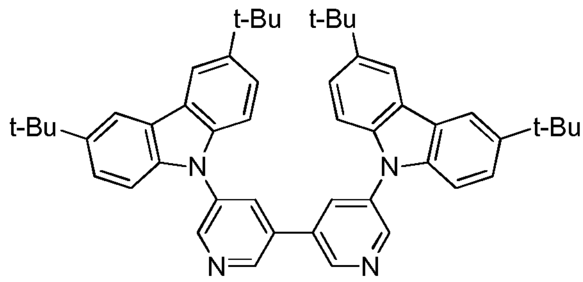

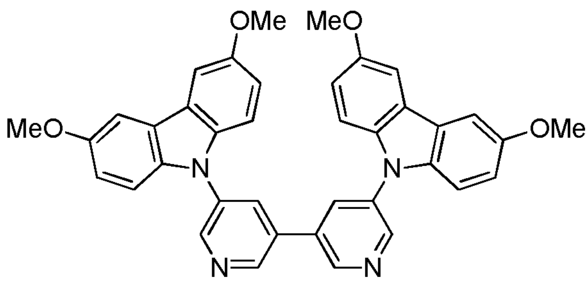

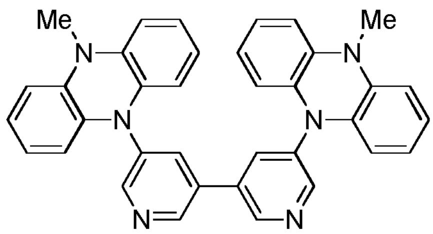

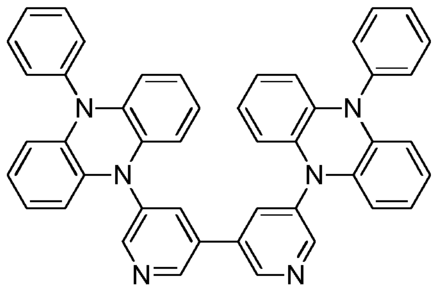

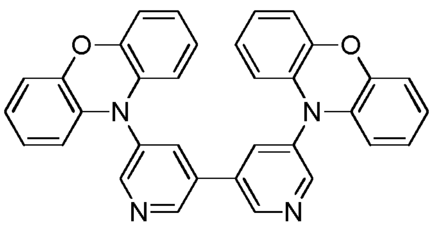

(0.052 eV)

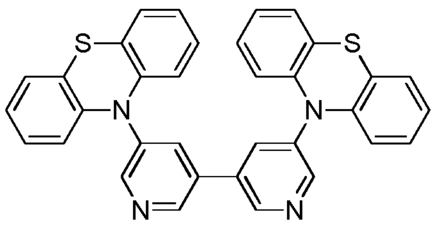

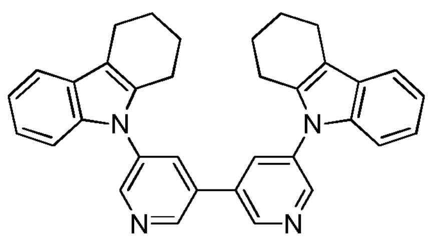

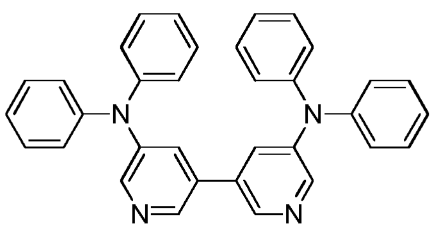

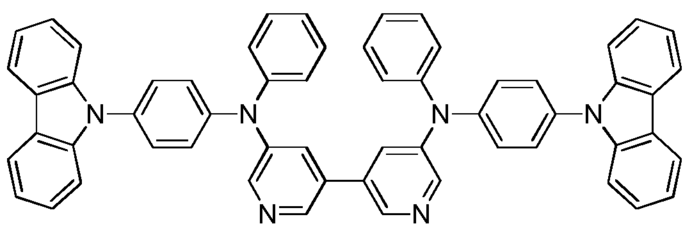

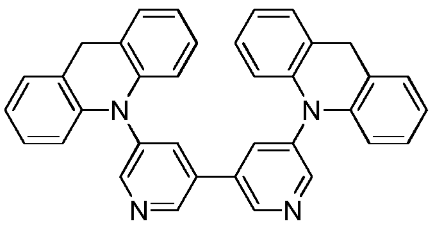

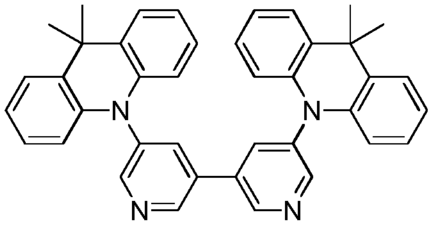

(0.046 eV)

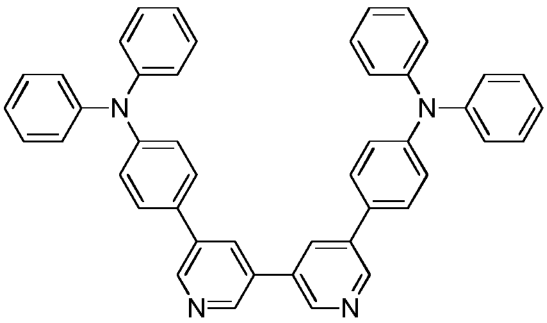

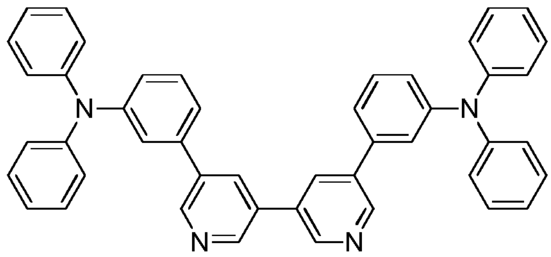

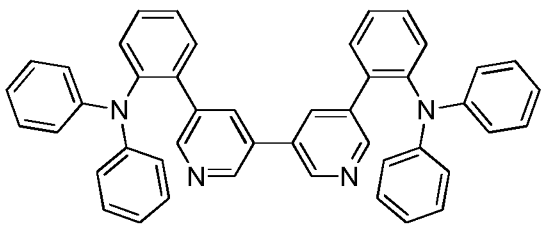

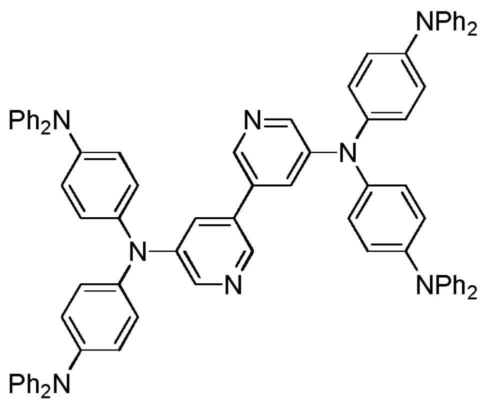

(0.056 eV)

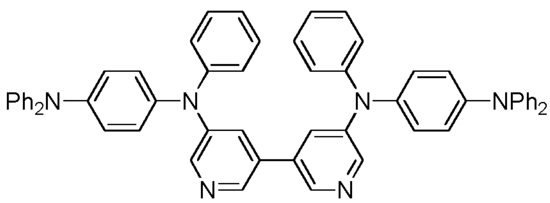

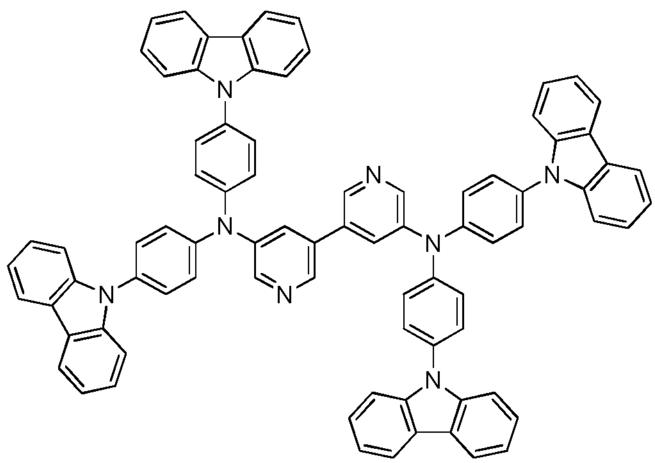

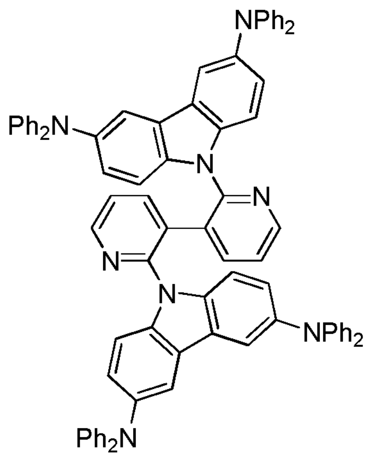

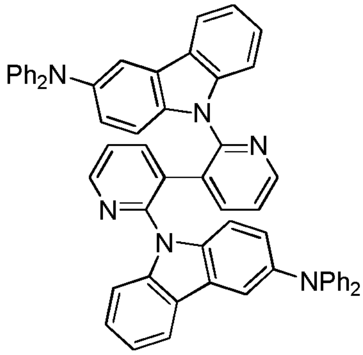

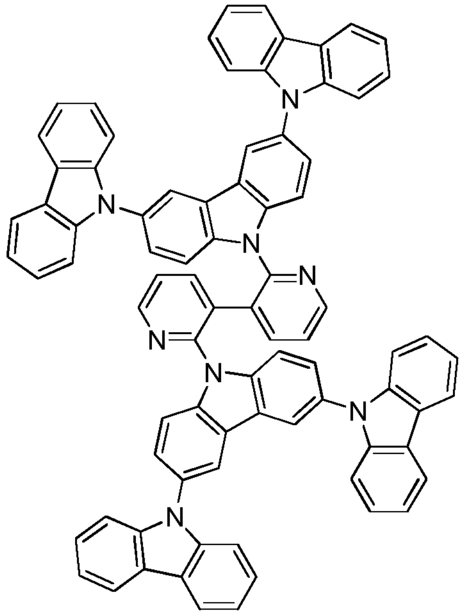

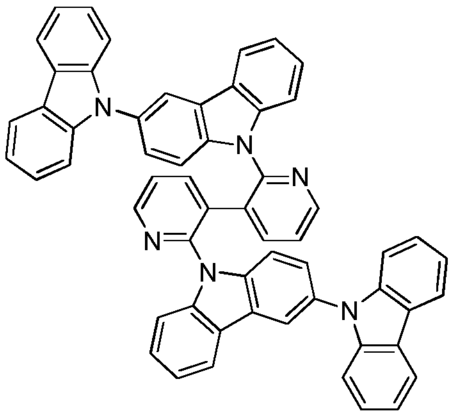

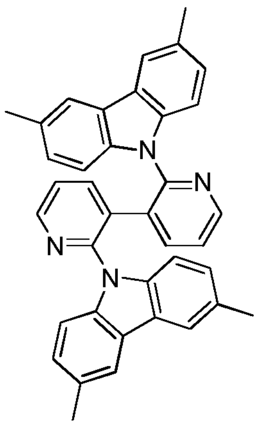

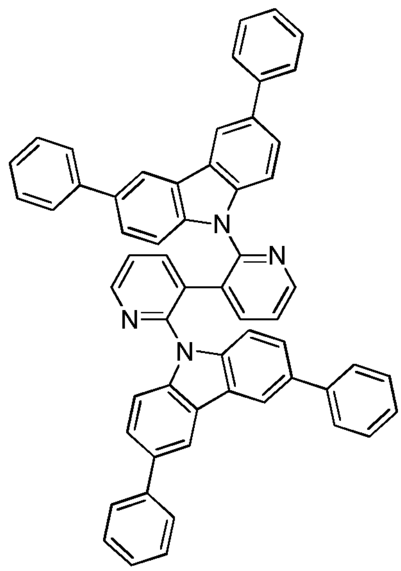

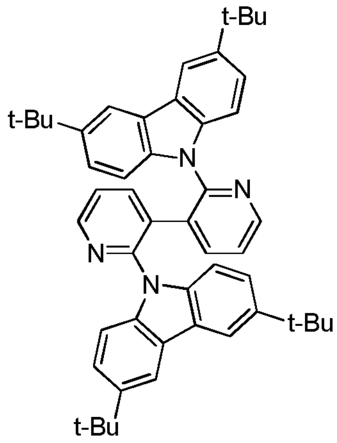

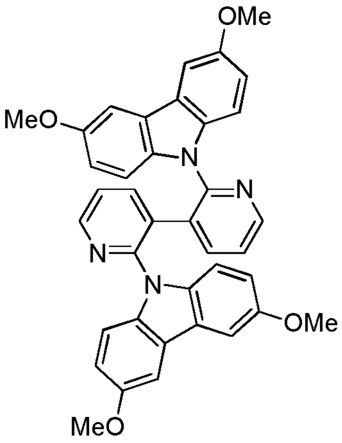

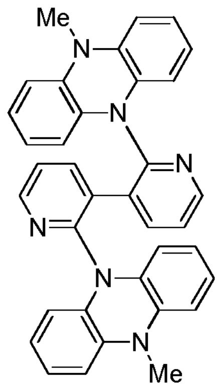

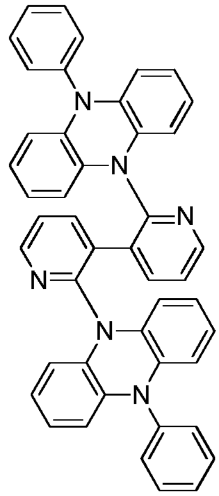

(0.027 eV)

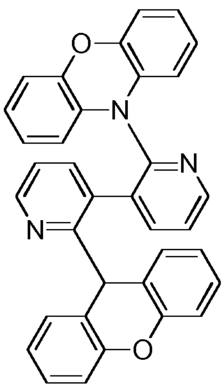

(0.062 eV)

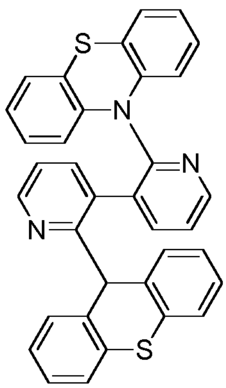

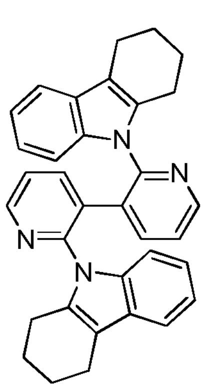

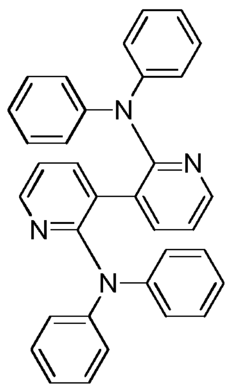

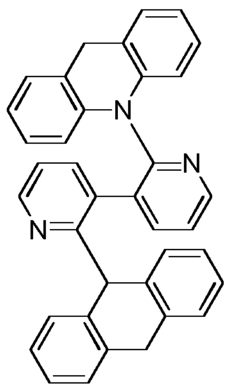

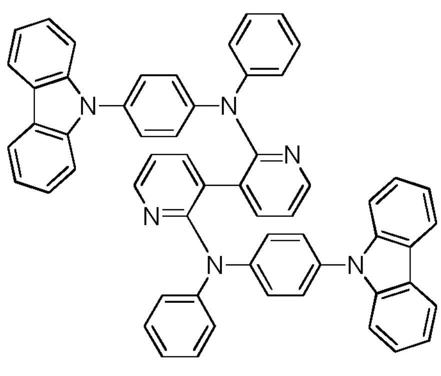

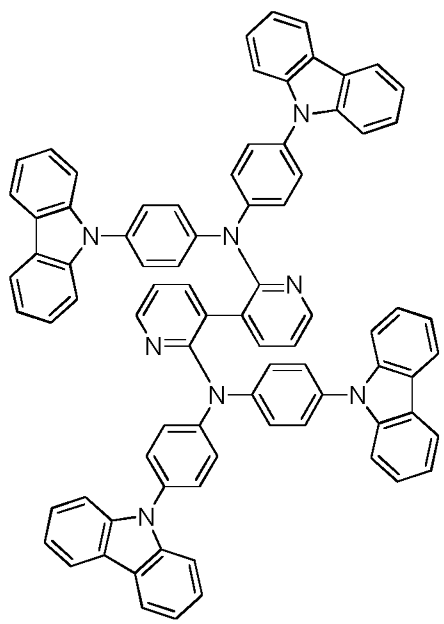

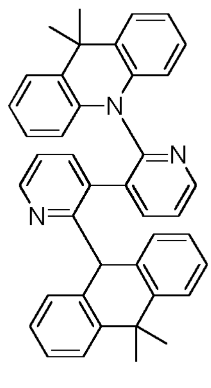

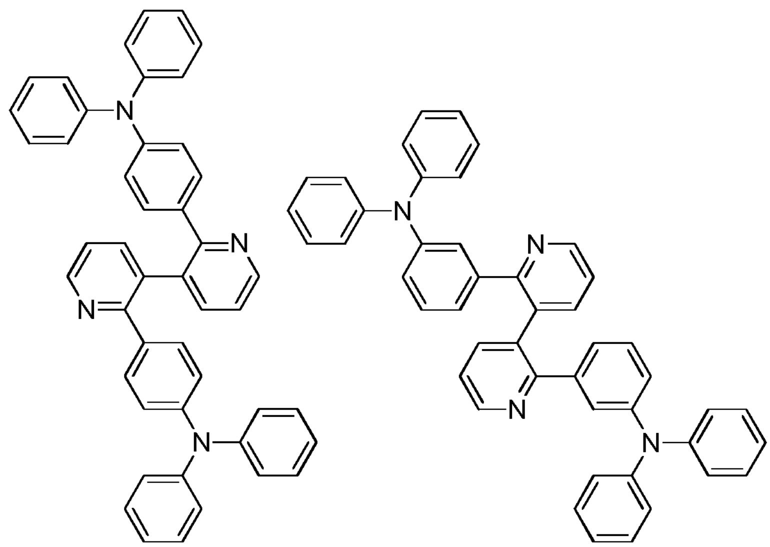

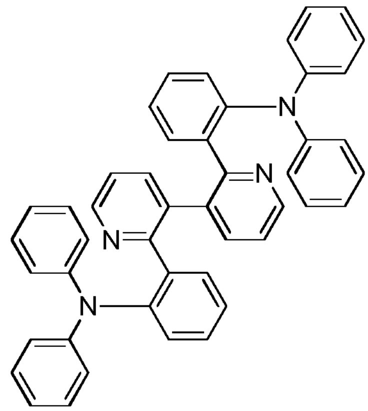

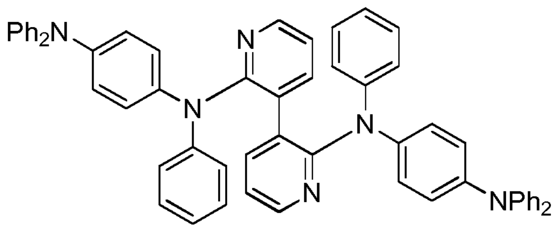

(0.285 eV)

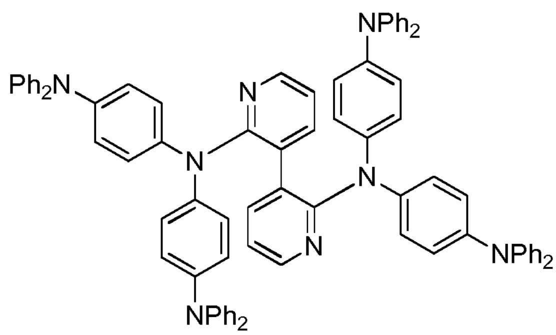

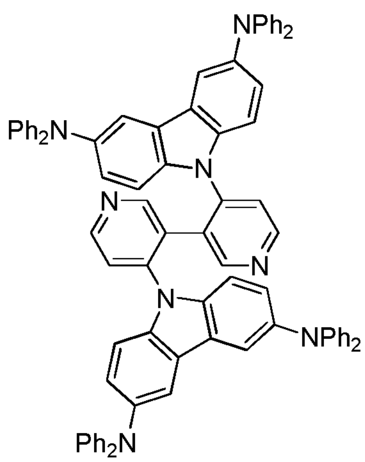

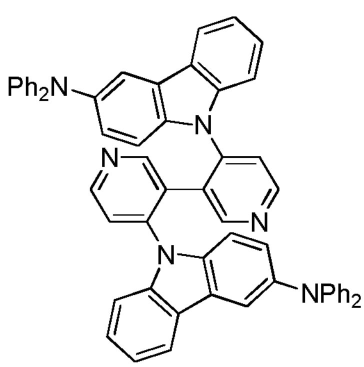

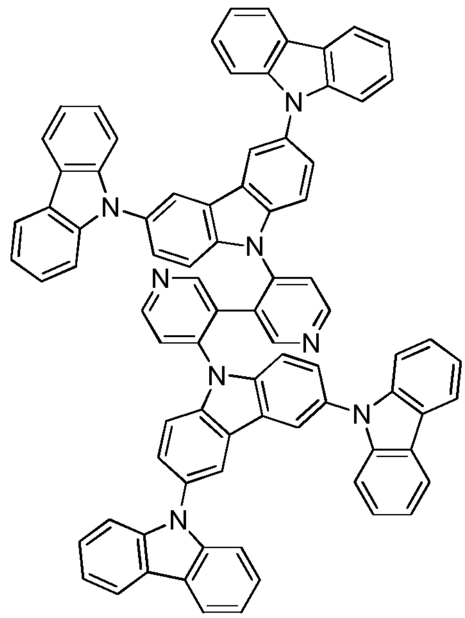

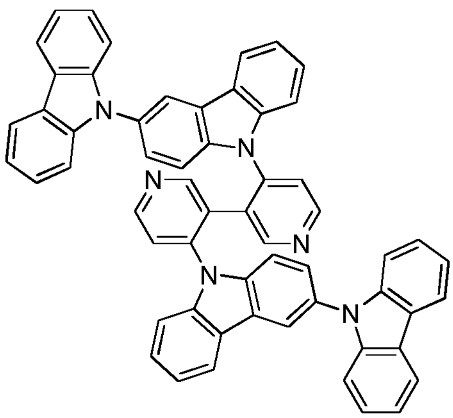
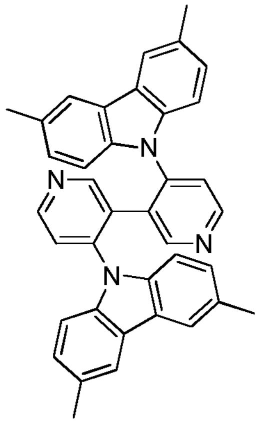
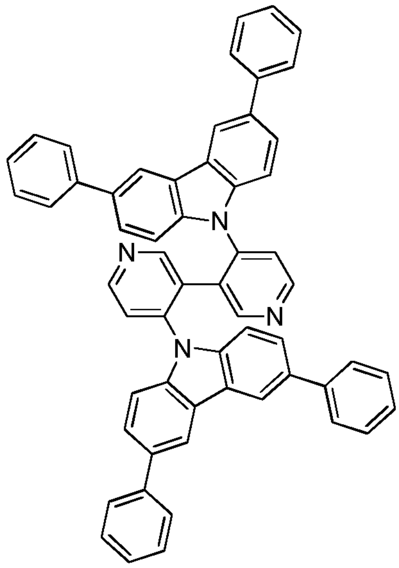

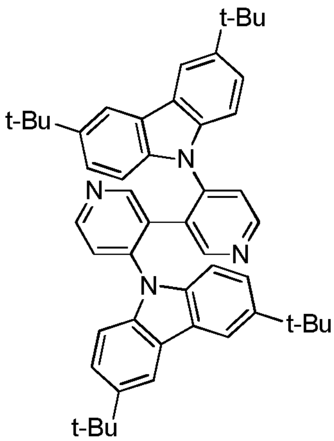
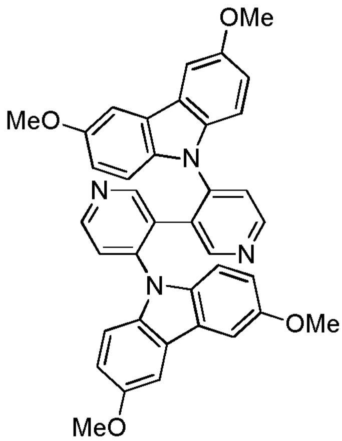
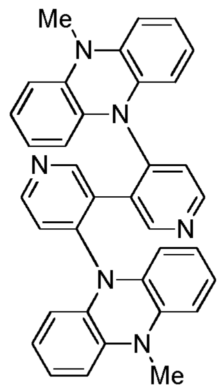
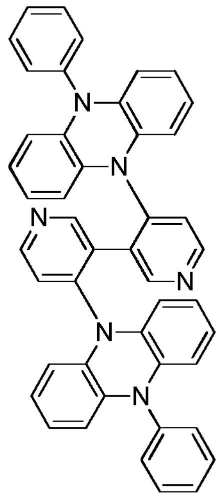

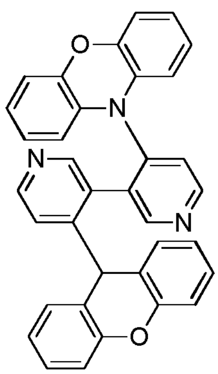
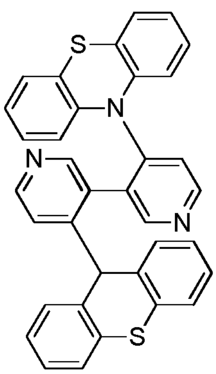
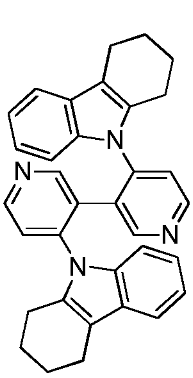
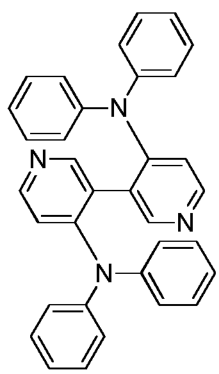
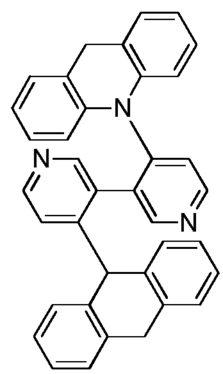

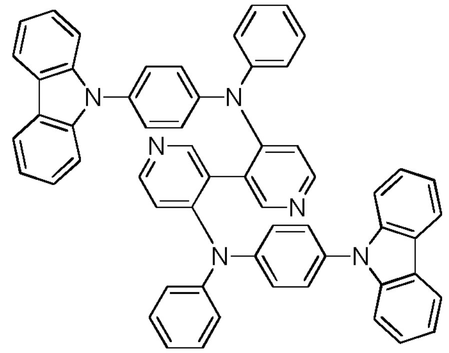

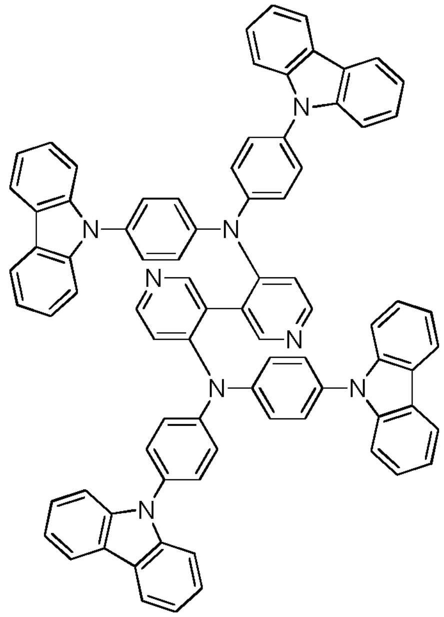

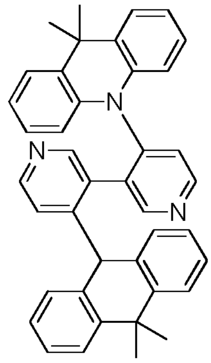

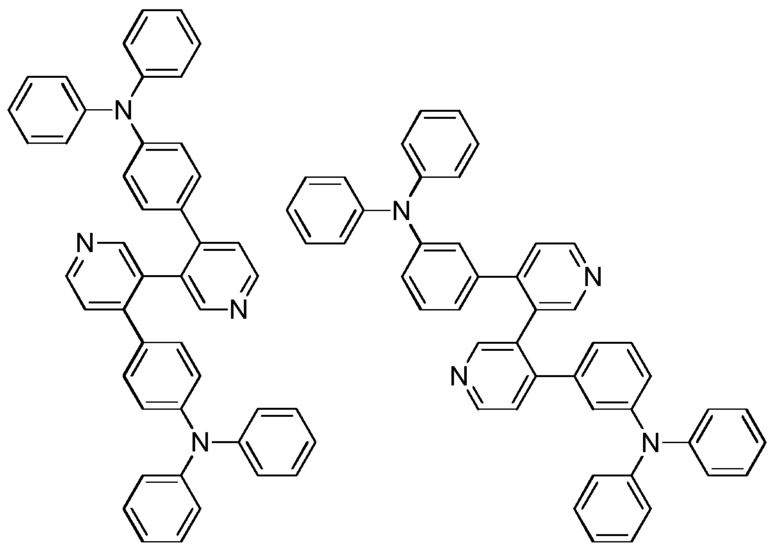

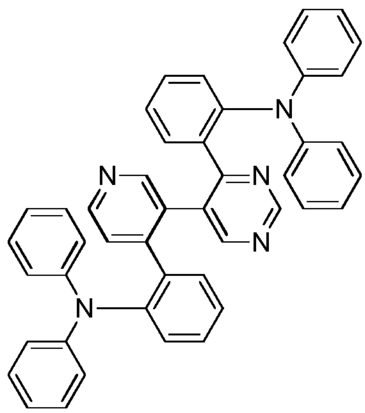

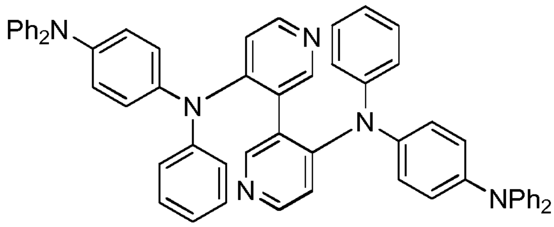

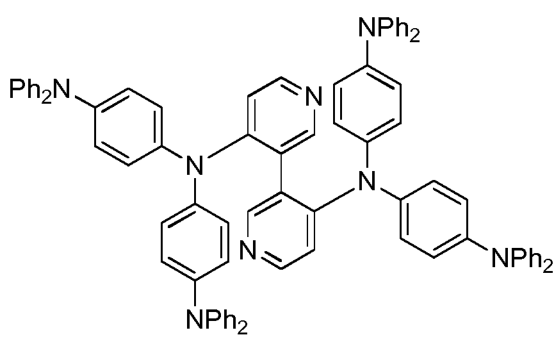

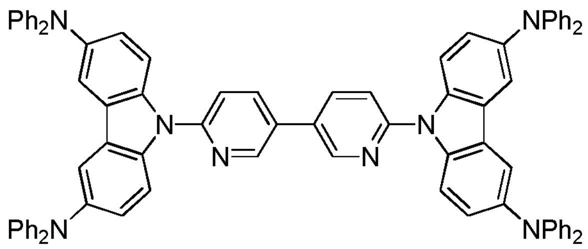

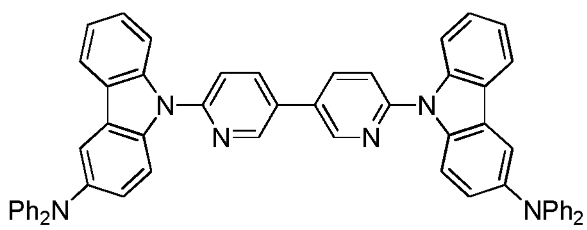

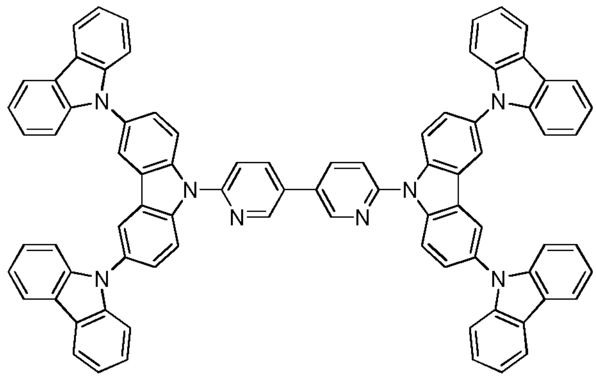

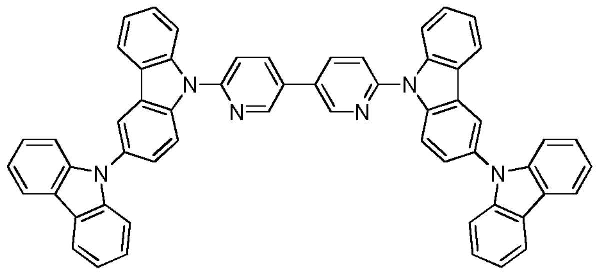

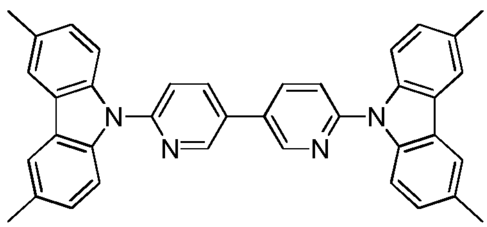

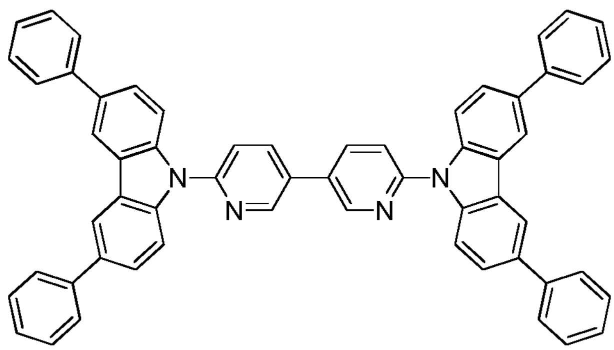

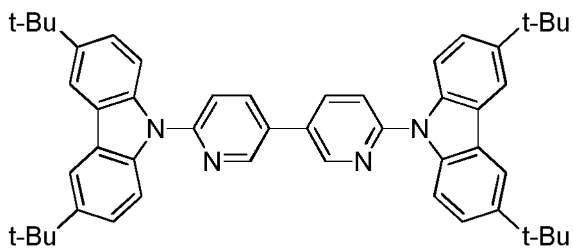

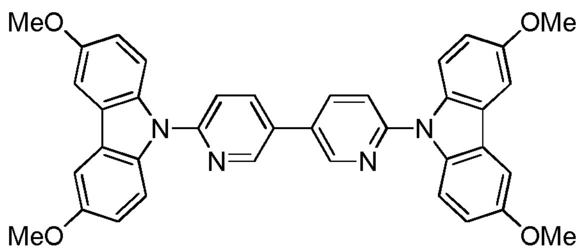

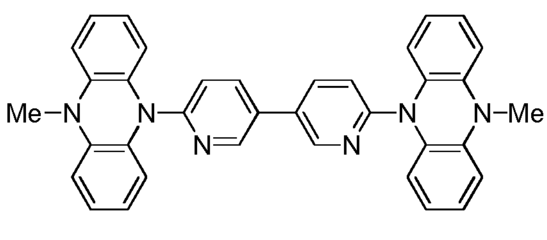

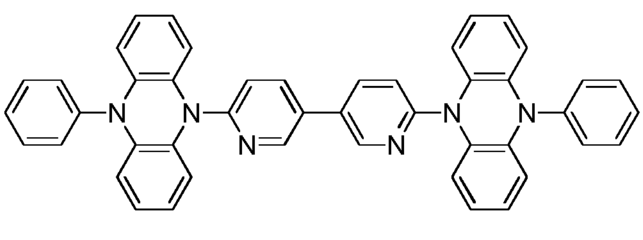

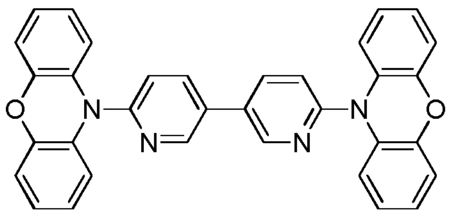

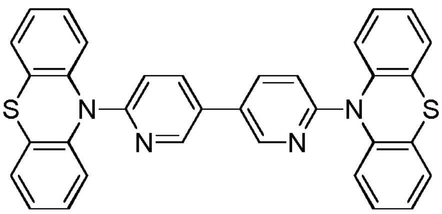

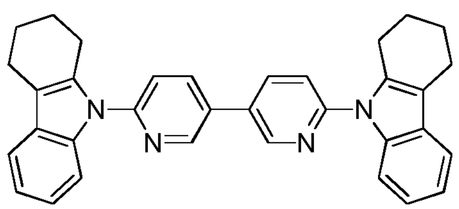

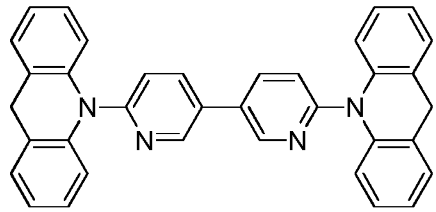

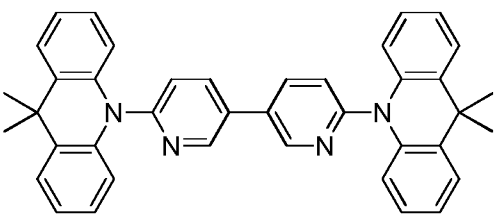

(0.029 eV)

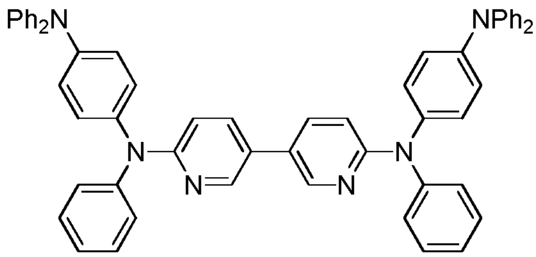

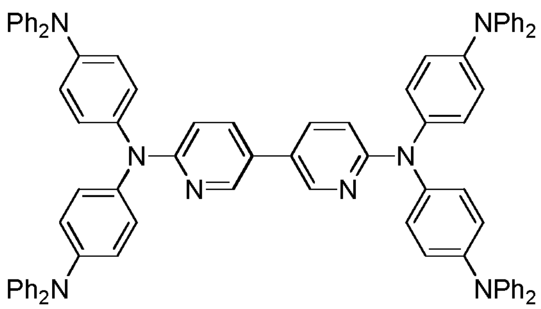

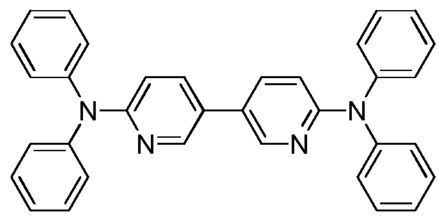

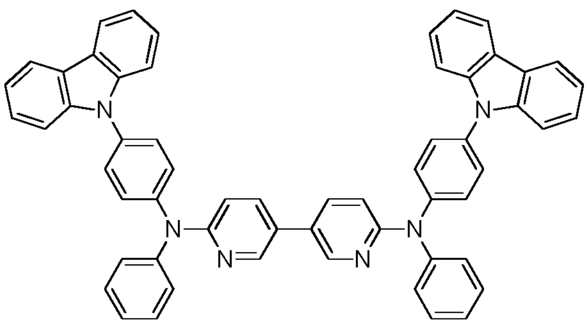

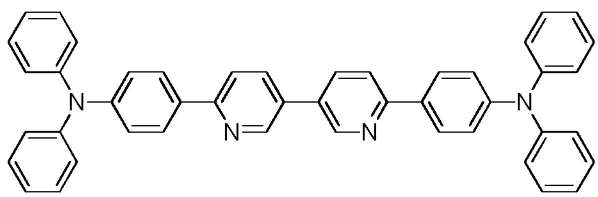

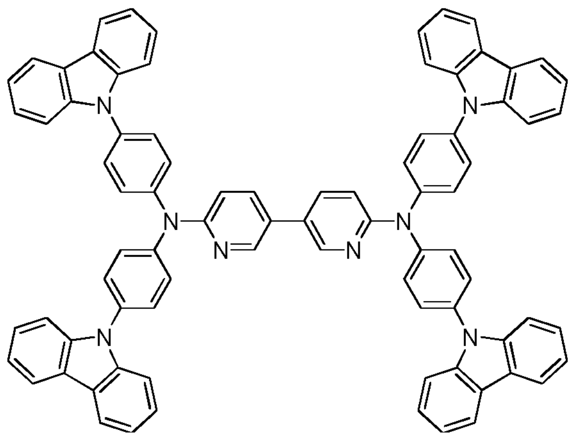

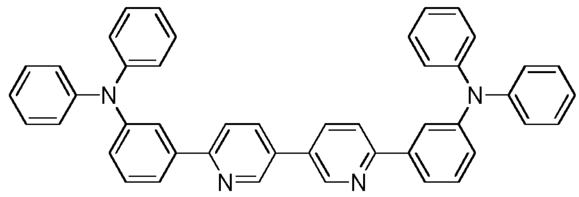

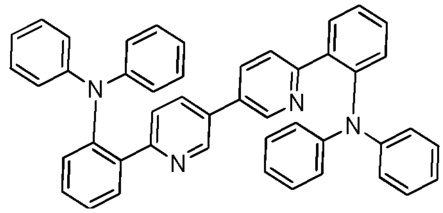

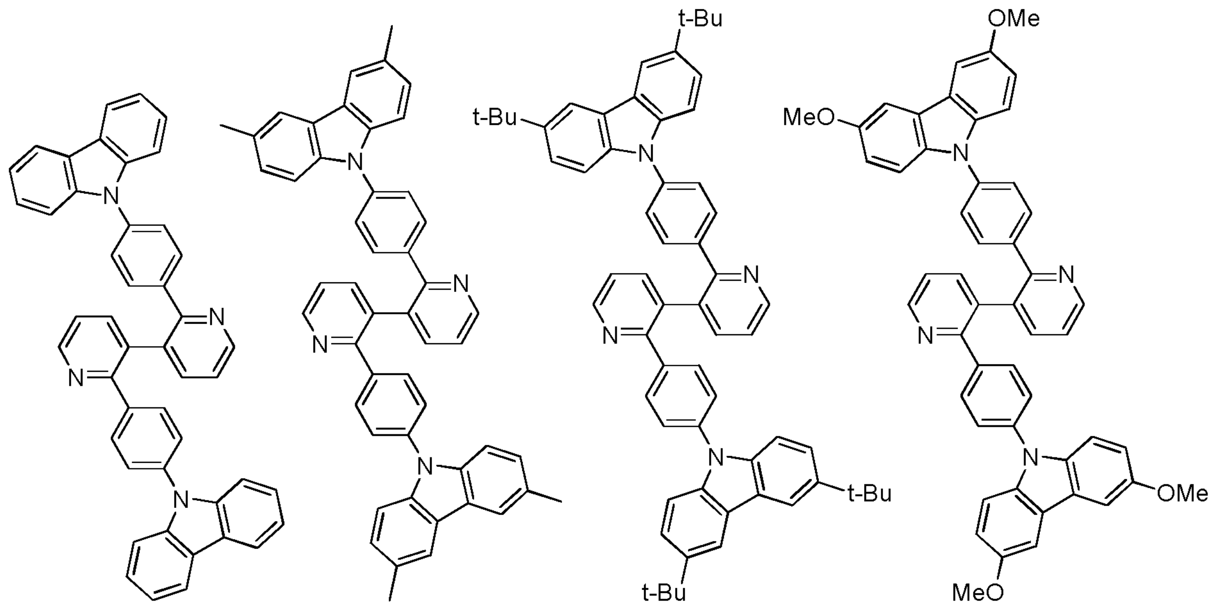

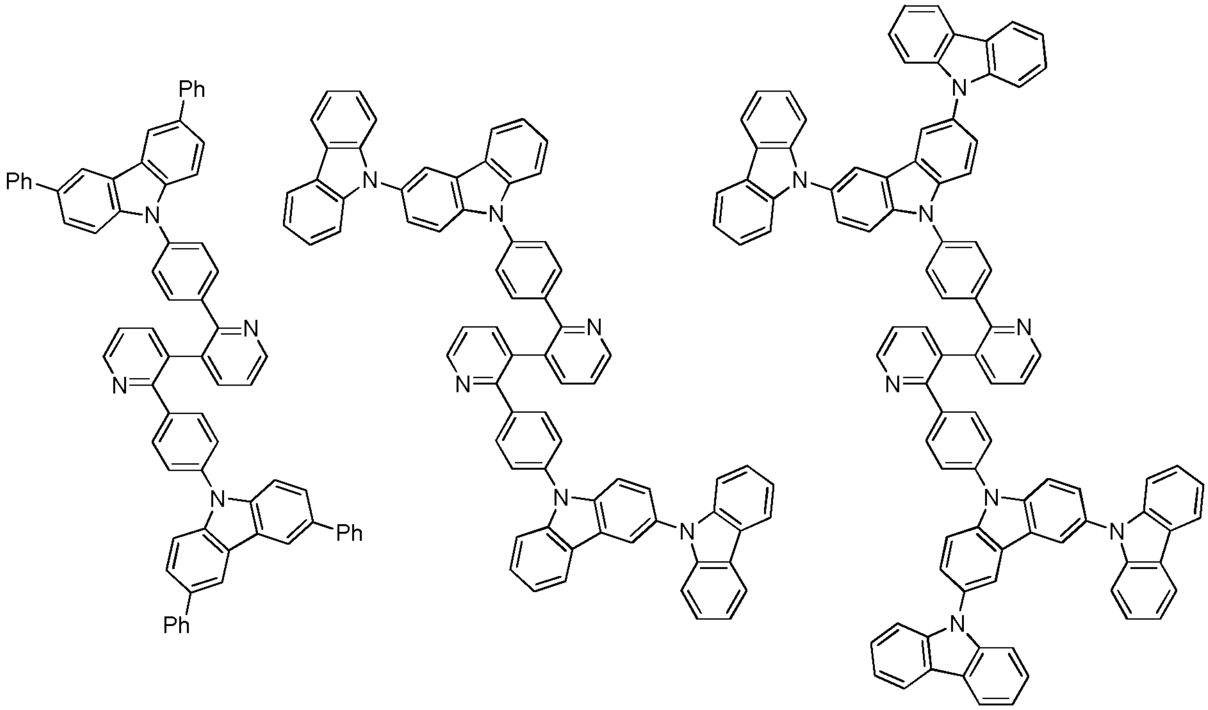

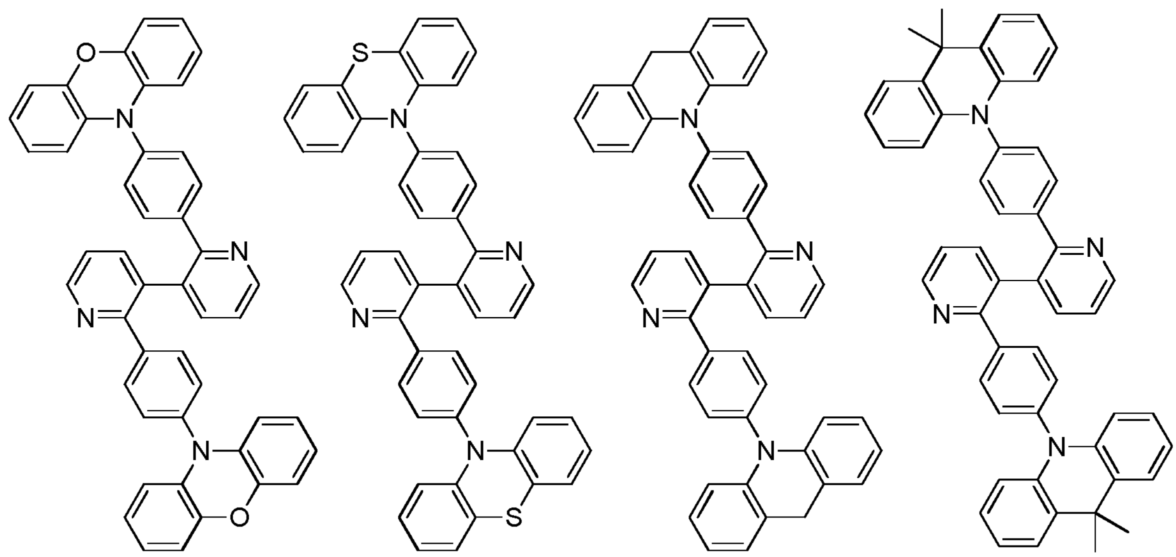

(0.067 eV) (0.014 eV)

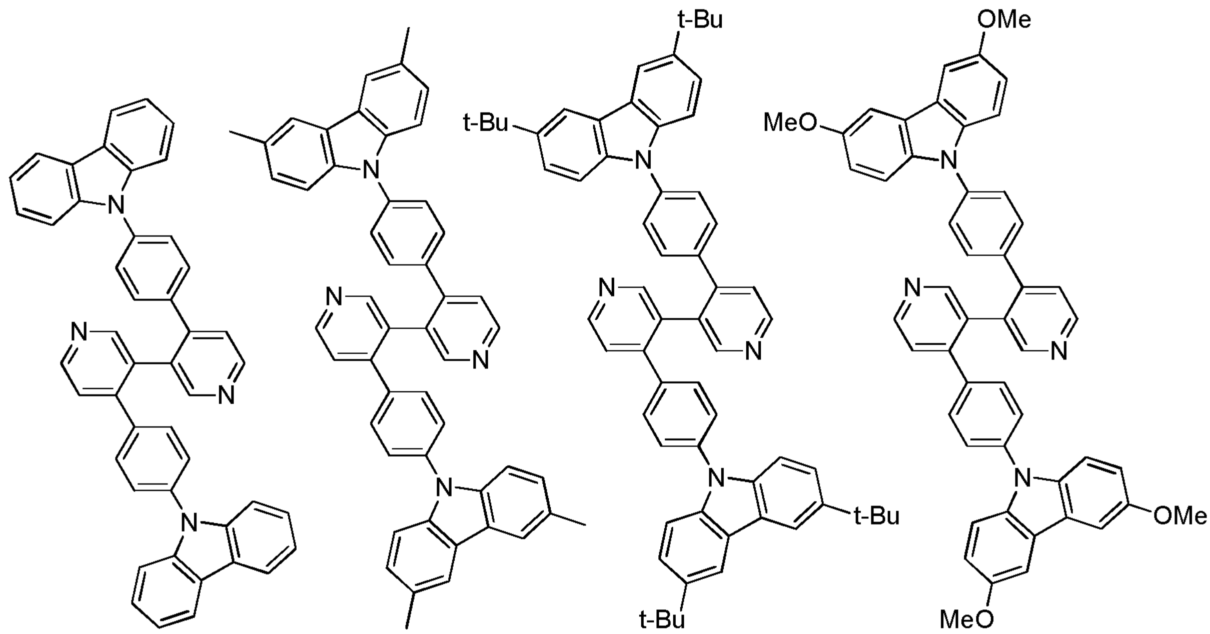

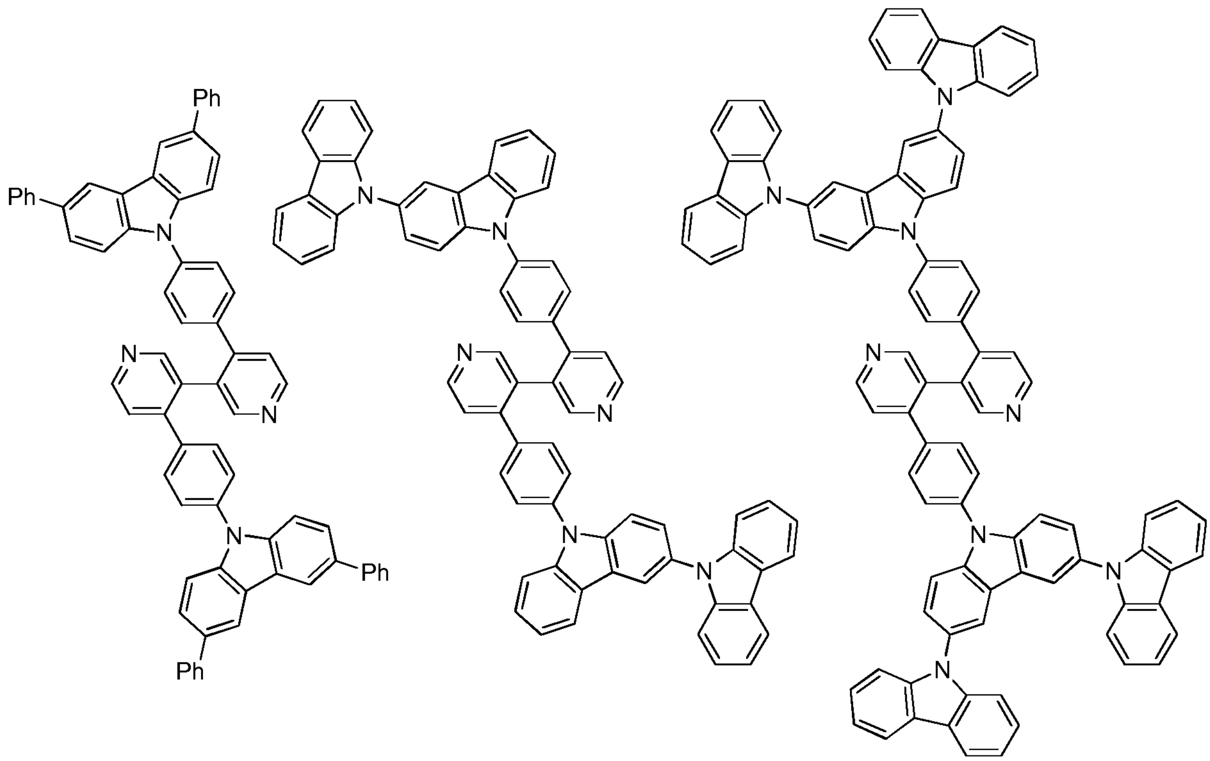

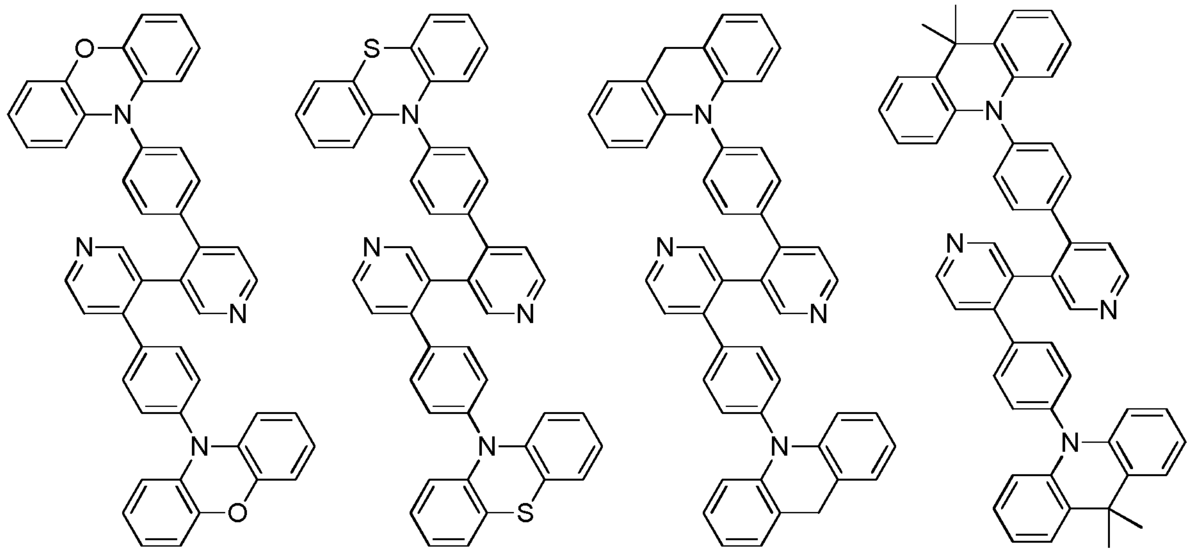

(0.036 eV)

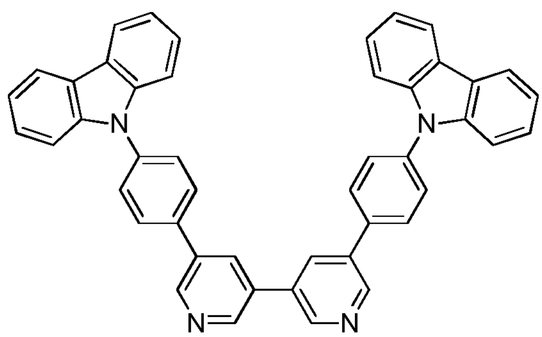

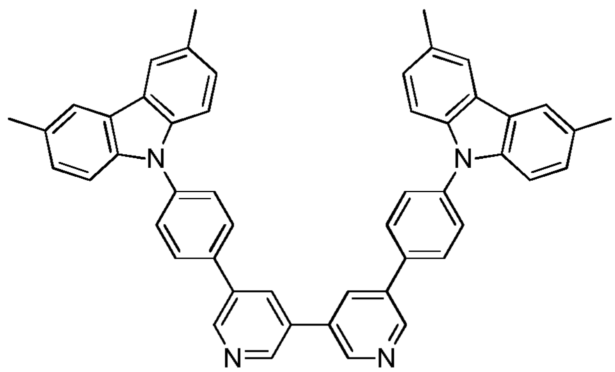

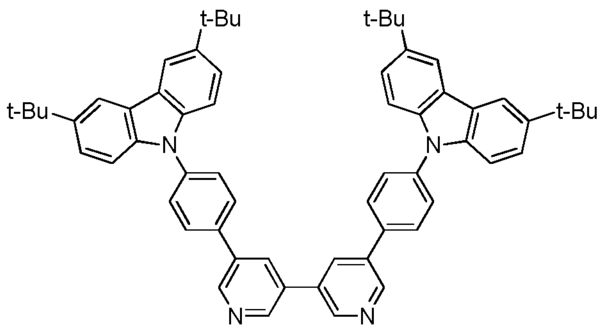

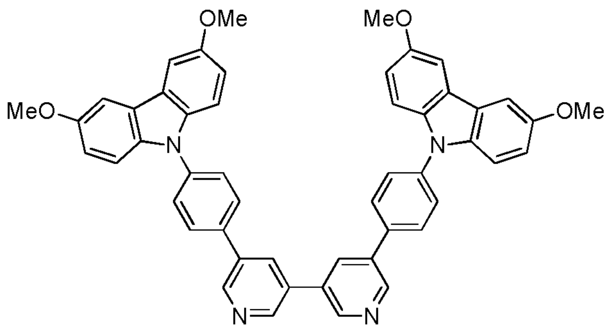

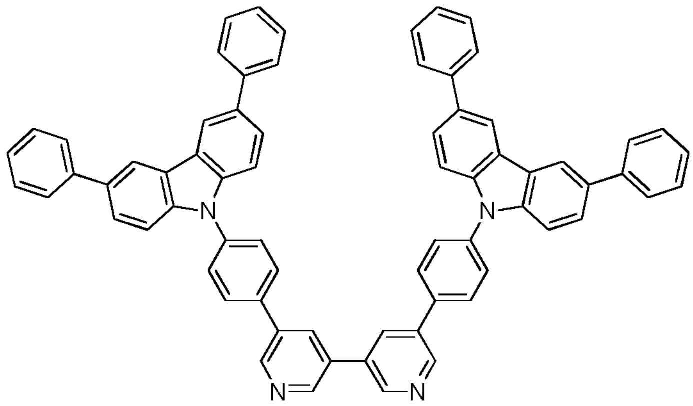

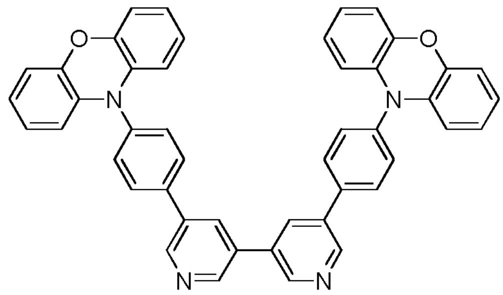

(0.008 eV)

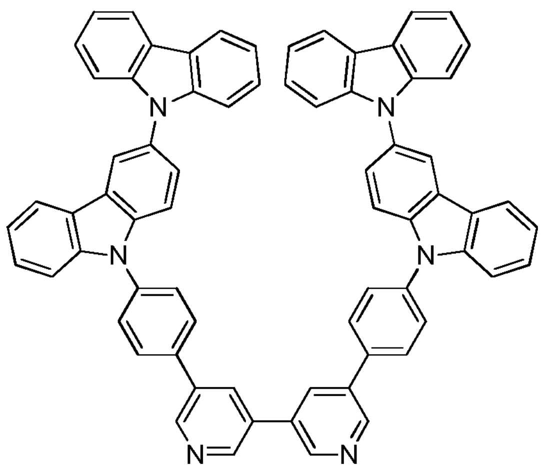

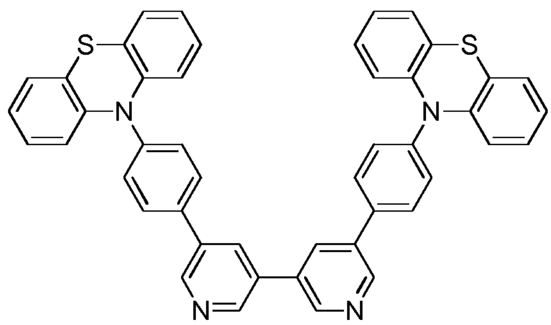

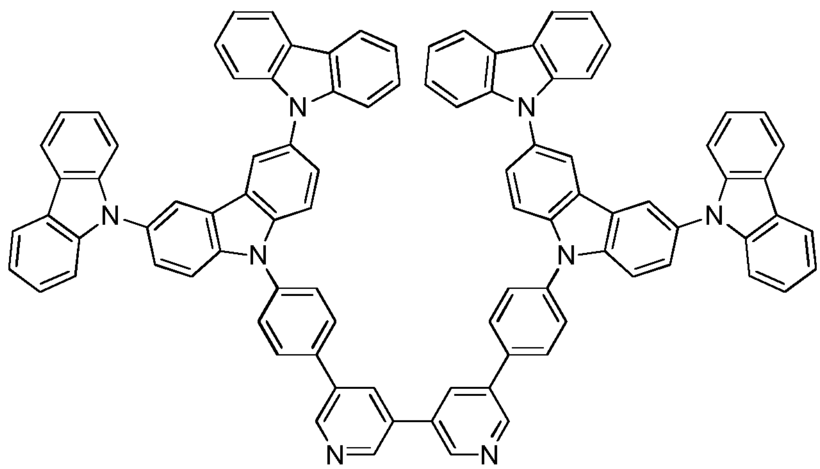

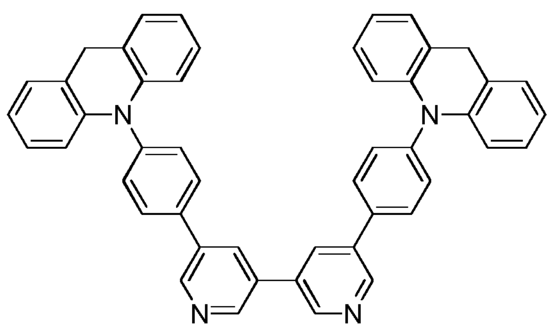

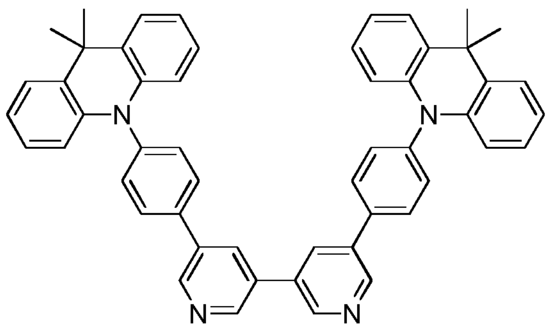

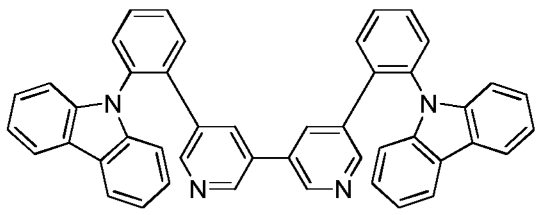

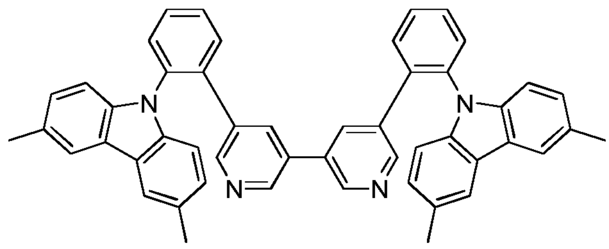

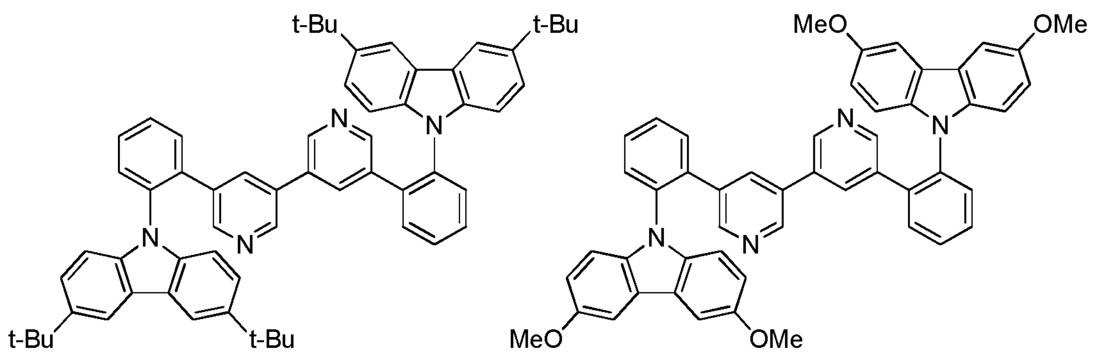

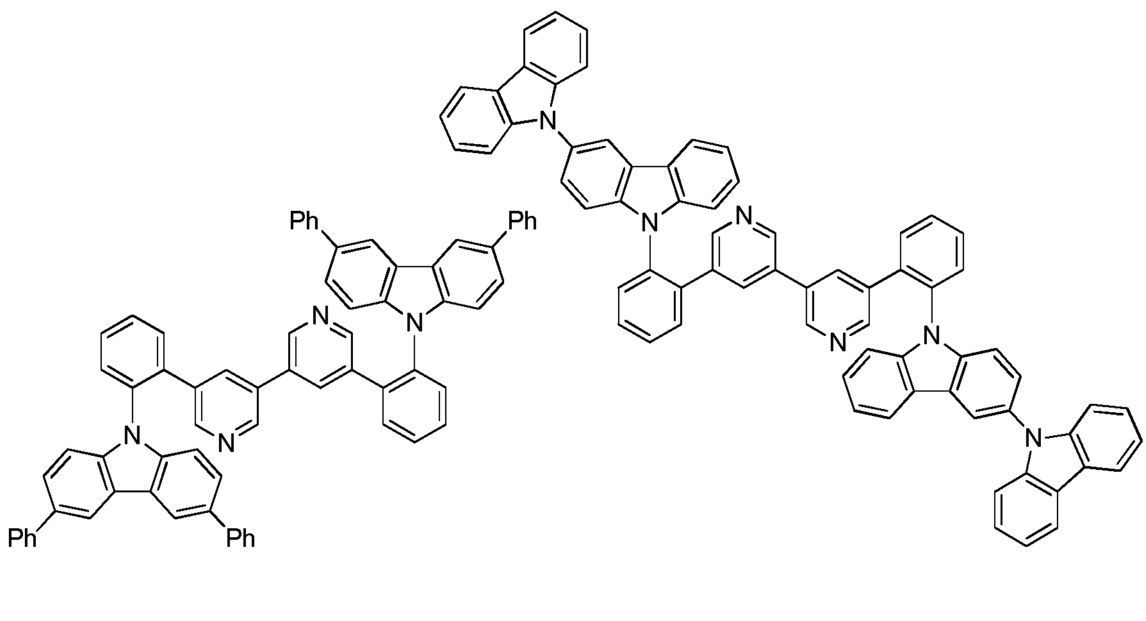

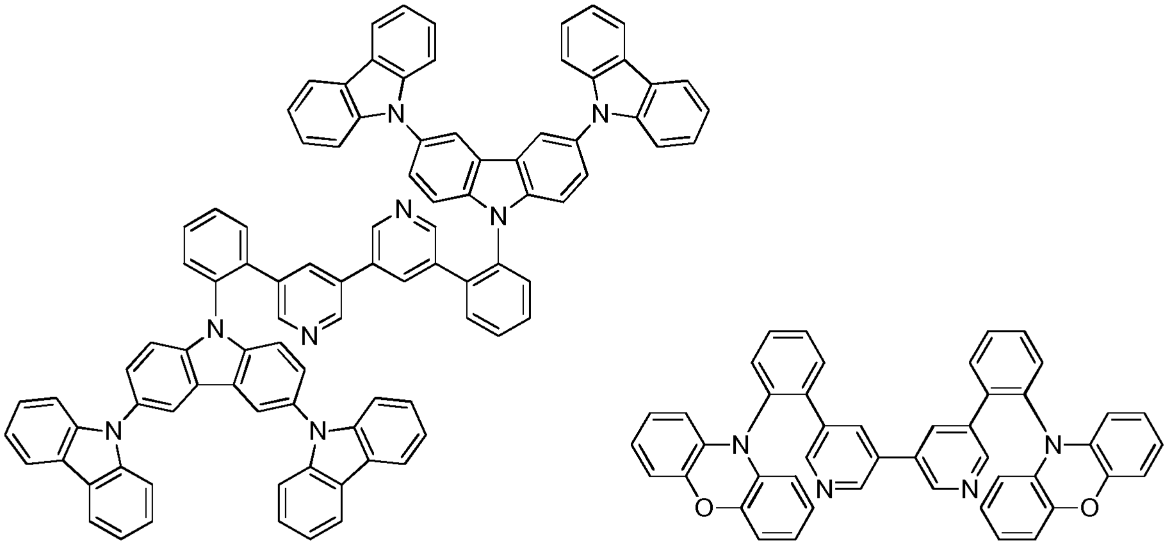

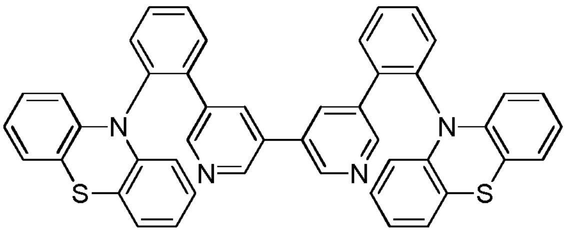

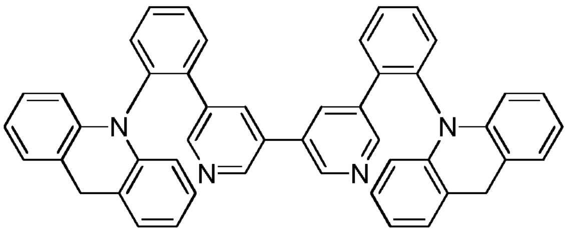

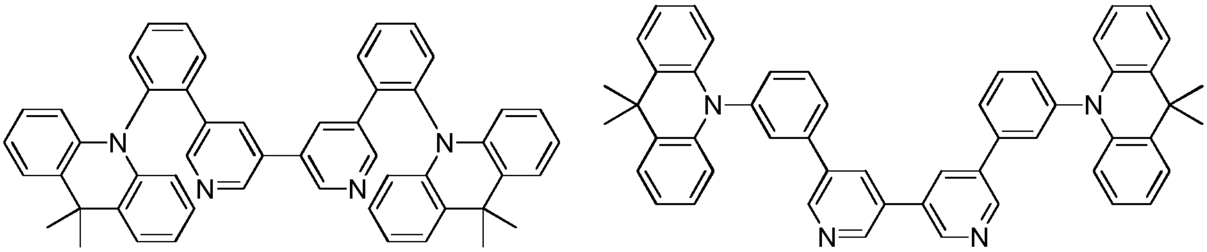

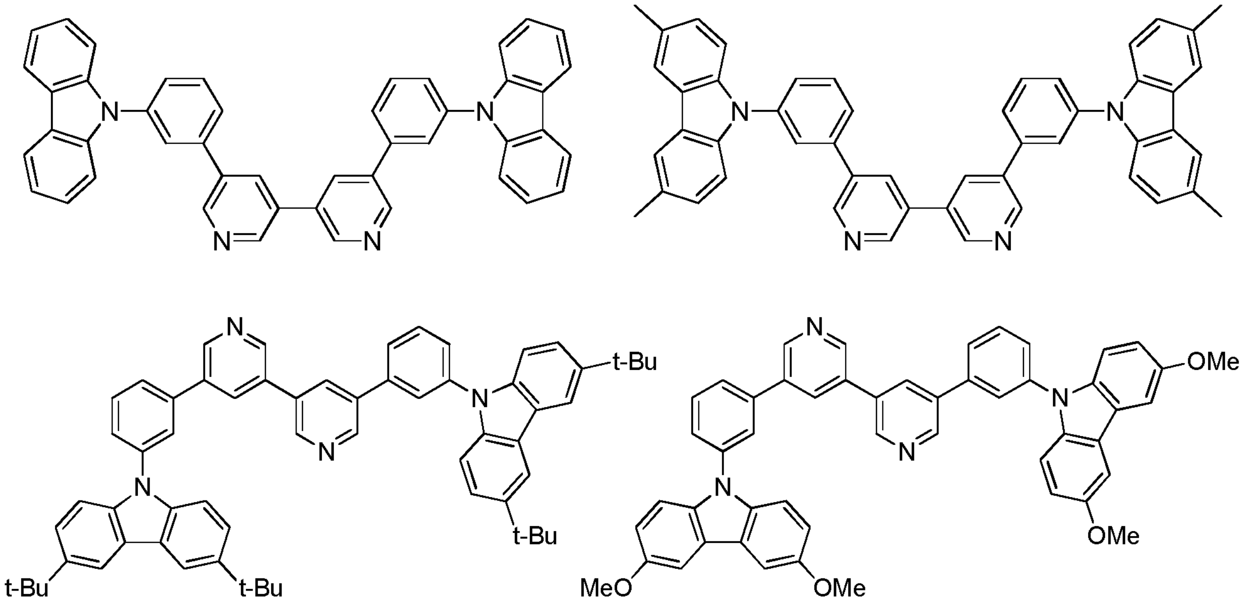

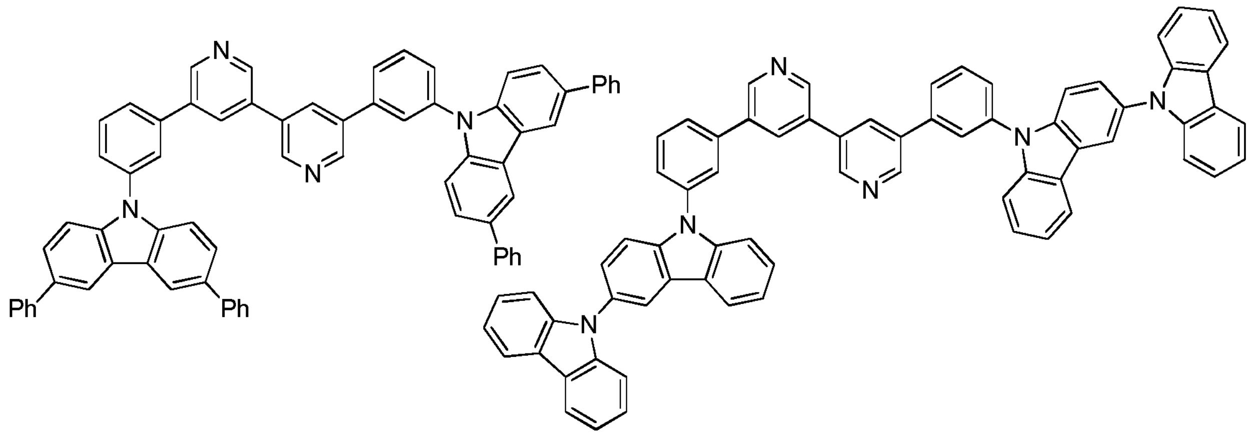

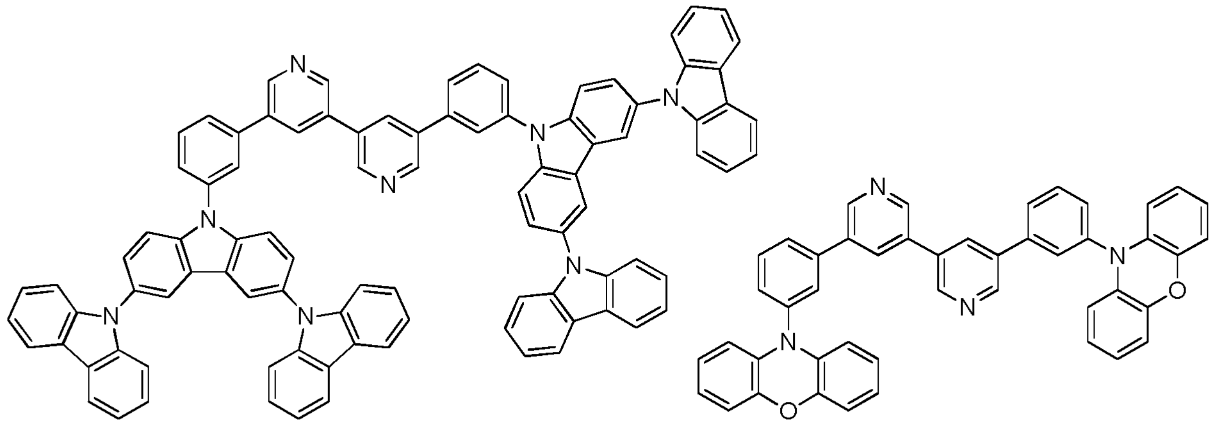

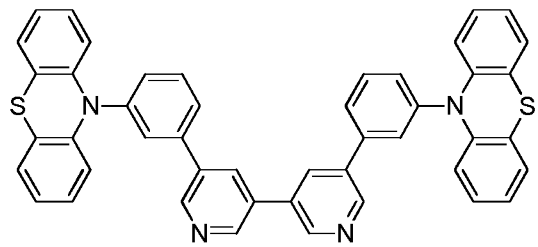

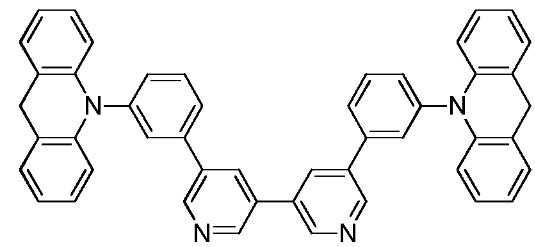

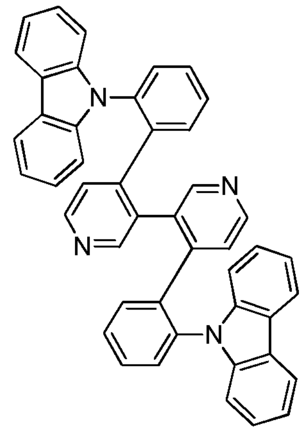

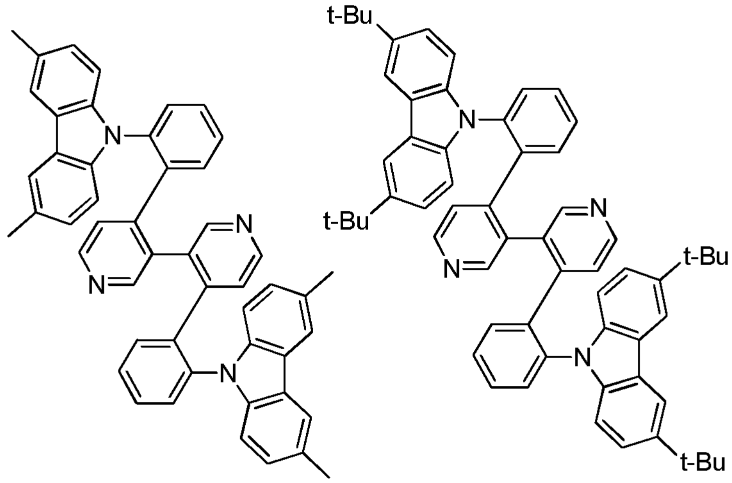

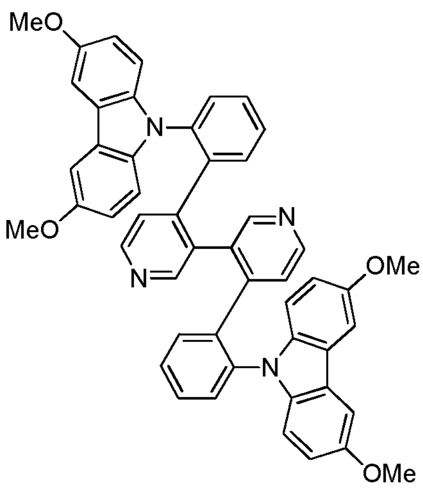

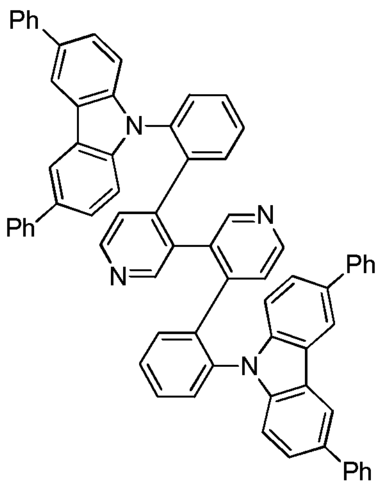

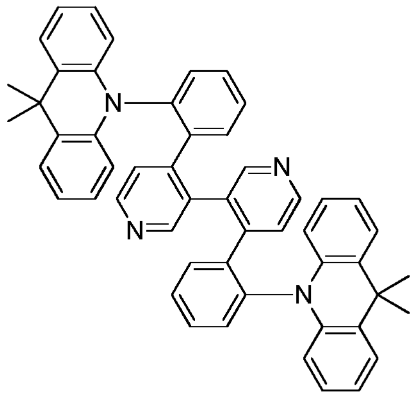

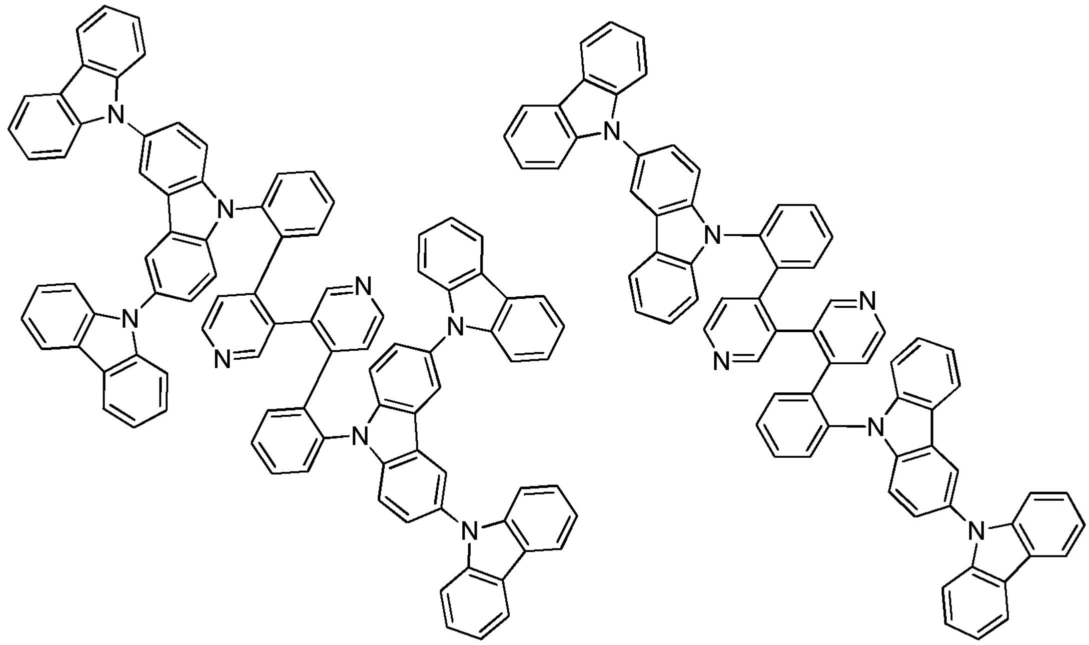

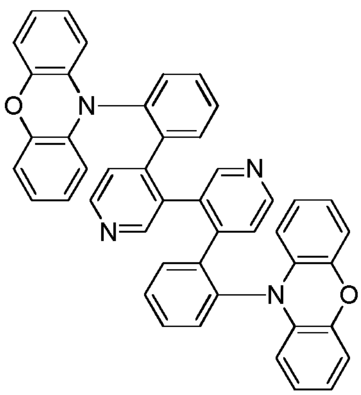

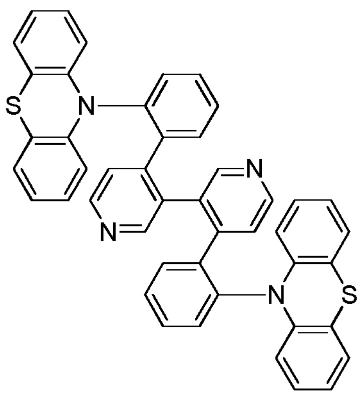

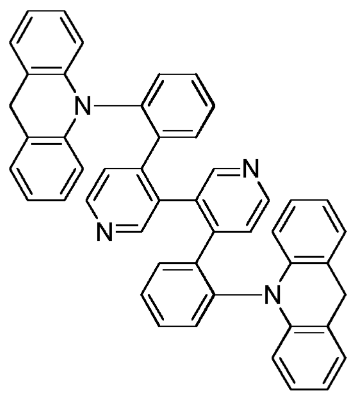

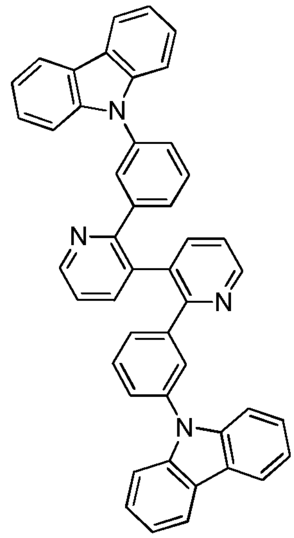

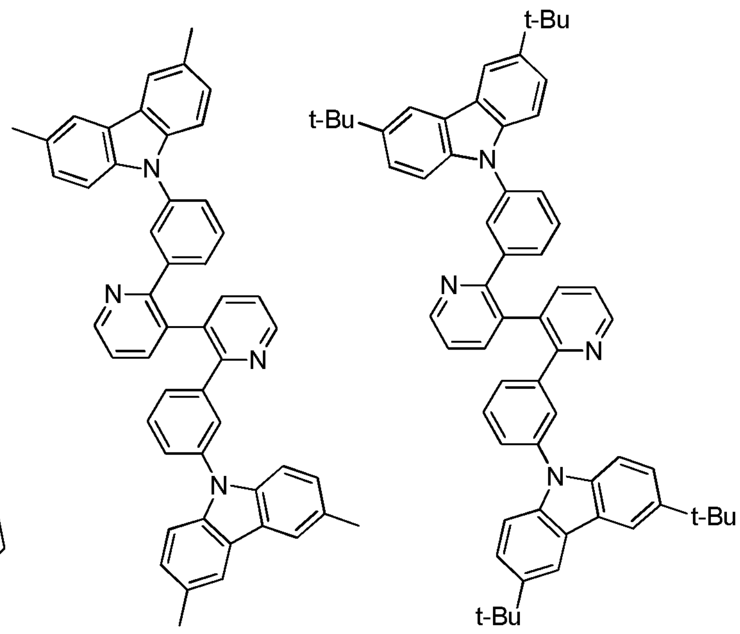

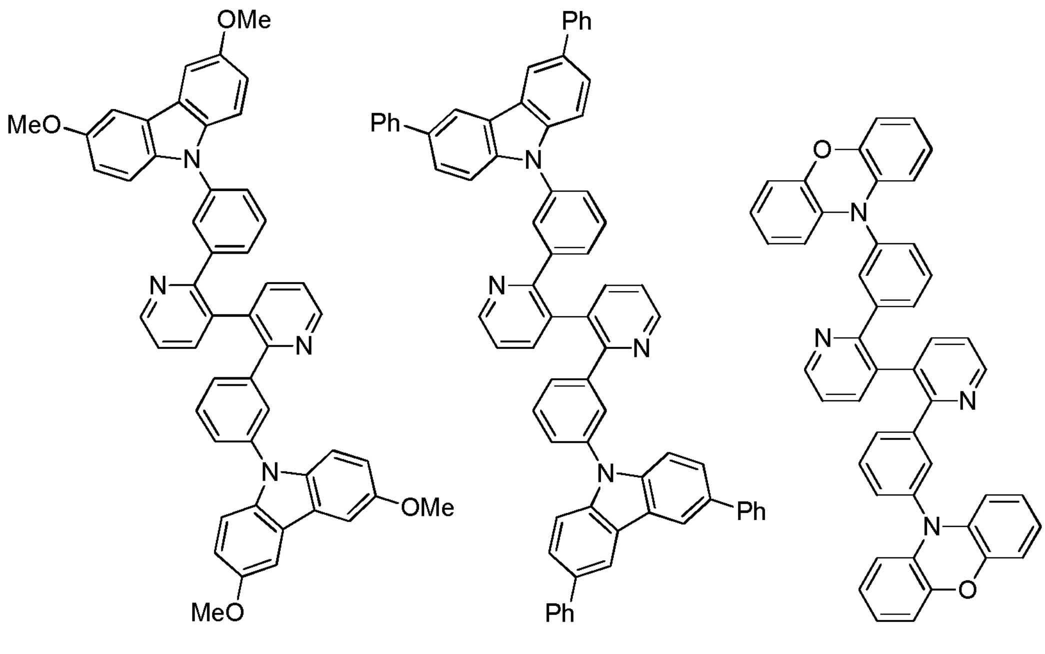

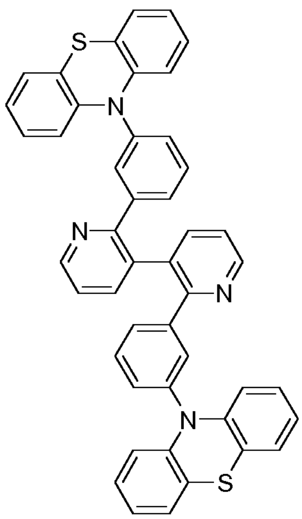

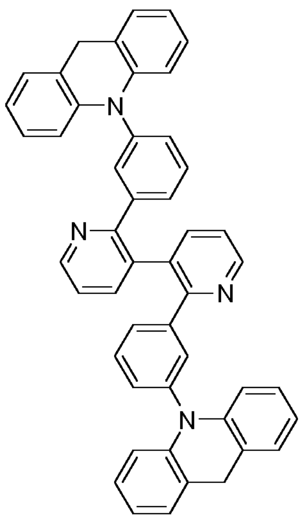

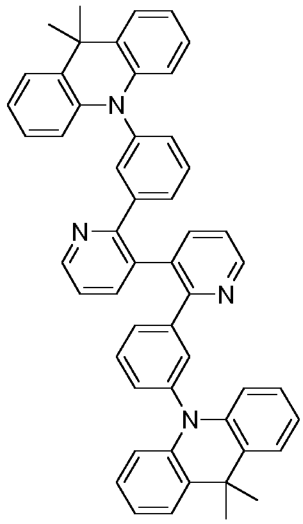

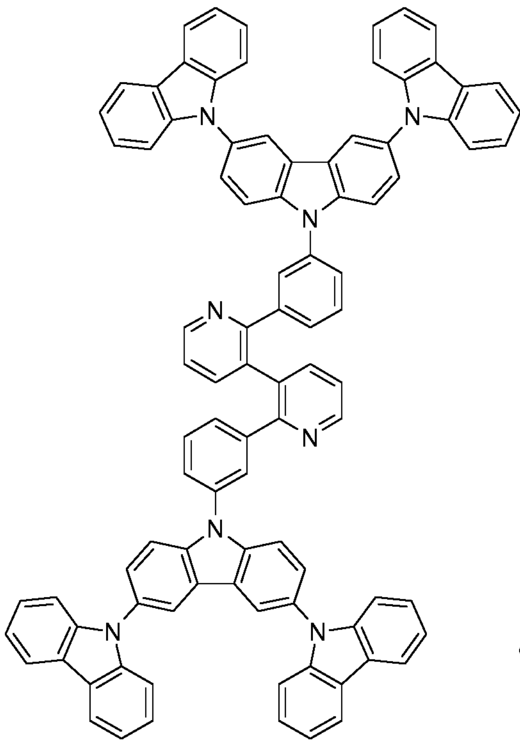

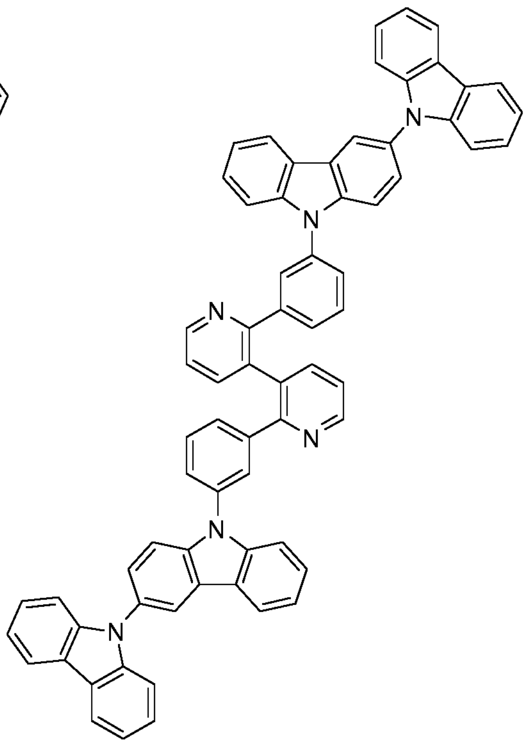

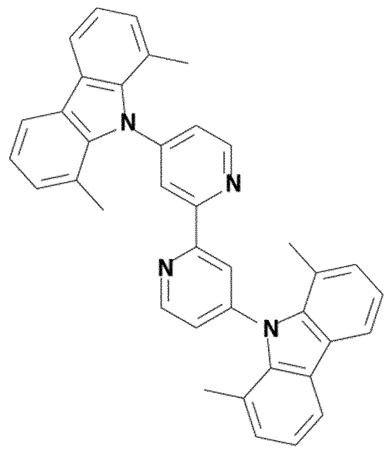

(0.073 eV)

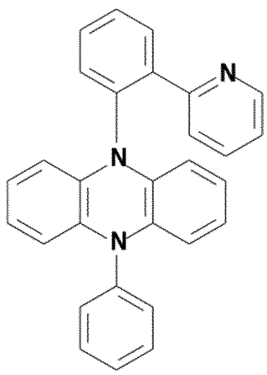

(0.038 eV)

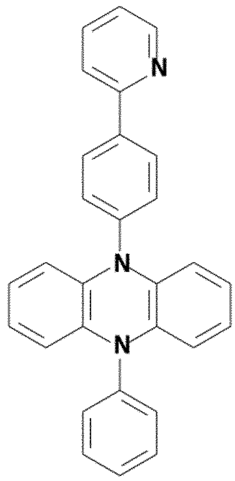

(0.007 eV)

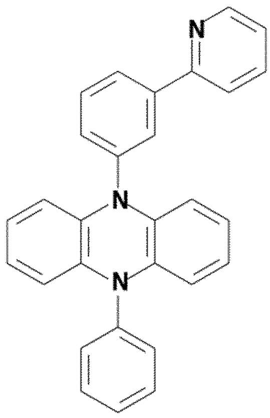

(0.037 eV)

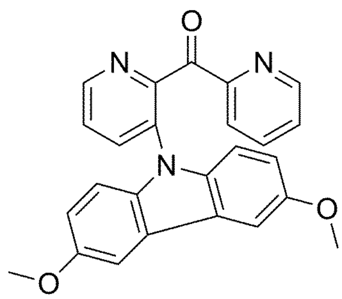

(0.025 eV)

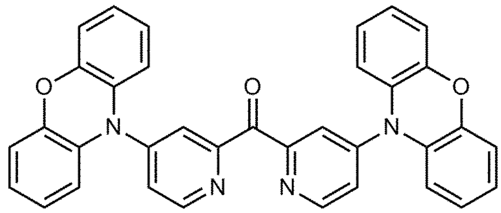

(0.056 eV)

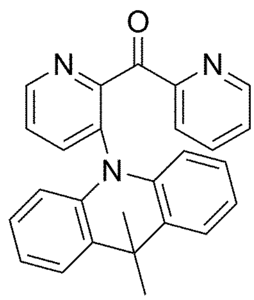

(0.025 eV)

**Tabelle 2a:** Beispiele für erfindungsgemäße organische Moleküle.

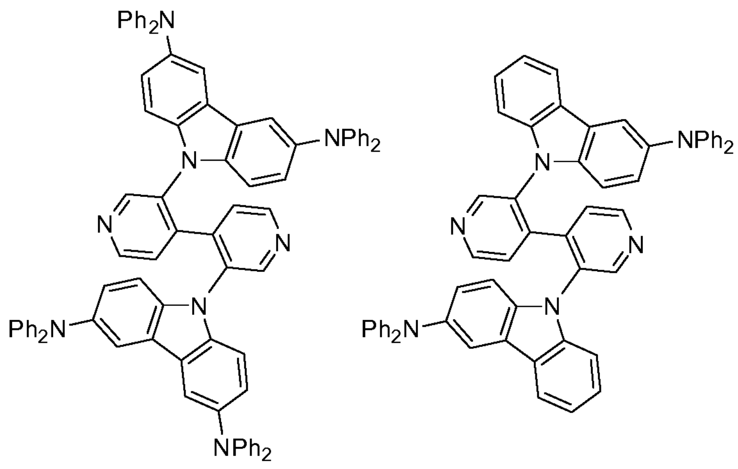

(0.014 eV)

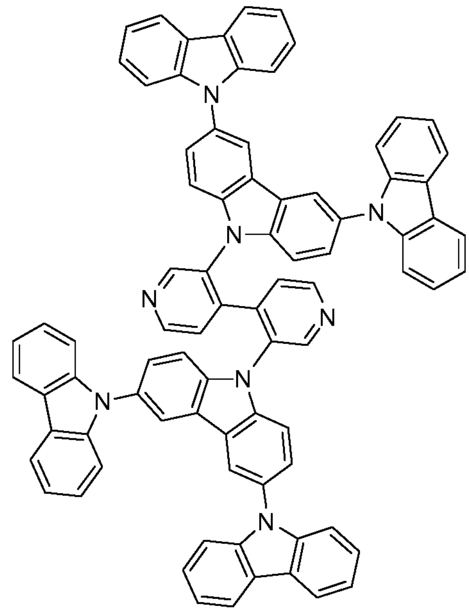

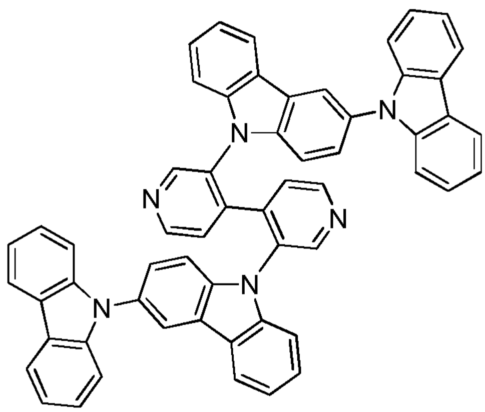

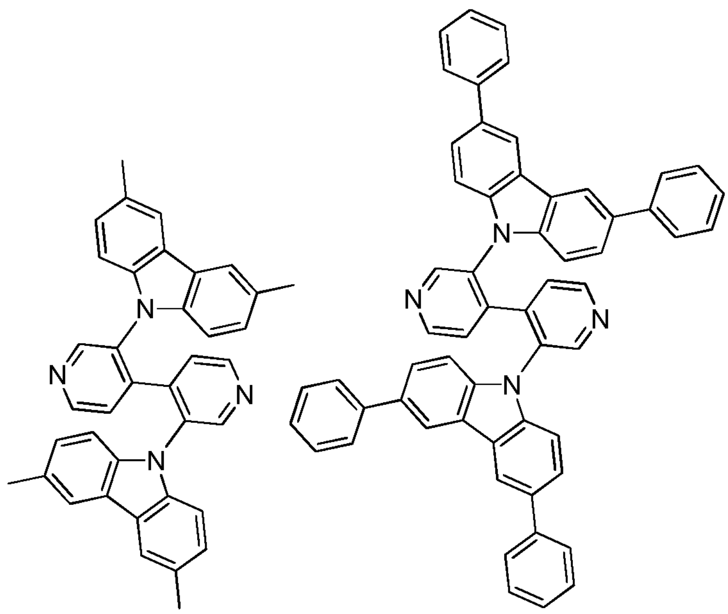

(0.051 eV)

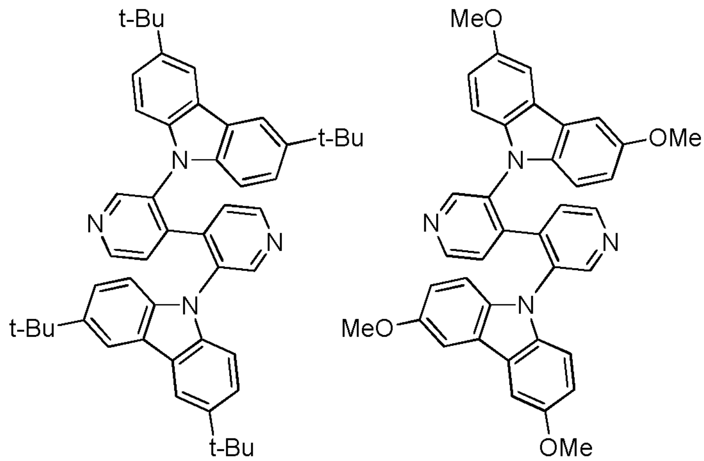

(0.033 eV)

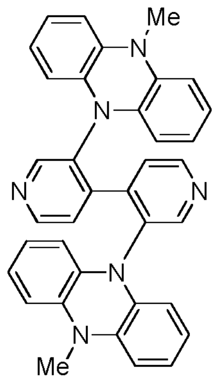

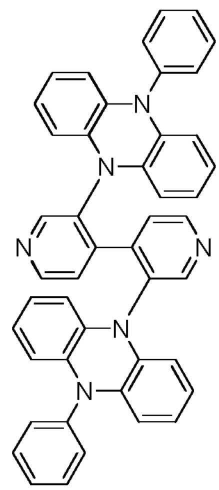

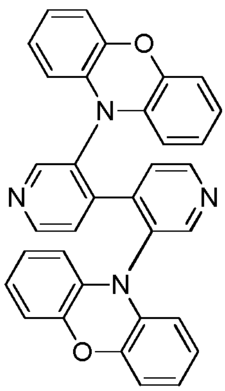

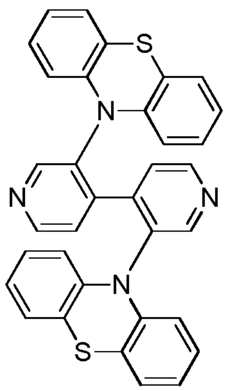

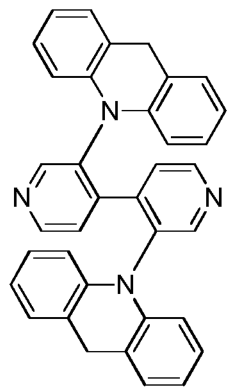

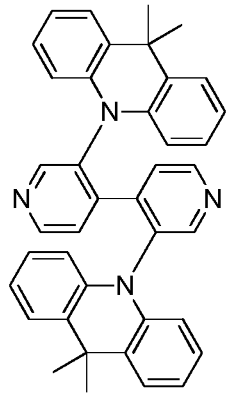

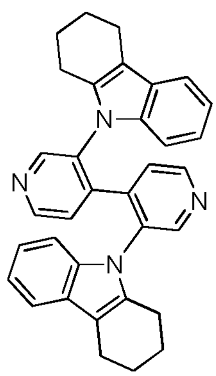

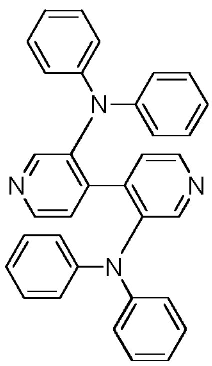

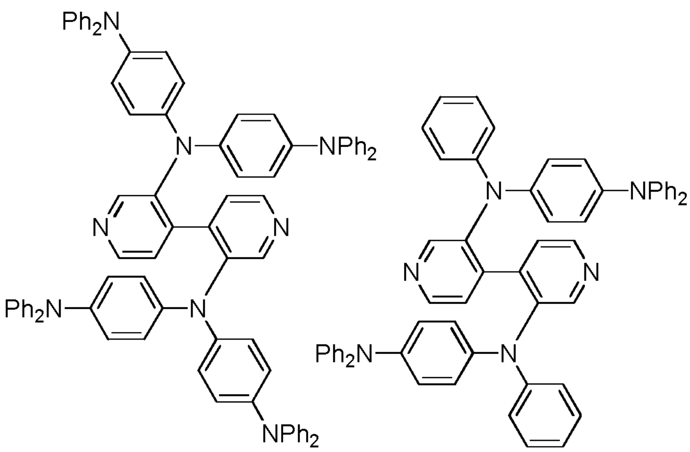

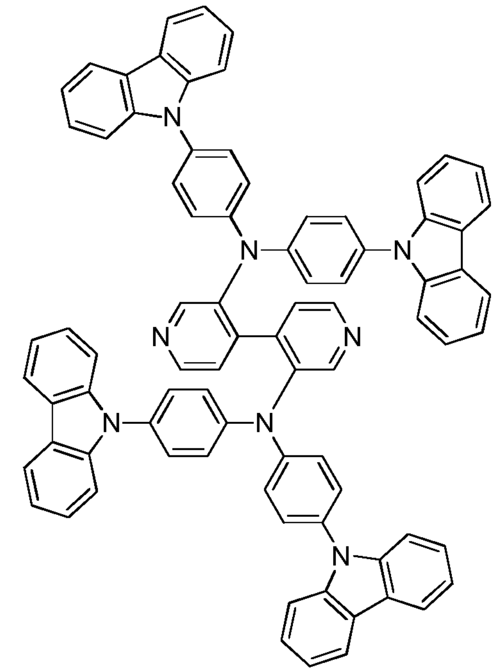

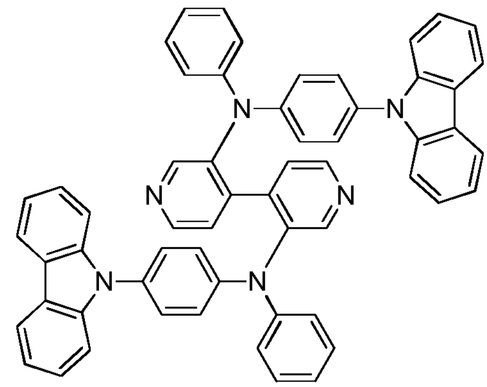

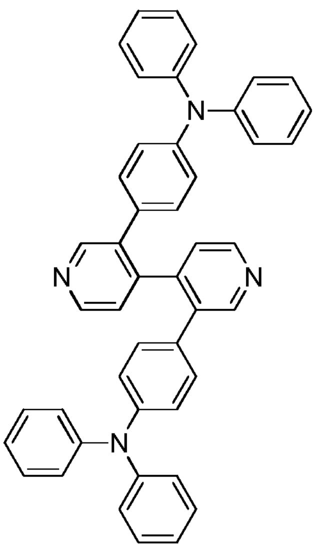

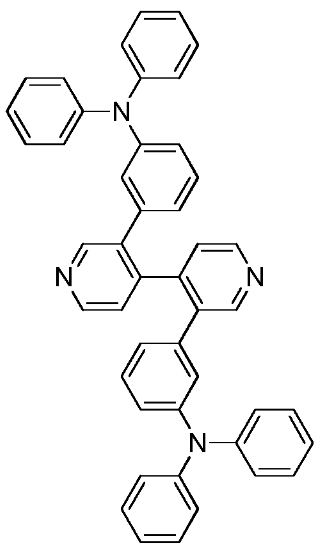

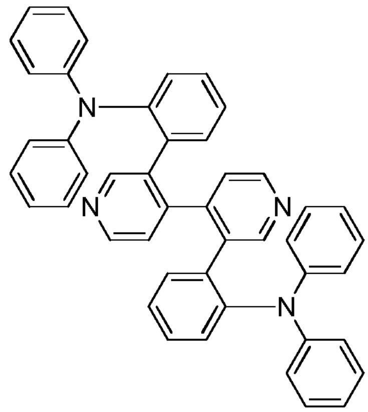

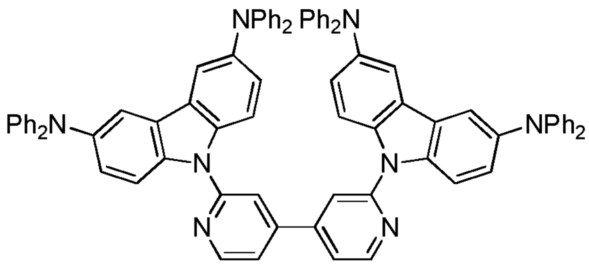

(0.093 eV)

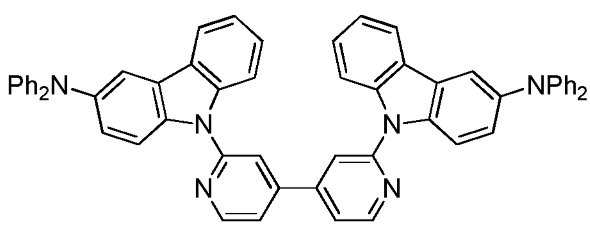

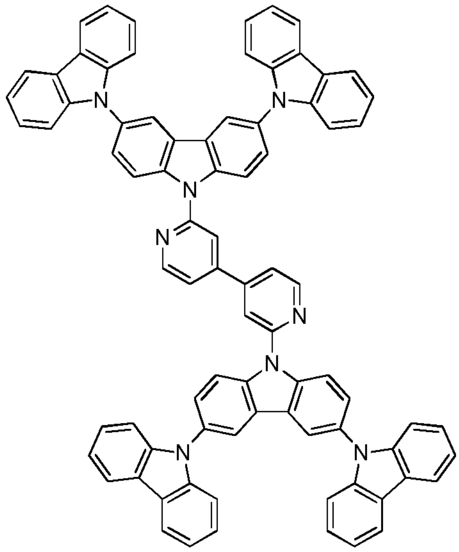
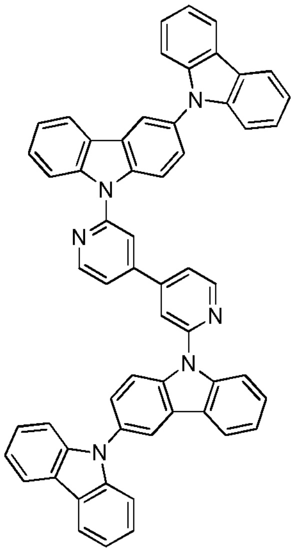
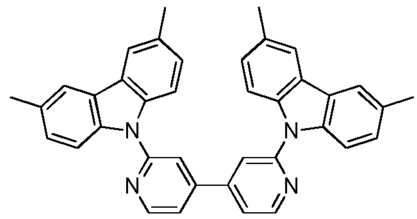
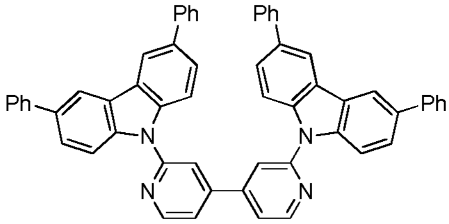
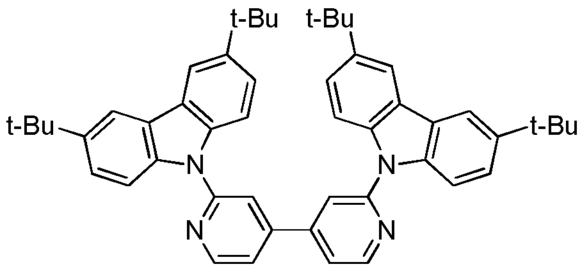
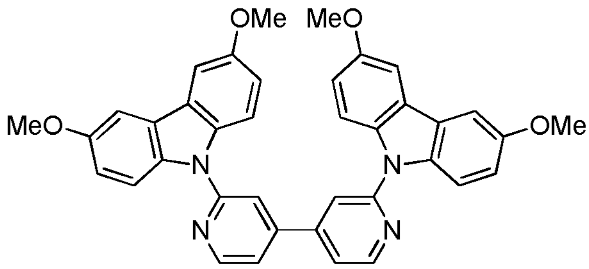
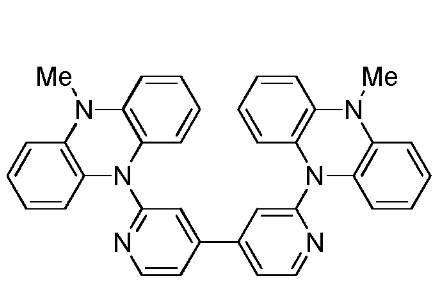
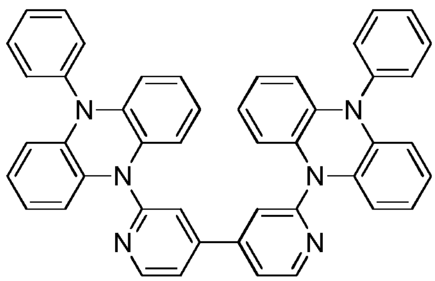
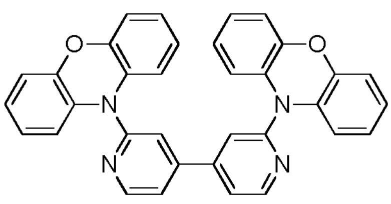
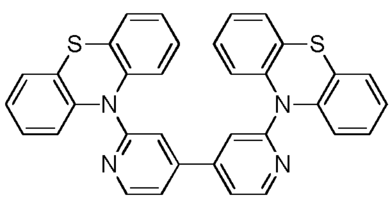
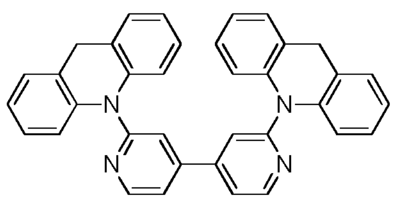
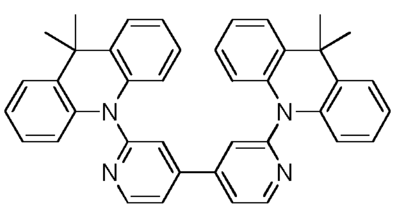
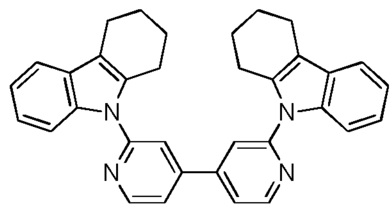
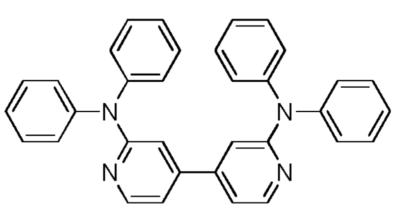

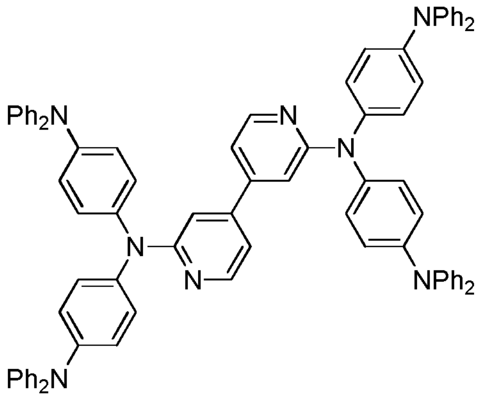

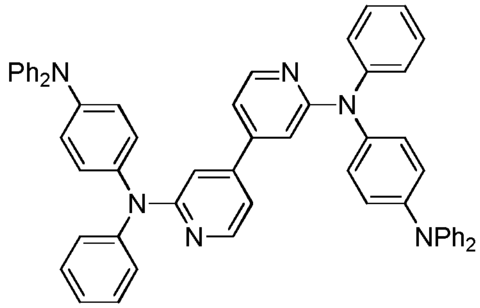

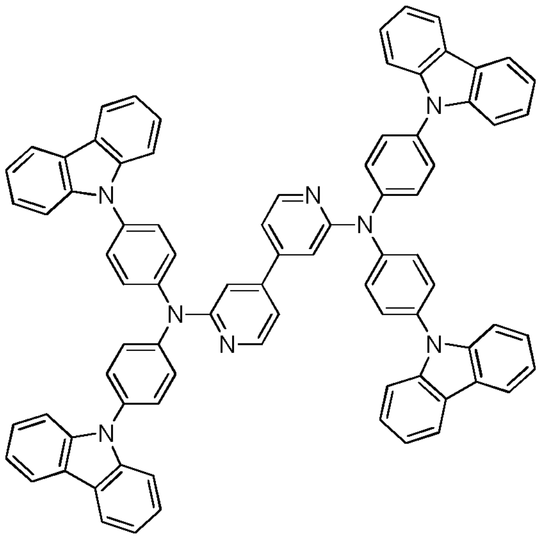

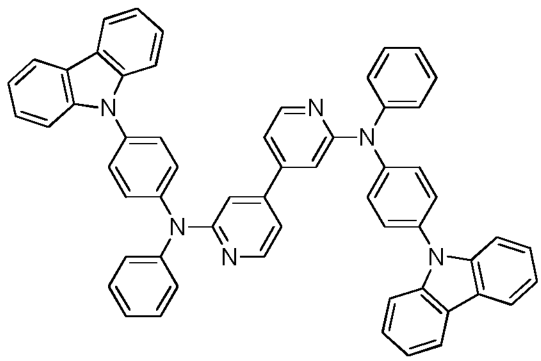

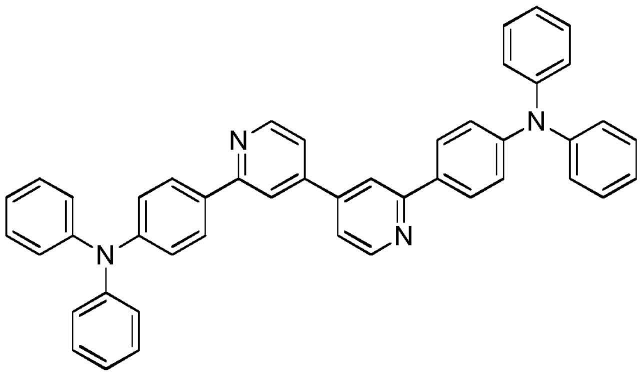

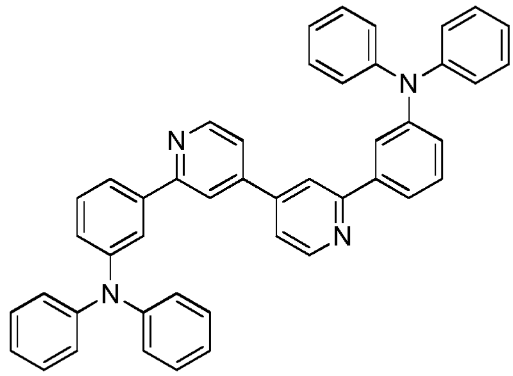

(0.215 eV)

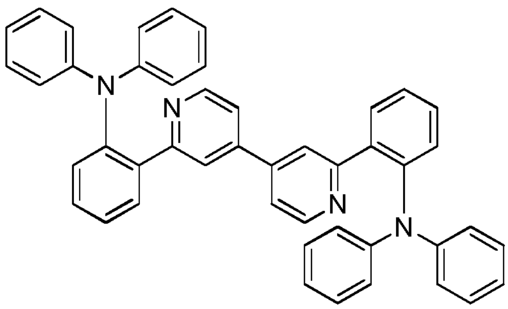

(0.099 eV)

(0.008 eV)

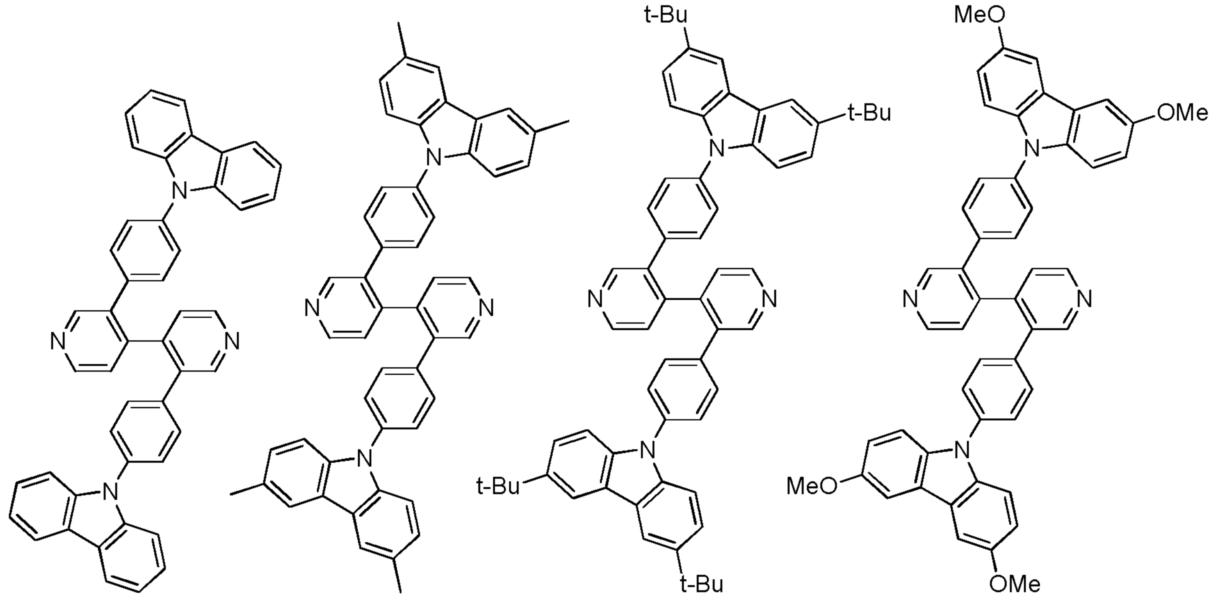

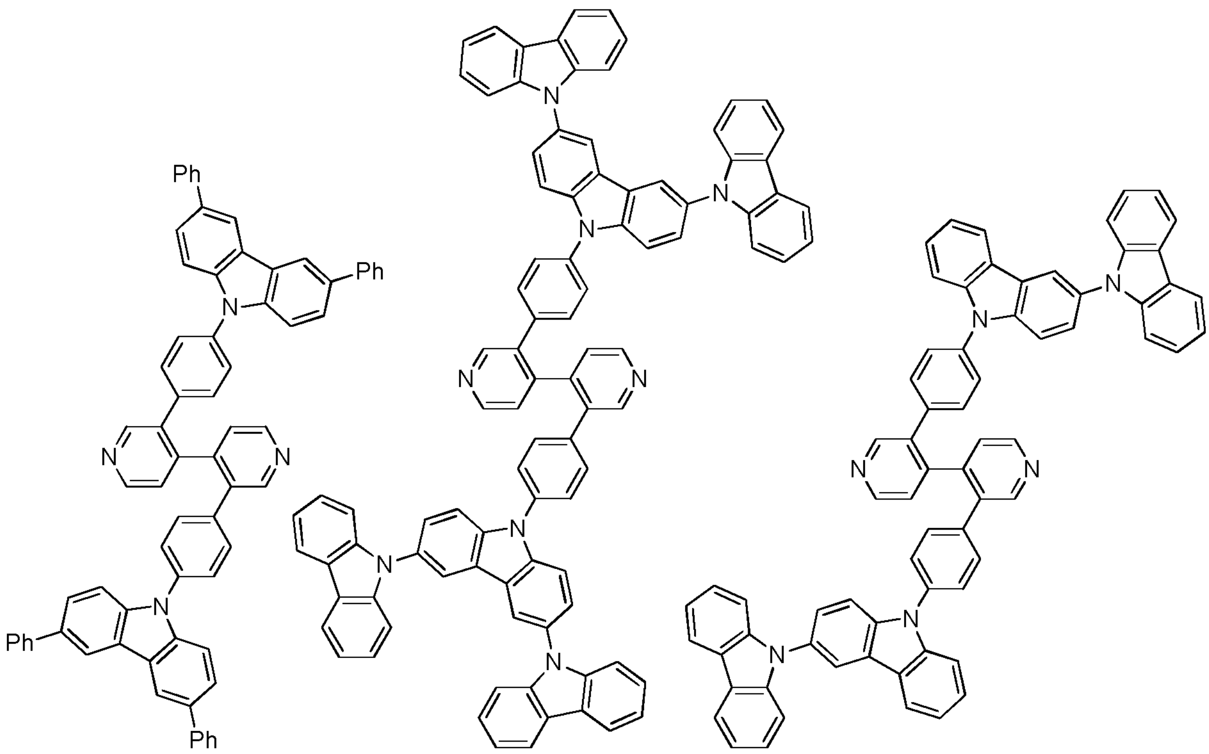

(0.239 eV)

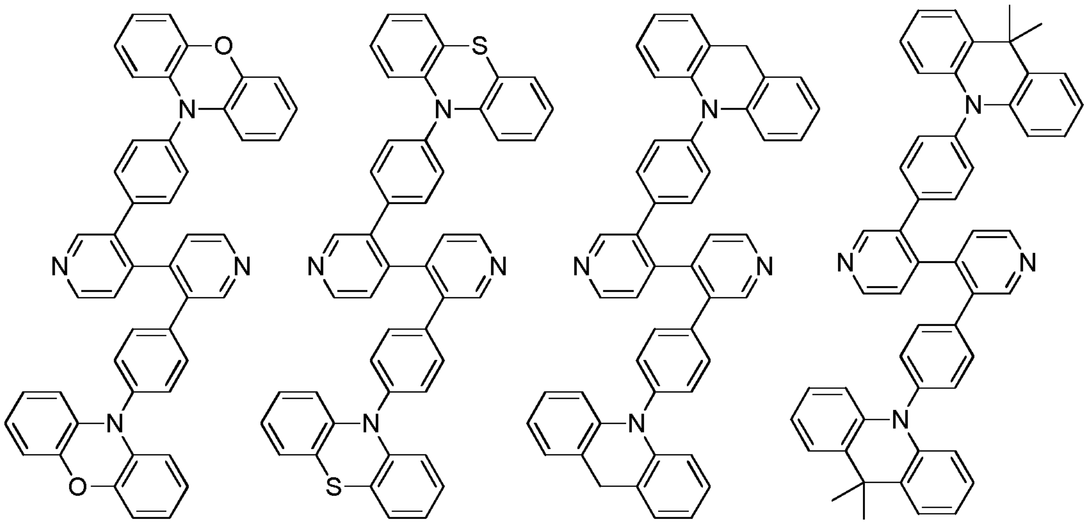

(0.016 eV)

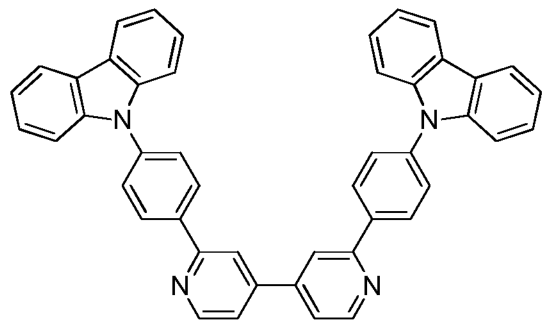

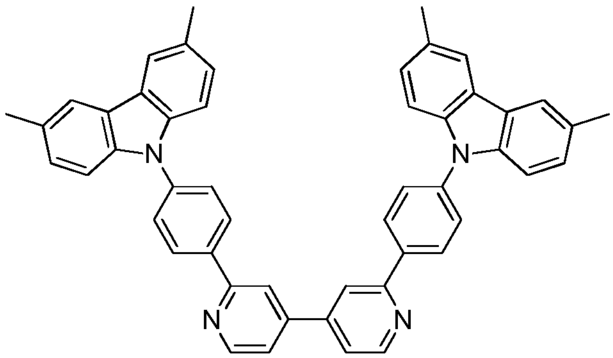

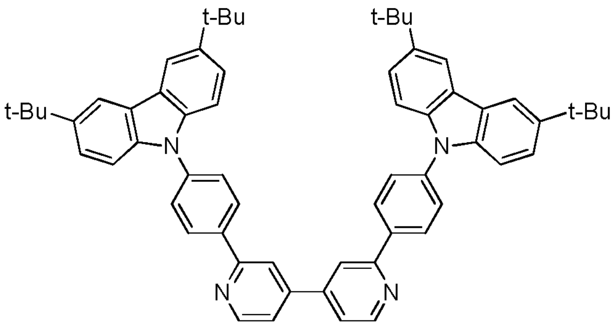

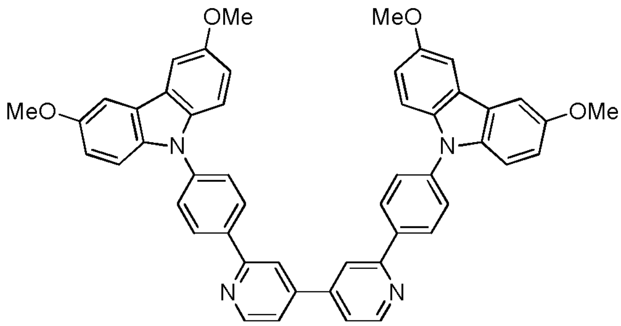

(0.217 eV)

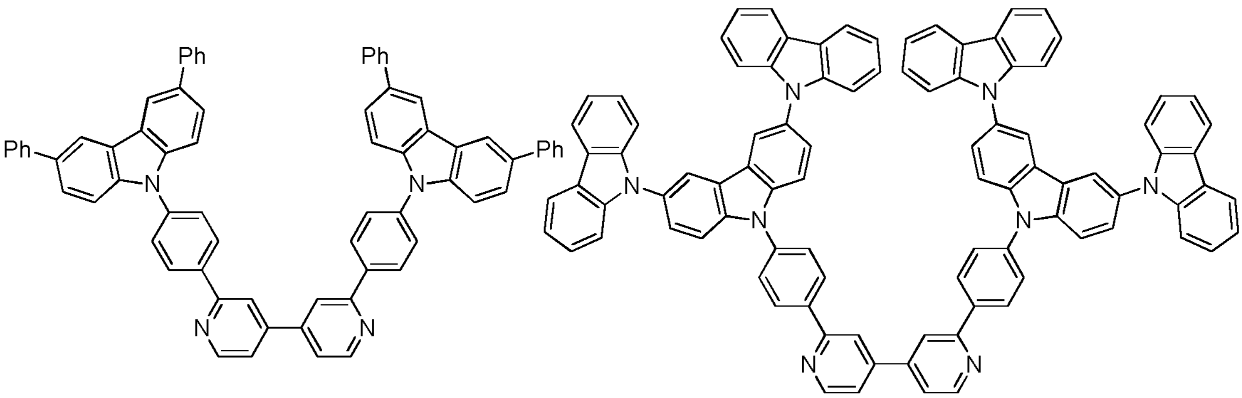

(0.295 eV)

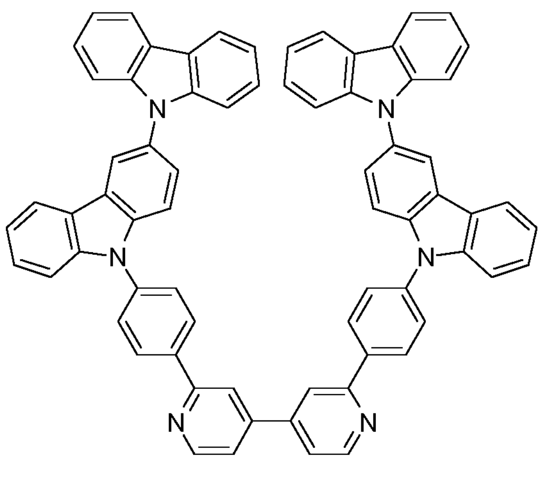

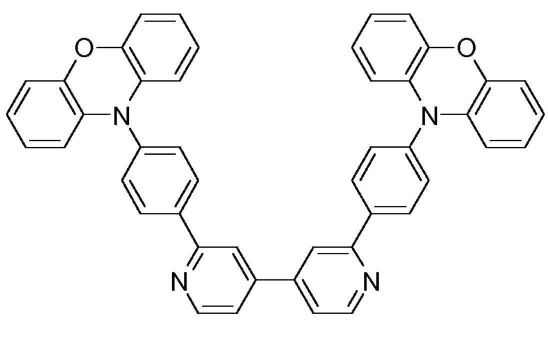

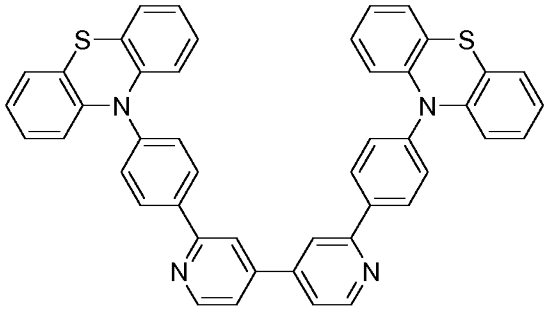

(0.013 eV)

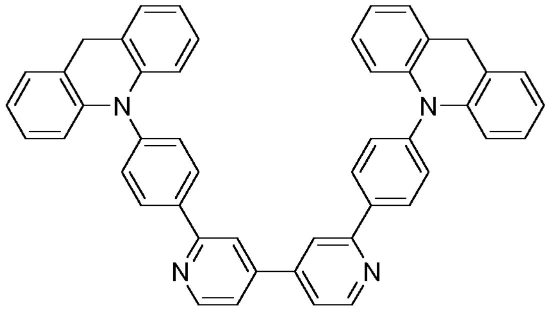

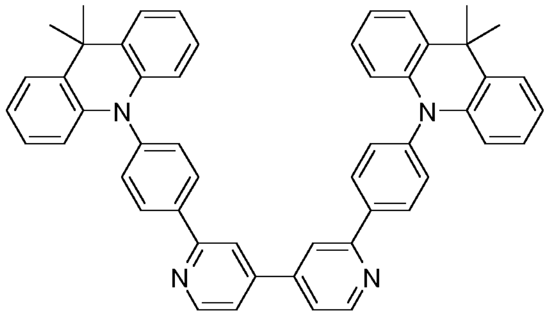

(0.005 eV)

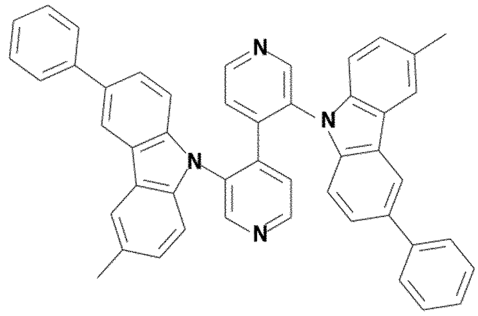

(0.043 eV)

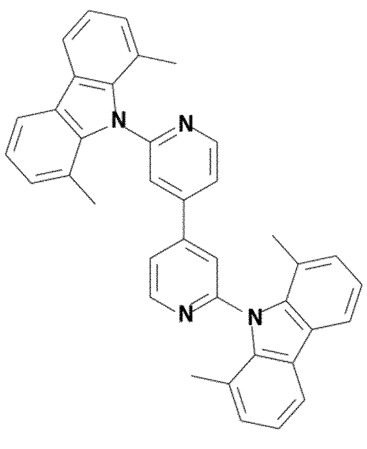

(0.055 eV)

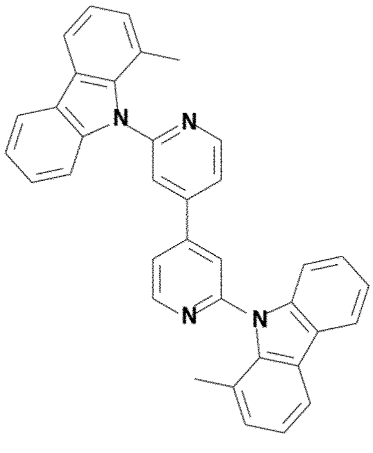

(0.141 eV)

In einer Ausführungsform unterscheidet insbesondere die Linkergruppe LG die organischen Moleküle funktionell von Molekülen gemäß dem Stand der Technik. Diese bewirkt einerseits einen Bruch der Konjugation zwischen dem konjugierten System des elektronendonierenden Molekülteils und dem des elektronenakzeptierenden Molekülteils, welcher insbesondere zur Lokalisierung der Grenzorbitale HOMO und LUMO auf unterschiedlichen Molekülteilen führt und somit zu einem geringen $\Delta E(S_1\text{-}T_1)$-Abstand führt. Andererseits vergrößert die Linkergruppe LG das Überlappungsintegral zwischen HOMO und LUMO, was zu einer hohen Oszillatorstärke des entsprechenden quantenmechanischen Übergangs führt. Dadurch können hohe Lumineszenzquantenausbeuten und kurze Abklingzeiten des angeregten Zustands erreicht werden. Bekannte organische Emitter bestehen in der Regel aus direkt verknüpften chemischen Einheiten. Eine Trennung der konjugierten aromatischen Systeme fand bisher nicht statt, insbesondere in Verbindung mit der Lokalisierung von HOMO und LUMO auf separaten Molekülteilen. Linkergruppen im Sinne dieser Erfindung verändern die Lage des HOMO bzw. LUMO der AF1 und der AF2 nicht signifikant. Als nicht signifikant gilt im Rahmen dieser Erfindung eine Veränderung von nicht mehr als +/- 0,4 eV. Die Berechnung derartiger Energien ist bekannt und funktioniert nach der oben beschriebenen Weise per DFT-Rechnung.

Anhand spektroskopischer Auswahlregeln (symmetrische Moleküle) oder durch Messung des Extinktionskoeffizienten (UV/VIS-Spektroskopie) oder anhand quantenchemischer Berechnung der Oszillatorstärke kann vorhergesagt werden, ob ein quantenmechanischer Übergang erlaubt ist. Je größer die Oszillatorstärke, desto eher ist ein Übergang erlaubt und desto schneller ist der damit verbundene Prozess (Abklingdauer). Angestrebt sind Abklingdauern von < 300 µs, insbesondere < 100 µs, oder von < 50 µs. Bei einer langen Abklingdauer des (organischen) Emitters kommt es bei hohen Stromstärken schnell zu Sättigungseffekten, was die Bauteillebensdauer negativ beeinflusst und die Erreichung hoher Helligkeiten verhindert.

Ein Maß für die Abklingdauer ist der $\Delta E(S_1-T_1)$-Abstand. Dieser wird durch die Überlappung von HOMO und LUMO beeinflusst. Die Größe des quantenmechanischen Überlappungsintegrals, welche nach oben genannter DFT-Methode berechenbar ist, kann durch Wahl der Linkergruppe gezielt gesteuert werden. Kommt es zur völligen Trennung von HOMO und LUMO hat dieses einen Wert von 0. Die Wahrscheinlichkeit einer effizienten Emission des organischen Moleküls sinkt drastisch. Bei einem Wert von 1 liegt nicht mehr verzögerte Fluoreszenz (TADF) sondern spontane Emission vor. Die gewünschte Überlappung wird in einer ausgewählten Form der Erfindung durch die geeignete Wahl einer Linkergruppe LG erreicht.

In einer Ausführungsform werden an die chemisch substituierbaren Positionen der so erhaltenen organischen Moleküle weitere Reste R angefügt, um die Löslichkeit der Emitter zu steigern und/oder die Polymerisierbarkeit zu ermöglichen ohne dabei die elektronischen Eigenschaften des Moleküls signifikant zu verändern, sodass auch bei Verwendung von R ein Emitter vorliegt, wobei

jedes R ist bei jedem Auftreten unabhängig voneinander ausgewählt aus der Gruppe bestehend aus H, Deuterium, Phenyl, Naphthyl, F, Cl, Br, I, $N(R^2)_2$, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, - C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=0)-, $-S(=O)_2-$, $-NR^2-$, -O-, oder-S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R auch miteinander ein monozyklisches aliphatisches Ringsystem mit insgesamt fünf oder sechs Ringgliedern bilden.

$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $As(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, - $Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, oder -S-ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden.

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

$R^4$ ist bei jedem Auftreten unabhängig voneinander ausgewählt aus der Gruppe bestehend aus H, Deuterium, Phenyl, Naphthyl, $N(R^2)_2$, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$,

-Ge($R^4$)$_2$-, -Sn($R^4$)$_2$, -C(=O)-, - C(=S)-, -C(=Se)-, -C=N-, -C(=O)O-, -C(=O)N($R^3$)-, -P(=O)($R^7$)-, -As(=O)($R^7$)-, -P(=S)($R^7$)-, - As(=S)($R^7$)-, -S(=O)-, -S(=O)$_2$-, -$NR^2$-, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden.

$R^5$ ist bei jedem Auftreten unabhängig voneinander ausgewählt aus der Gruppe bestehend aus Phenyl, Naphthyl, $CF_3$, C(=O)$R^3$, P(=O)($R^7$)$_2$, As(=O)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9C$=$CR^9$-, -C=C-, bzw. eine benachbarte $CH_2$-Gruppe durch -Si($R^4$)$_2$-, -Ge($R^4$)$_2$-, -Sn($R^4$)$_2$, -C(=O)-, - C(=S)-, -C(=Se)-, -C=N-, -C(=O)O-, -C(=O)N($R^3$)-, -P(=O)($R^7$)-, -As(=O)($R^7$)-, -P(=S)($R^7$)-, - As(=S)($R^7$)-, -S(=O)-, -S(=O)$_2$-, -$NR^2$-, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden.

$R^6$ ist bei jedem Auftreten unabhängig voneinander ausgewählt aus der Gruppe bestehend aus Phenyl, Naphthyl, $CF_3$, Si($R^4$)$_3$, C(=O)$R^3$, P(=O)($R^7$)$_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9C$=$CR^9$-, -C=C-, bzw. eine benachbarte $CH_2$-Gruppe durch-Si($R^4$)$_2$-, -Ge($R^4$)$_2$-, -Sn($R^4$)$_2$, -C(=O)-, - C(=S)-, -C(=Se)-, -C=N-, -C(=O)O-, -C(=O)N($R^3$)-, -P(=O)($R^7$)-, -As(=O)($R^7$)-, -P(=S)($R^7$)-, - As(=S)($R^7$)-, -S(=O)-, -S(=O)$_2$-, -$NR^2$-, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden.

$R^7$ ist bei jedem Auftreten unabhängig voneinander ausgewählt aus der Gruppe bestehend aus Phenyl, Naphthyl, N($R^2$)$_2$, $CF_3$, C(=O)O$R^3$, C(=O)N($R^3$)$_2$, Si($R^4$)$_3$, C(=O)$R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9C$=$CR^9$-, -C=C-, bzw. eine benachbarte $CH_2$-Gruppe durch -Si($R^4$)$_2$-, - Ge($R^4$)$_2$-, -Sn($R^4$)$_2$, -C(=O)-, -C(=S)-, -C(=Se)-, -C=N-, -C(=O)O-, -C(=O)N($R^3$)-, -P(=O)($R^7$)-, - As(=O)($R^7$)-, -P(=S)($R^7$)-, -As(=S)($R^7$)-, -S(=O)-, -S(=O)$_2$-, -$NR^2$-, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden.

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden.

$R^9$ ist bei jedem Auftreten unabhängig voneinander ausgewählt aus der Gruppe bestehend aus H, Deuterium, Phenyl, Naphthyl, $N(R^2)_2$, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, -C=N-, -C(=O)O-, - $C(=O)N(R^3)-$, $-P(=O)(R^7)-$, $-As(=O)(R^7)-$, $-P(=S)(R^7)-$, $-As(=S)(R^7)-$, -S(=0)-, $-S(=O)_2-$, $-NR^2-$, - O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem.

Polymerisierbare Reste sind solche Reste, die polymerisierbare funktionelle Einheiten tragen, die mit sich selbst homopolymerisiert oder mit anderen Monomeren copolymiersiert werden können. Somit können die erfindungsgemäßen Moleküle als Polymer mit folgenden Wiederholungseinheiten der Formeln 5 und 6 erhalten werden, die als Polymere in der lichtemittierenden Schicht des optoelektronischen Bauelements Verwendung finden können.

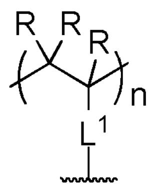
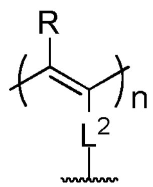

**Formel 5** **Formel 6**

In Formel 5 und 6 stehen L1 und L2 für gleiche oder verschiedene Linkergruppen, die 0 bis 20, insbesondere 1 bis 15, oder 2 bis 10 Kohlenstoffatome aufweist, und wobei die gewellte Linie die Position kennzeichnet, über die die Linkergruppe an das organische Molekül der Formel 1 angebunden ist. In einer Ausführungsform weist die Linkergruppe L1 und/oder L2 eine Form -X-L3- auf, wobei X für O oder S steht und L3 für eine Linkergruppe ausgewählt aus der Gruppe aus einer substituierten und unsubstituierten Alkylengruppe (linear, verzweigt oder cyclisch) und einer substituierten und unsubstituierten Arylengruppe, insbesondere eine substituierte oder unsubstituierte Alkylengruppe mit 1 bis 10 Kohlenstoffatomen oder eine substituierte oder unsubstituierte Phenylengruppe, wobei auch Kombinationen möglich sind. In einer weiteren Ausführungsform weist die Linkergruppe L1 und/oder L2 eine Form - C(=O)O- auf. R ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten R auch miteinander ein mono- oder polycyclisches, aliphatisches Ringsystem bilden, außerdem kann R sein: eine lineare Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen.

Vorteilhafte Ausführungsformen der Wiederholungseinheiten sind Strukturen der Formeln 7 bis 12:

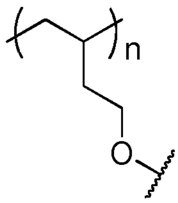 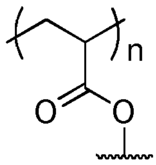 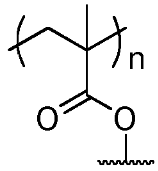 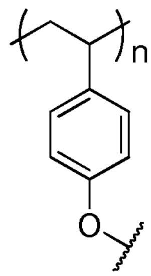 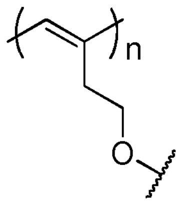 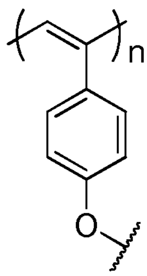

Formel 7 Formel 8 Formel 9 Formel 10 Formel 11 Formel 12

Zur Herstellung der Polymere, die die Wiederholungseinheiten gemäß Formel 7 bis 12 aufweisen, werden die polymerisierbaren funktionellen Einheiten über eine Linkergruppe der Formeln 13 bis 18, die eine Hydroxyleinheit aufweisen, an ein organisches Molekül der Formel 1 angebunden und die daraus resultierenden Verbindungen mit sich selbst homopolymerisiert oder mit anderen geeigneten Monomeren copolymerisiert.

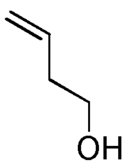 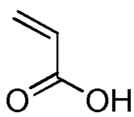 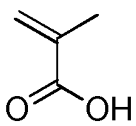 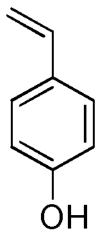 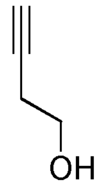 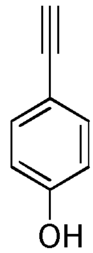

Formel 13 Formel 14 Formel 15 Formel 16 Formel 17 Formel 18

Polymere, die eine Einheit gemäß Formel 5 oder Formel 6 aufweisen, können dabei entweder ausschließlich Wiederholungseinheiten mit einer Struktur der allgemeinen Formel 5 oder 6, oder Wiederholungseinheiten mit einer anderen Struktur aufweisen. Beispiele von Wiederholungseinheiten mit anderen Strukturen weisen Einheiten auf, die sich aus entsprechenden Monomeren ergeben, die typischerweise in Copolymerisationen eingesetzt oder verwendet werden. Beispiele für derartige Wiederholungseinheiten, die sich aus Monomeren ergeben, sind Wiederholungseinheiten, die ungesättigte Einheiten wie Ethylen oder Styrol aufweisen.

Eine Ausführungsform der Erfindung betrifft organischen Moleküle, welche

- einen $\Delta E(S_1-T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweisen und/oder
- eine Emissionslebensdauer von höchstens 50 $\mu$s aufweisen.

Die Erfindung betrifft in einem Aspekt die Verwendung eines erfindungsgemäßen organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:

- organischen lichtemittierenden Dioden (OLEDs),
- lichtemittierenden elektrochemischen Zellen,
- OLED-Sensoren, insbesondere in nicht hermetisch nach außen abgeschirmten Gas- und Dampf-Sensoren,
- organischen Dioden
- organischen Solarzellen,
- organischen Transistoren,
- organischen Feldeffekttransistoren,
- organischen Lasern und
- Down-Konversions-Elementen.

Der Anteil des erfindungsgemäßen organischen Moleküls am lumineszierenden Emitter und/oder Hostmaterial und/oder Elektronentransportmaterial und/oder Lochinjektionsmaterial und/oder Lochblockiermaterial beträgt in einer Ausführungsform 1 % bis 99 % (Gew%), insbesondere beträgt der Anteil am Emitter in optischen Licht emittierenden Bauelementen, insbesondere in OLEDs, zwischen 5 % und 80 %.

Die Erfindung betrifft in einem weiteren Aspekt optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischer lichtemittierender Diode (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

Eine Ausführungsform betrifft das erfindungsgemäße optoelektronische Bauelement aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein erfindungsgemäßes organisches Molekül enthält.

In einer weiteren Ausführungsform des Bauelements wird das organische Molekül als Emissionsmaterial in einer Emissionsschicht eingesetzt, wobei sie in Kombination mit mindestens einem Hostmaterial oder insbesondere als Reinschicht eingesetzt werden kann. In einer Ausführungsform beträgt dabei der Anteil des organischen Moleküls als Emissionsmaterial in einer Emissionsschicht in optischen Licht-emittierenden Bauelementen, insbesondere in OLEDs, zwischen 5 % und 80 % (Gew%).

In einer weiteren Ausführungsform des erfindungsgemäßen Bauelements ist die ein erfindungsgemäßes organisches Molekül aufweisende lichtemittierende Schicht auf ein Substrat aufgebracht.

In einer Ausführungsform betrifft die Erfindung ein optoelektronisches Bauelement, bei dem die lichtemittierende Schicht ausschließlich ein erfindungsgemäßes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement neben dem erfindungsgemäßen organischen Molekül mindestens ein Hostmaterial auf, wobei insbesondere der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls, und wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement ein Substrat, eine Anode, eine Kathode und mindestens je eine löcherinjizierende und eine elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer weiteren Ausführungsform weist das optoelektronische Bauelement ein Substrat, eine Anode, eine Kathode und mindestens je eine löcherinjizierende und eine elektroneninjizierende Schicht, und mindestens je eine löchertransportierende und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement mindestens ein Hostmaterial aus einem Material gemäß Formel 1 auf.

In einer weiteren Ausführungsform des optoelektronischen Bauelements beinhaltet die lichtemittierende Schicht fluoreszente oder phosphoreszente Materialien, welche eine Struktur der Formel 1 aufweisen.

In einer weiteren Ausführungsform des optoelektronischen Bauelements bilden ein organisches Molekül gemäß Formel 1 und ein funktionelles Material, beispielsweise in Form eines weiteren Emitter-Materials, eines Host-Materials, oder eines weiteren organischen Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

In einer weiteren Ausführungsform des optoelektronischen Bauelements ist die Emission durch thermisch aktivierte verzögerte Fluoreszenz (TADF) charakterisiert.

In einer weiteren Ausführungsform des optoelektronischen Bauelements werden organische Moleküle gemäß Formel 1 als Ladungstransportschicht verwendet.

Die Erfindung betrifft in einem Aspekt ein lichtemittierendes Material, aufweisend ein erfindungsgemäßes organisches Molekül und ein Hostmaterial, wobei die Triplett ($T_1$)- und Singulett ($S_1$)-Energieniveaus des Hostmaterials energetisch höher liegen als die Triplett ($T_1$)- und Singulett ($S_1$)-Energieniveaus des organischen Moleküls, und wobei das organische Molekül Fluoreszenz oder thermisch aktivierte verzögerte Fluoreszenz (TADF) emittiert, und einen $\Delta E(S_1-T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweist.

Ein Aspekt der Erfindung betrifft ein Verfahren zur Herstellung eines optoelektronischen Bauelements aufweisend ein erfindungsgemäßes organisches Molekül. In einer Ausführungsform weist das Verfahren den Schritt der Verarbeitung des organischen Moleküls mittels eines Vakuumverdampfungsverfahrens oder aus einer Lösung auf.

In einer Ausführungsform weist das Verfahren das Aufbringen des organischen Moleküls auf einen Träger auf, wobei das Aufbringen insbesondere nass-chemisch, mittels kolloidaler Suspension oder mittels Sublimation erfolgt.

In einer weiteren Ausführungsform des Verfahrens wird mindestens eine Schicht

- mit einem Sublimationsverfahren beschichtet
- mit einem OVPD (Organic Vapor Phase Deposition) Verfahren beschichtet
- mit Hilfe einer Trägergassublimation beschichtet oder
- aus Lösung oder mit einem beliebigen Druckverfahren hergestellt.

Ein weiterer Aspekt der Beschreibung betrifft ein Verfahren zur Veränderung der Emissions- und/oder Absorptionseigenschaften eines elektronischen Bauelements, wobei ein erfindungsgemäßes organisches Molekül in ein Matrixmaterial zur Leitung von Elektronen oder Löchern in einem optoelektronischen Bauelement eingebracht wird.

## Beispiele

### Berechnungen nach der Dichtefunktionaltheorie

### Variante 1 (BP86)

Für die DFT-Rechnungen (Dichtefunktionaltheorie) wurde das BP86-Funktional (Becke, A. D. Phys. Rev. A1988, 38, 3098-3100; Perdew, J. P. Phys. Rev. B1986, 33, 8822-8827) und def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) verwendet. Zur numerischen Integration kam das m4-Grid zum Einsatz und die resolution-of-identity-Näherung (RI) (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) wurde in allen Rechnungen verwendet. Die DFT-Rechnungen wurden mit dem Turbomole-Programmpaket (Version 6.5) (TURBOMOLE V6.4 2012, University of Karlsruhe/Forschungszentrum Karlsruhe GmbH, 1989-2007, TURBOMOLE GmbH, since 2007; http://www.turbomole.com) durchgeführt.

### Variante 2 (TD-B3LYP)

Für die Optimierung der Molekülstrukturen wurde das BP86-Funktional (Becke, A. D. Phys. Rev. A1988, 38, 3098-3100; Perdew, J. P. Phys. Rev. B1986, 33, 8822-8827) verwendet, wobei die resolution-of-identity-Näherung (RI) (Sierka, M.; Hogekamp, A.; Ahlrichs, R. J. Chem. Phys. 2003, 118, 9136-9148; Becke, A.D. , J.Chem.Phys. 98 (1993) 5648-5652; Lee, C; Yang, W; Parr, R.G. Phys. Rev. B 37 (1988) 785-789) zum Einsatz kam. Anregungsenergien wurden bei der mit BP86 optimierten Struktur mit der Time-Dependent DFT-Methode (TD-DFT) unter Verwendung des B3LYP-Funktionals (Becke, A.D. , J.Chem.Phys. 98 (1993) 5648-5652; Lee, C; Yang, W; Parr, R.G. Phys. Rev. B 37 (1988) 785-789; Vosko, S. H.; Wilk, L.; Nusair, M. Can. J. Phys. 58 (1980) 1200-1211; Stephens, P. J.; Devlin, F. J.; Chabalowski, C. F. ; Frisch, M. J. J.Phys.Chem. 98 (1994) 11623-11627) berechnet. In allen Rechnungen wurden def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) und ein m4 -Grid zur numerischen Integration verwendet. Alle DFT-Rechnungen wurden mit dem Turbomole-Programmpaket (Version 6.5) (TURBOMOLE V6.4 2012, University of Karlsruhe und Forschungszentrum Karlsruhe GmbH, 1989-2007, TURBOMOLE GmbH, since 2007; http://www. turbomole.com) durchgeführt.

**Synthesen**

*Synthese fluorierter Bipyridine als Vorstufen*

Die Synthese erfolgt analog der Herstellung der Vorstufe A.

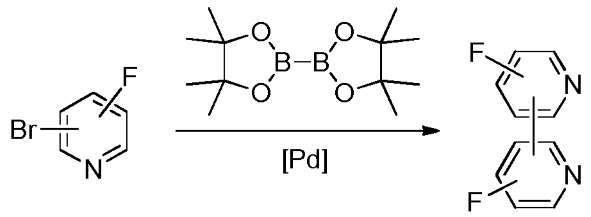


*Nucleophile aromatische Substitution mit Arylaminen und -Derivaten*

Die Synthese erfolgt analog der Herstellung der Verbindungen A bis D.

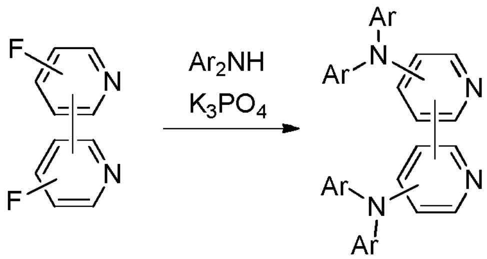


**Molekülbeispiele** (Molekülstrukturen s. Tabelle 3)

*Vorstufe A*

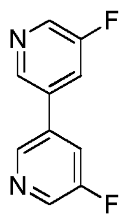

In einem Zweihalskolben (500 mL) mit Rückflusskühler und Septum wurden 3-Brom-5-fluorpyridin (56,8 mmol, 1 Äquiv.), Bis(pinacolato)dibor (28,4 mmol, 0.5 Äquiv.), $Pd_2(dba)_3$ (0,28 mmol, 0,005 Äquiv.), 2-Dicyclohexylphosphino-2',6'-dimethoxy-1,1'-biphenyl (1.14 mmol, 0,02 Äquiv.) und $K_3PO_4$ (170 mmol, 3 Äquiv.) unter Stickstoffatmosphäre vorgelegt. Es wurden abs. Dioxan (150 mL) und deionisiertes Wasser (15 mL) zugegeben und die resultierende Suspension im Stickstoffstrom entgast. Das Gemisch wurde während 17 h auf 100 °C erhitzt. Nach Abkühlen auf RT wurde das Gemisch filtriert, der Rückstand mit Dioxan gewaschen und verworfen. Das Filtrat wurde unter vermindertem Druck vom Lösungsmittel befreit. Der Rückstand wurde aus Toluol umkristallisiert und die Mutterlauge heiß filtriert. So wurde Vorstufe A in einer Ausbeute von 77% (21,8 mmol) erhalten.

*Verbindung A*

In einem Zweihalskolben (100 mL) mit Rückflusskühler und Septum wurden Vorstufe A (1,30 mmol, 1 Äquiv.), 3,6-Bis(diphenylamino)-9H-carbazol (2,59 mmol, 2 Äquiv.) und $K_3PO_4$ (5,20 mmol, 4 Äquiv.) unter Stickstoffatmosphäre vorgelegt. Nach Zugabe von abs. DMSO (20 mL) wurde das Gemisch 15 h auf 110 °C erhitzt. Nach Abkühlen auf RT wurde das Reaktionsgemisch in 400 mL Kochsalzlösung geschüttet. Dichlormethan (150 mL) wurde zugegeben, die Phasen getrennt und die wässrige Phase nochmals mit Dichlormethan (150 mL) extrahiert. Die vereinigten organischen

Phasen wurden mit Kochsalzlösung gewaschen (200 mL) und anschließend über $MgSO_4$ getrocknet. Unter vermindertem Druck wurde das Lösungsmittel entfernt und der Rückstand per MPLC gereinigt. Die Ausbeute an Verbindung A betrug 25% (0,32 mmol).

*Verbindung B*

In einem Zweihalskolben (100 mL) mit Rückflusskühler und Septum wurden Vorstufe A (3,12 mmol, 1 Äquiv.), 3-Diphenylamino-9H-carbazol (6,24 mmol, 2 Äquiv.) und $K_3PO_4$ (12,5 mmol, 4 Äquiv.) unter Stickstoffatmosphäre vorgelegt. Nach Zugabe von abs. DMSO (20 mL) wurde das Gemisch 14 h auf 140 °C erhitzt. Nach Abkühlen auf RT wurde das Reaktionsgemisch in 400 mL Kochsalzlösung geschüttet. Dichlormethan (150 mL) wurde zugegeben, die Phasen getrennt und die wässrige Phase nochmals mit Dichlormethan (150 mL) extrahiert. Die vereinigten organischen Phasen wurden mit Kochsalzlösung gewaschen (200 mL) und anschließend über $MgSO_4$ getrocknet. Unter vermindertem Druck wurde das Lösungsmittel entfernt und der Rückstand per MPLC gereinigt. Die Ausbeute an Verbindung B betrug 29% (0,92 mmol).

*Verbindung C*

In einem Zweihalskolben (100 mL) mit Rückflusskühler und Septum wurden Vorstufe A (3,64 mmol, 1 Äquiv.), 3,6-Diphenyl-9H-carbazol (7,28 mmol, 2 Äquiv.) und $K_3PO_4$ (14,6 mmol, 4 Äquiv.) unter Stickstoffatmosphäre vorgelegt. Nach Zugabe von abs. DMSO (20 mL) wurde das Gemisch 15 h auf 140 °C erhitzt. Nach Abkühlen auf RT wurde das Reaktionsgemisch in 400 mL Kochsalzlösung geschüttet. Dichlormethan (150 mL) wurde zugegeben, die Phasen getrennt und die wässrige Phase nochmals mit Dichlormethan (150 mL) extrahiert. Die vereinigten organischen Phasen wurden mit Kochsalzlösung gewaschen (200 mL) und anschließend über $MgSO_4$ getrocknet. Unter vermindertem Druck wurde das Lösungsmittel entfernt und der Rückstand per MPLC gereinigt. Die Ausbeute an Verbindung C betrug 35% (1,28 mmol).

*Verbindung D*

In einem Zweihalskolben (100 mL) mit Rückflusskühler und Septum wurden Vorstufe A (4,68 mmol, 1 Äquiv.), 3,6-Dimethyl-9H-carbazol (9,36 mmol, 2 Äquiv.) und $K_3PO_4$ (18,7 mmol, 4 Äquiv.) unter Stickstoffatmosphäre vorgelegt. Nach Zugabe von abs. DMSO (20 mL) wurde das Gemisch 15 h auf 140 °C erhitzt. Nach Abkühlen auf RT wurde das Reaktionsgemisch in 400 mL Kochsalzlösung geschüttet. Dichlormethan (150 mL) wurde zugegeben, die Phasen getrennt und die wässrige Phase nochmals mit Dichlormethan (150 mL) extrahiert. Die vereinigten organischen Phasen wurden mit Kochsalzlösung gewaschen (200 mL) und anschließend über $MgSO_4$ getrocknet. Unter vermindertem Druck wurde das Lösungsmittel entfernt und der Rückstand per MPLC gereinigt. Die Ausbeute an Verbindung D betrug 16% (0,74 mmol).

**Photophysikalische Messungen**

*Vorbehandlung von optischen Gläsern*

Alle Gläser (Küvetten und Substrate aus Quarzglas, Durchmesser: 1cm) wurden nach jeder Benutzung gereinigt: Je dreimaliges Spülen mit Dichlormethan, Aceton, Ethanol, demineralisiertem Wasser, Einlegen in 5% Hellmanex-Lösung für 24h, gründliches Ausspülen mit demineralisiertem Wasser. Zum Trocknen wurden die optischen Gläser mit Stickstoff abgeblasen.

*Probenvorbereitung, Film: Spin-Coating* (Gerät: Spin150, SPS euro.)

Die Probenkonzentration entsprach 10mg/ml, angesetzt in Toluol oder Chlorbenzol.
Die Konzentration des optisch neutralen Hostpolymers PMMA (Polymethylmethacrylat) entsprach 10 mg/mL, angesetzt in Toluol oder Chlorbenzol.
Die Filmpräparation erfolgte aus einem Gemisch der PMMA-Lösung und der Probenlösung im volumetrischen Verhältnis 90:10.

Programm: 1) 3 s bei 400 U/min; 2) 20 Sek. bei 1000 U/min bei 1000 Upm/ s. 3) 10s bei 4000 U/min bei 1000 Upm/ s. Die Filme wurden nach dem Beschichten für 1 min bei 70 °C an Luft auf einer Präzisionsheizplatte von LHG getrocknet.

### *Absorptionsspektroskopie*

Lösungen: UV-VIS-Spektren wurden auf einem Gerät der Firma Thermo Scientific, Modell Evolution 201 aufgenommen. (Siehe Probenvorbereitung: Lösungen)
Film: UV-VIS-Spektren wurden auf einem Gerät der Firma Thermo Scientific, Modell Evolution 201 aufgenommen. (Siehe Probenvorbereitung, Film: Spin-Coating)

### *Photolumineszenzspektroskopie und TCSPC*

Steady-state Emissionsspektroskopie wurde mit einem Fluoreszenzspektrometer der Firma Horiba Scientific, Modell FluoroMax-4 durchgeführt, ausgestattet mit einer 150 W Xenon-Arc Lampe, Anregungs- und Emissionsmonochromatoren und einer Hamamatsu R928 Photomultiplier-Röhre, sowie einer TCSPC-Option. Emissions- und Anregungsspektren wurden korrigiert durch Standardkorrekturkurven.

Die Emissionsabklingzeiten wurden ebenfalls auf diesem System gemessen unter Verwendung der TCSPC-Methode mit dem FM-2013 Zubehör und einem TCSPC-Hub von Horiba Yvon Jobin. Anregungsquellen: NanoLED 370 (Wellenlänge: 371 nm, Pulsdauer: 1.1 ns), NanoLED 290 (Wellenlänge: 294 nm, Pulsdauer: <1 ns), SpectraLED 310 (Wellenlänge: 314nm), SpectraLED 355 (Wellenlänge: 355nm).

Die Auswertung (exponentielles Fitten) erfolgte mit dem Softwarepaket DataStation und der DAS 6 Auswertungssoftware. Der Fit wurde über die Chi-Quadrat-Methode angegeben

$$c^2 = \sum_{k=1}^{i} \frac{(e_i - o_i)^2}{e_i}$$

mit $e_i$: Durch den Fit vorhergesagte Größe und $o_i$: Gemessenen Größe.

### *Quanteneffizienzbestimmung*

Die Messung der Photolumineszenzquantenausbeute (PLQY) erfolgte mittels eines *Absolute PL Quantum Yield Measurement* C9920-03G-Systems der Firma *Hamamatsu Photonics.* Dieses besteht aus einer 150 W Xenon-Gasentladungslampe, automatisch justierbaren Czerny-Turner Monochromatoren (250 - 950 nm) und einer Ulbricht-Kugel mit hochreflektierender Spektralon-Beschichtung (einem Teflon-Derivat), die über ein Glasfaserkabel mit einem PMA-12 Vielkanaldetektor mit BT- *(back thinned-)* CCD-Chip mit 1024 x 122 Pixeln (Größe 24 x 24 μm) verbunden ist. Die Auswertung der Quanteneffizienz und der CIE-Koordinaten erfolgte mit Hilfe der Software U6039-05 Version 3.6.0 Für G9920-OXG (PMA-12). Das Emissionsmaximum wird in nm, die Quantenausbeute Φ in % und die CIE-Farbkoordinaten als x,y-Werte angegeben.

PLQY wurde für Polymerfilme, Lösungen und Pulverproben nach folgendem Protokoll bestimmt:

1) Durchführung der Qualitätssicherung: Als Referenzmaterial dient Anthracene in Ethanol mit bekannter Konzentration.
2) Ermitteln der Anregungswellenlänge: Es wurde zuerst das Absorbtionsmaximum des organischen Moleküls bestimmt und mit diesem angeregt.
3) Durchführung der Probenmessung: Es wurde von entgasten Lösungen und Filmen unter Stickstoff-Atmosphäre die absolute Quantenausbeute bestimmt. Die Berechnung erfolgte systemintern nach folgender Gleichung:

$$\Phi_{PL} = \frac{n_{photon}, emittiert}{n_{photon}, absorbiert} = \frac{\int \frac{\lambda}{hc}\left[Int_{emittiert}^{Probe}(\lambda) - Int_{absorbiert}^{Probe}(\lambda)\right]d\lambda}{\int \frac{\lambda}{hc}\left[Int_{emittiert}^{Referenz}(\lambda) - Int_{absorbiert}^{Referenz}(\lambda)\right]d\lambda}$$

mit der Photonenzahl $n_{photon}$ und der Intensität Int.

### Photophysikalische Parameter

Sämtliche hier aufgeführten Messungen wurden nach den oben beschriebenen Prozeduren durchgeführt. In Tabelle 4 bedeuten $\lambda_{EX}$ Anregungswellenlänge, $\lambda_{EM}$ Emissionswellenlänge, PLQY Photolumineszenzquantenausbeute.

**Tabelle 3:** Photophysikalische Parameter ausgesuchter, nicht-efindungsgemäßer Verbindungen

| Verbindung | Struktur | $\lambda_{EX}$ [nm] | $\lambda_{EM}$ [nm] |
|---|---|---|---|
| A | 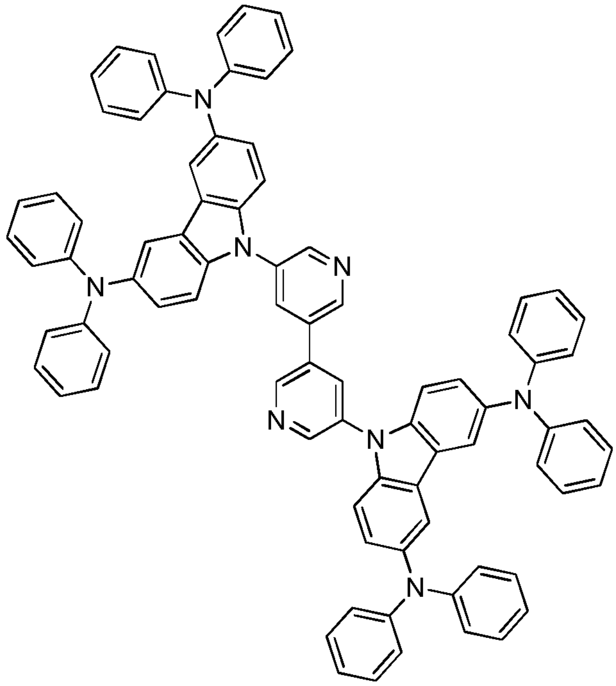 | 297 | 495 |
| B | 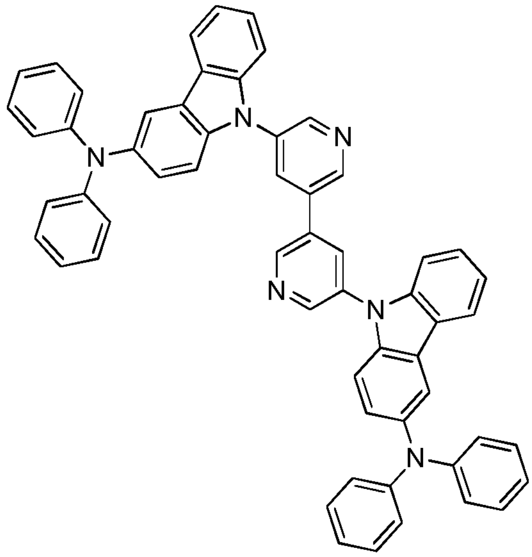 | 300 | 474 |

(fortgesetzt)

| Verbindung | Struktur | $\lambda_{EX}$ [nm] | $\lambda_{EM}$ [nm] |
|---|---|---|---|
| C | 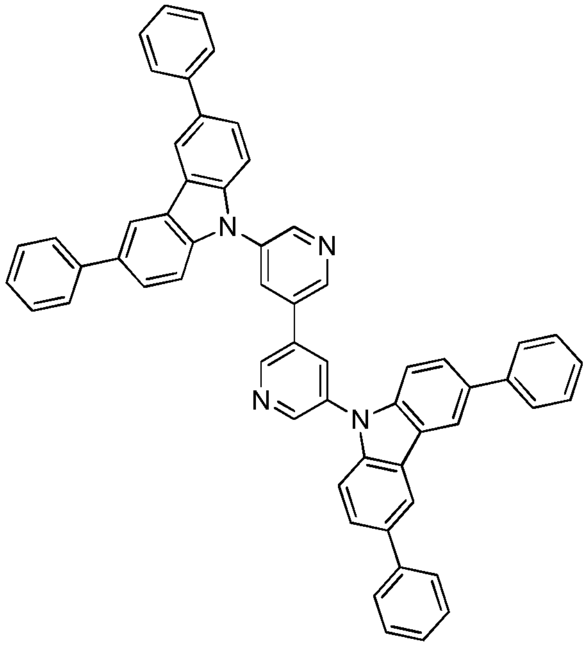 | 297 | 400 |
| D | 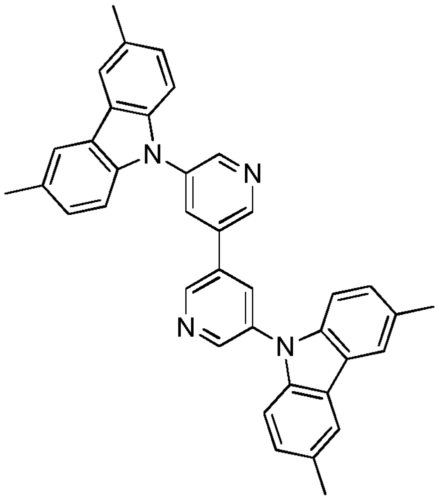 | 297 | 408 |

Es zeigen

Figur 1: Schematische Darstellung des Aufbaus einer organischen lichtemittierenden Diode (OLED).

Figur 2: Schematische Darstellung des Energieniveaudiagrammes (relative Energie in eV) eines erfindungsgemäßen Emittermoleküls (Lichtemission resultiert aus dem Übergang LUMO (AF1/Pyridineinheit) hin zu HOMO (AF2)).

## Patentansprüche

**1.** Organisches Molekül, aufweisend eine Struktur der Formel 3b

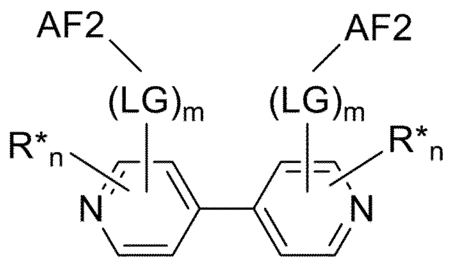

**Formel 3b**

wobei gilt:

m ist 0 oder 1;
n ist 1, 2 oder 3;
LG ist eine divalente Linkergruppe, ausgewählt aus der Gruppe bestehend aus:

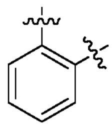 , 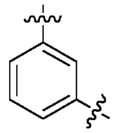 , 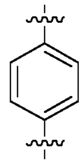 ;

oder LG ist eine Element-Element-Einfachbindung;
wobei AF2 eine Struktur der Formel 2 aufweist:

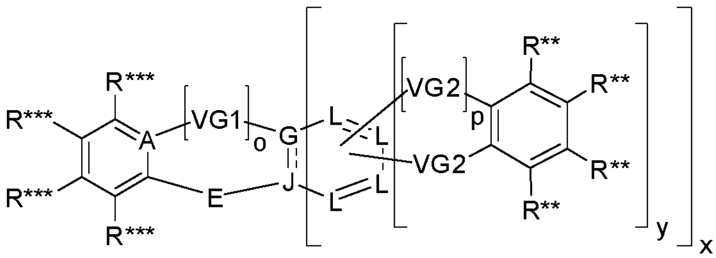

**Formel 2**

wobei gilt:

x ist 1;
y ist 0;
o ist 0 oder 1;
A ist CR*** wenn o = 0, ansonsten C;
VG1 ist eine verbrückende Gruppe und ist ausgewählt aus der Gruppe bestehend aus

- NR**, CR**$_2$, O, S, eine C-C-Einfachbindung, BR**, AsR**, SiR**$_2$, GeR**$_2$,

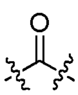 , 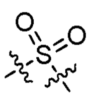 , 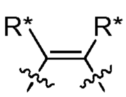 , 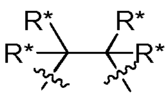 , 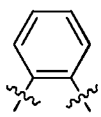 , 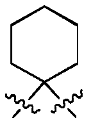 , 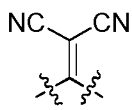 , 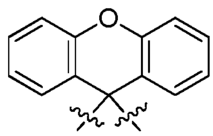 ,

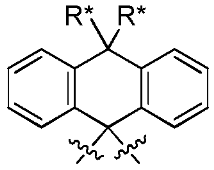, 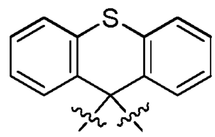 und 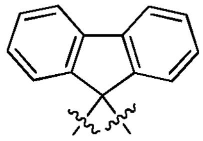;

E ist NR**,

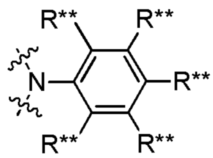,

O oder S;

G ist C wenn o = 1; G ist CR** wenn o = 0;

J ist C;

L ist CR***;

R*** ist R** oder ist ausgewählt aus den folgenden Einheiten, wobei maximal zwei der Reste R*** gleichzeitig gleich einer der folgenden Einheiten sind:

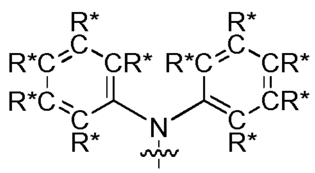, 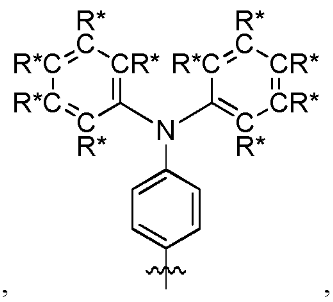, 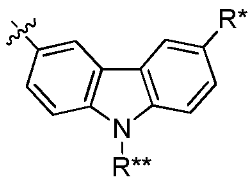, 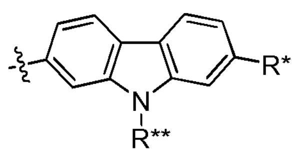,

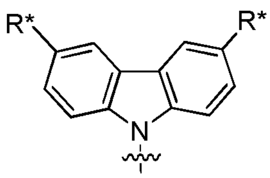, 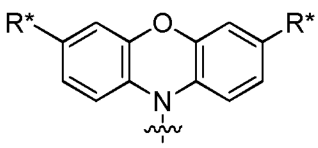, 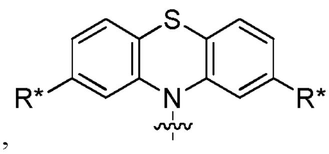,

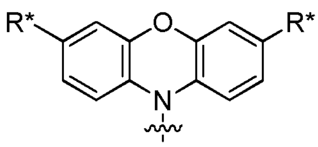, 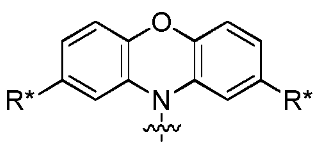;

R** ist bei jedem Auftreten unabhängig voneinander ein Rest R* und/oder markiert die Anknüpfungsstelle an die Linkergruppe LG oder bei m = 0 an die Pyridineinheit der Formel 3b;

R* ist bei jedem Auftreten unabhängig voneinander ausgewählt aus der Gruppe bestehend aus H, Deuterium, Phenyl, Naphthyl, $N(R^2)_2$, -SCN, $-CF_3$, $-NO_2$, $Si(R^4)_3$, eine lineare Alkyl-, Alkoxy- oder Thioalkoxygruppe mit 1 bis 40 C-Atomen, die jeweils mit einem oder mehreren Resten $R^9$ substituiert sein kann, wobei eine benachbarte $CH_2$-Gruppe durch $-Si(R^4)_2-$, - $Ge(R^4)_2-$, $-Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch

einen oder mehrere Reste $R^9$ substituiert sein kann, oder eine Kombination dieser Systeme;

$R^2$ ist bei jedem Auftreten unabhängig voneinander ausgewählt aus der Gruppe bestehend aus H, Deuterium, Phenyl, Naphthyl, $CF_3$, $Si(R^4)_3$, eine lineare Alkyl-, Alkoxy- oder Thioalkoxygruppe mit 1 bis 40 C-Atomen die jeweils mit einem oder mehreren Resten $R^9$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme;

$R^4$ ist bei jedem Auftreten unabhängig voneinander ausgewählt aus der Gruppe bestehend aus H, Deuterium, Phenyl, Naphthyl, $N(R^2)_2$, $CF_3$, OH, eine lineare Alkyl-, Alkoxy- oder Thioalkoxygruppe mit 1 bis 40 C-Atomen, die jeweils mit einem oder mehreren Resten $R^9$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können;

$R^9$ ist bei jedem Auftreten unabhängig voneinander ausgewählt aus der Gruppe bestehend aus H, Deuterium, Phenyl, Naphthyl, $N(R^2)_2$, $CF_3$, $NO_2$, OH, $Si(R^4)_3$, eine lineare Alkyl-, Alkoxy- oder Thioalkoxygruppe mit 1 bis 40 C-Atomen, die jeweils mit einem oder mehreren Resten $R^8$ substituiert sein kann, wobei eine benachbarte $CH_2$-Gruppe durch $-Si(R^4)_2-$, $-Ge(R^4)_2-$, - $Sn(R^4)_2$, $-NR^2-$, -O-, oder -S- ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme.

**2.** Organisches Molekül nach Anspruch 1, wobei AF2 eine Struktur der Formel 4 aufweist:

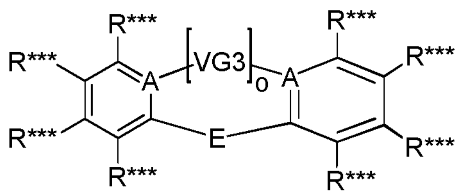

**Formel 4**

wobei gilt:

o ist 0 oder 1;

A ist CR*** wenn o = 0, ansonsten C;

VG3 = verbrückende Gruppe ist NR**, $CR^{**}_2$, O, S oder eine C-C-Einfachbindung,

E ist NR** oder

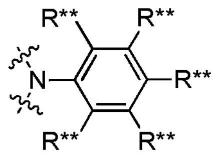 ;

R*** ist R** oder ist ausgewählt aus den folgenden Einheiten, wobei maximal zwei der Reste R*** gleichzeitig gleich einer der folgenden Einheiten sind:

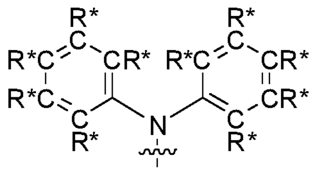 , 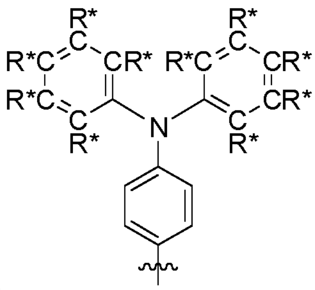 , 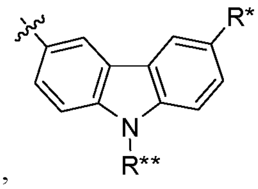 , 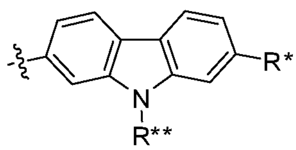 ,

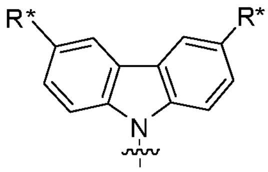 , 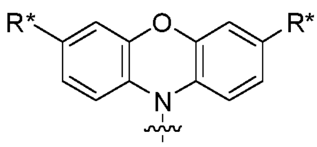 , 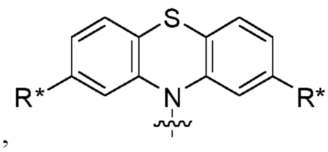 ,

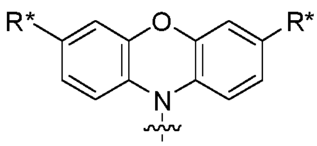 , 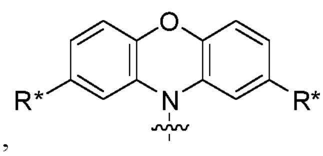 ;

und wobei für R** und R* wie in Anspruch 1 definiert sind.

3. Organisches Molekül nach Anspruch 1 oder 2, wobei m gleich 0 ist.

4. Organisches Molekül nach Anspruch 1, aufweisend eine der Strukturen 3.1, 3.2, 3.5 oder 3.6, wobei optional sämtliche $C_{sp2}$-H-Gruppen auch $C_{sp2}$-R* -Gruppen sein können und im Übrigen die unter Anspruch 1 angegebenen Definitionen gelten:

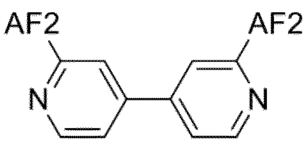

3.1

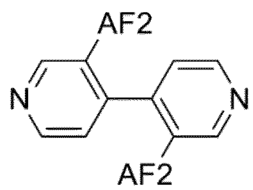

3.2

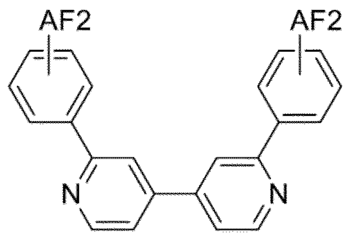

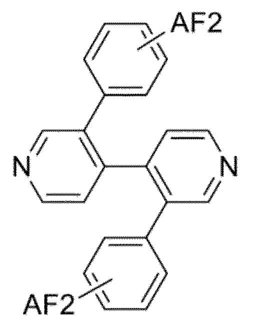

3.5 3.6

**5.** Organisches Molekül nach Anspruch 1 bis 4, wobei das organische Molekül an mindestens einer chemisch substituierbaren Position mindestens einen Rest R, insbesondere zur Steigerung der Löslichkeit aufweist, wobei gilt:
R ist bei jedem Auftreten unabhängig voneinander ausgewählt aus der Gruppe bestehend aus H, Deuterium, Phenyl, Naphthyl, F, Cl, Br, I, $N(R^2)_2$, -SCN, $-CF_3$, $-NO_2$, -OH, $Si(R^4)_3$, eine lineare Alkyl-, Alkoxy- oder Thioalkoxygruppe mit 1 bis 40 C-Atomen, die jeweils mit einem oder mehreren Resten $R^9$ substituiert sein kann, wobei eine benachbarte $CH_2$-Gruppe durch $-Si(R^4)_2-$, $-Ge(R^4)_2-$, $-Sn(R^4)_2$, $-NR^2-$, -O-, oder -S-ersetzt sein können und wobei ein oder mehrere H-Atome durch Deuterium, F, Cl, Br, I, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; wobei $R^2$ bis $R^9$ definiert sind wie in Anspruch 1.

**6.** Verwendung eines organischen Moleküls nach Anspruch 1 bis 5 als lumineszierender Emitter und/oder als Hostmaterial und/oder als Elektronentransportmaterial und/oder als Lochinjektionsmaterial und/oder als Lochblockiermaterial in einem optoelektronischen Bauelement.

**7.** Verwendung nach Anspruch 6, wobei das optoelektronische Bauelement ausgewählt ist aus der Gruppe bestehend aus:

- organischen lichtemittierenden Dioden (OLEDs),
- Licht-emittierenden elektrochemischen Zellen,
- OLED-Sensoren, insbesondere in nicht hermetisch nach außen abgeschirmten Gas- und Dampf-Sensoren,
- organischen Dioden
- organischen Solarzellen,
- organischer Transistor
- organischen Feldeffekttransistoren,
- organischen Lasern und
- Down-Konversions-Elementen.

**8.** Verwendung nach Anspruch 6 oder 7, wobei der Anteil des organischen Moleküls an dem Emitter 1 % bis 99 % beträgt.

**9.** Verwendung nach Anspruch 6, 7 oder 8, wobei die Konzentration des organischen Moleküls als Emitter in optischen lichtemittierenden Bauelementen, insbesondere in OLEDs, zwischen 5 % und 80 % beträgt.

**10.** Optoelektronisches Bauelement, aufweisend ein organisches Molekül nach Anspruch 1 bis 5, insbesondere ausgeformt als ein Bauelement ausgewählt aus der Gruppe bestehend aus organischer lichtemittierender Diode (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

**11.** Optoelektronisches Bauelement nach Anspruch 10, aufweisend

- ein Substrat,
- eine Anode und
- eine Kathode, wobei die Anode und die Kathode auf das Substrat aufgebracht sind, und
- mindestens eine lichtemittierende Schicht, die zwischen Anode und Kathode angeordnet ist und die ein organisches Molekül nach Anspruch 1 bis 5 enthält.

**12.** Optoelektronisches Bauelement nach Anspruch 11, in dem die lichtemittierende Schicht mindestens ein Hostmaterial aufweist, wobei der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls nach Anspruch 1 bis 5.

**13.** Optoelektronisches Bauelement nach Anspruch 10 bis 12, aufweisend mindestens ein Hostmaterial bestehend aus einem Material gemäß Anspruch 1 bis 5.

**14.** Optoelektronisches Bauelement nach Anspruch 10 bis 13, wobei die lichtemittierende Schicht fluoreszente oder phosphoreszente Materialien aufweist und wobei es sich bei den Materialien der lichtemittierenden Schicht um organische Moleküle nach Anspruch 1 bis 5 handelt.

**15.** Optoelektronisches Bauelement nach Anspruch 14, in dem ein organisches Molekül gemäß Anspruch 1 bis 5 zusammen mit einem funktionellen Material einen Exciplex bilden.

**16.** Optoelektronisches Bauelement nach Anspruch 10 bis 15, in dem ein organisches Molekül nach Anspruch 1 bis 5 als Ladungstransportschicht verwendet wird.

**17.** Verfahren zur Herstellung eines optoelektronischen Bauelements, wobei ein organisches Molekül nach Anspruch 1 bis 5 verwendet wird.

**18.** Verfahren nach Anspruch 17, wobei die Verarbeitung des organischen Moleküls mittels eines Vakuumverdampfungsverfahrens oder aus einer Lösung erfolgt.

**Claims**

**1.** An organic molecule comprising a structure of formula 3b

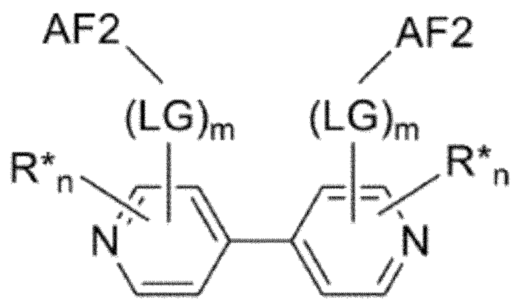

**Formula 3b**

wherein:

m is 0 or 1;
n is 1, 2 or 3;
LG is a divalent linker group, selected from the group consisting of:

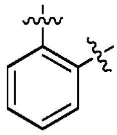 , 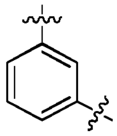 , 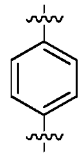 ;

or LG is an element-element single bond;
wherein AF2 comprises a structure of formula 2:

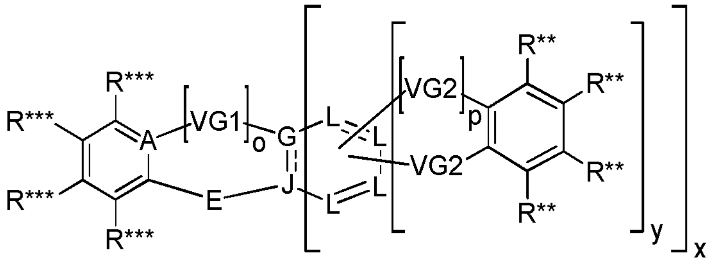

**Formula 2**

wherein:

x is 1;
y is 0;
o is 0 or 1;
A is CR*** when o = 0, otherwise C;
VG1 is a bridging group and is selected from the group consisting of

- NR**, $CR**_2$, O, S, a C-C single bond, BR**, AsR**, $SiR**_2$, $GeR**_2$,

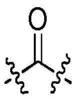 , 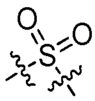 , 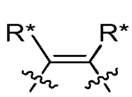 , 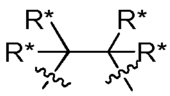 , 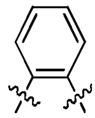 , 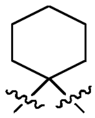 , 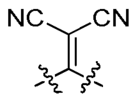 , 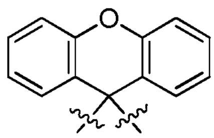 ,

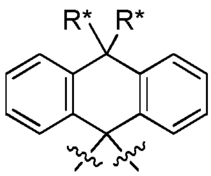 , 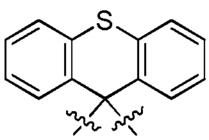 and 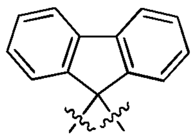 ;

E is NR**,

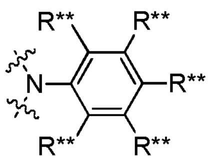 ,

O or S;
G is C when o = 1; G is CR** when o = 0;
J is C;
L is CR***;
R*** is R** or is selected from the following units, wherein a maximum of two of the radicals R*** are simultaneously one of the following units:

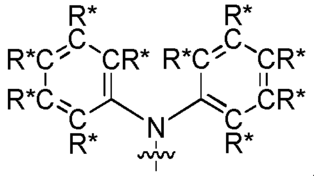, 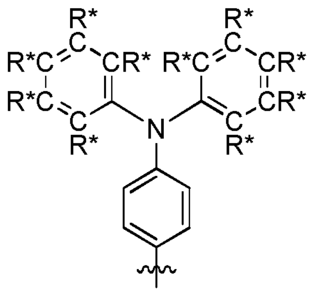, 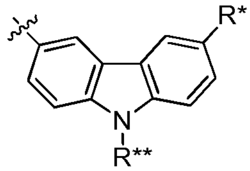, 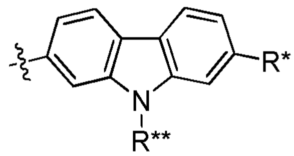,

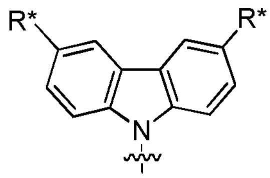, 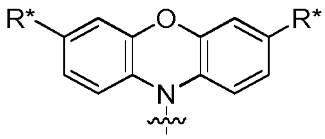, 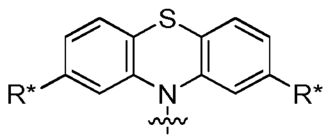,

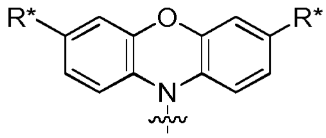, 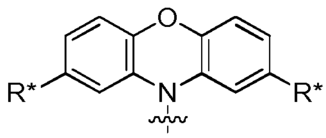;

R** at each occurrence independently of one another is a radical R* and/or marks the linking site to the linker group LG or in case m = 0, to the pyridine unit of formula 1;

R* at each occurrence independently of one another is selected from the group consisting of H, deuterium, phenyl, naphthyl, $N(R^2)_2$, -SCN, $-CF_3$, $-NO_2$, $Si(R^4)_3$, a linear alkyl, alkoxy or thioalkoxy group with 1 to 40 C atoms, each of which may be substituted with one or more radicals $R^9$, wherein an adjacent $CH_2$ group may be replaced by $-Si(R^4)_2-$, $-Ge(R^4)_2-$, $-Sn(R^4)_2$, $-NR^2-$, -O-, or -S- and wherein one or more H atoms may be replaced by deuterium, F, Cl, Br, I, $CF_3$ or $NO_2$, or an aromatic or heteroaromatic ring system with 5 to 60 aromatic ring atoms, which in each case may be substituted with one or more radicals $R^2$, or an aryloxy or heteroaryloxy group with 5 to 60 aromatic ring atoms, which with one or more radicals $R^9$, or a diarylamino group, diheteroarylamino group or arylheteroarylamino group with 10 to 40 aromatic ring atoms, which with one or more radicals $R^9$, or a combination of these systems;

$R^2$ at each occurrence independently of one another is selected from the group consisting of H, deuterium, phenyl, naphthyl, $CF_3$, $Si(R^4)_3$, a linear alkyl, alkoxy or thioalkoxy group with 1 to 40 C atoms, each of which may be substituted with one or more radicals $R^9$, wherein an adjacent $CH_2$ group may be replaced by a $-Si(R^4)_2-$, $-Ge(R^4)_2-$, $-Sn(R^4)_2$, $-NR^2-$, -O-, or -S- and wherein one or more H atoms may be replaced by deuterium, F, Cl, Br, I, $CF_3$ or $NO_2$, or an aromatic or heteroaromatic ring system with 5 to 60 aromatic ring atoms, which in each case may be substituted with one or more radicals $R^9$, or an aryloxy or heteroaryloxy group with 5 to 60 aromatic ring atoms, which may be substituted with one or more radicals $R^9$, or a diarylamino group, diheteroarylamino group or arylheteroarylamino group with 10 to 40 aromatic ring atoms, which with one or more radicals $R^9$, or a combination of these systems;

$R^4$ at each occurrence independently of one another is selected from the group consisting of H, deuterium, phenyl, naphthyl, $N(R^2)_2$, $CF_3$, OH, a linear alkyl, alkoxy or thioalkoxy group with 1 to 40 C atoms, each of which may be substituted with one or more radicals $R^9$, wherein an adjacent $CH_2$ group may be replaced by $-Si(R^4)_2-$, $-Ge(R^4)_2-$, $-Sn(R^4)_2$, $-NR^2-$, -O-, or -S- and wherein one or more H atoms may be replaced by deuterium, F, Cl, Br, I, $CF_3$ or $NO_2$, or an aromatic or heteroaromatic ring system with 5 to 60 aromatic ring atoms, which in each case may be substituted with one or more radicals $R^8$, or an aryloxy or heteroaryloxy group with 5 to 60 aromatic ring atoms, which may be substituted with one or more radicals $R^9$, or a diarylamino group, diheteroarylamino group or arylheteroarylamino group with 10 to 40 aromatic ring atoms, which may be substituted with one or more radicals $R^9$, or a combination of these systems;

$R^8$ at each occurrence independently of one another is selected from the group consisting of H, deuterium, phenyl, naphthyl, F, $CF_3$ or an aliphatic, aromatic and/or heteroaromatic hydrocarbon radical with 1 to 20 C

atoms, in which also one or more H atoms may be replaced by F or $CF_3$;

$R^9$ at each occurrence independently of one another is selected from the group consisting of H, deuterium, phenyl, naphthyl, $N(R^2)_2$, $CF_3$, $NO_2$, OH, $Si(R^4)_3$, a linear alkyl, alkoxy or thioalkoxy group with 1 to 40 C atoms, each of which may be substituted with one or more radicals $R^8$, wherein an adjacent $CH_2$ group may be replaced by $-Si(R^4)_2-$, $-Ge(R^4)_2-$, $-Sn(R^4)_2$, $-NR^2-$, -O-, or -S- and wherein one or more H atoms may be replaced by deuterium, F, Cl, Br, I, $CF_3$ or $NO_2$, or an aromatic or heteroaromatic ring system with 5 to 60 aromatic ring atoms, which in each case may be substituted with one or more radicals $R^8$, or an aryloxy or heteroaryloxy group with 5 to 60 aromatic ring atoms, which may be substituted with one or more radicals $R^3$, or a diarylamino group, diheteroarylamino group or arylheteroarylamino group with 10 to 40 aromatic ring atoms, which may be substituted with one or more radicals $R^8$, or a combination of these systems.

**2.** The organic molecule according to claim 1, wherein AF2 comprises a structure of formula 4:

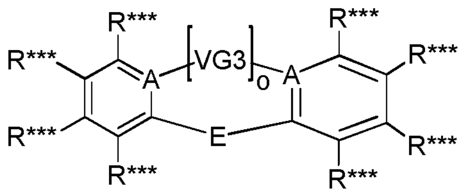

**Formula 4**

wherein:

o is 0 or 1;
A is CR*** when o = 0, otherwise C;
VG3 = bridging group is NR**, $CR**_2$, O, S or a C-C single bond,
E is NR** or

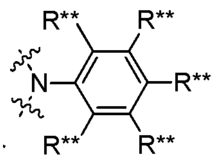

;

R*** is R** or is selected from the following units, wherein a maximum of two of the radicals R*** at the same time are one of the following units:

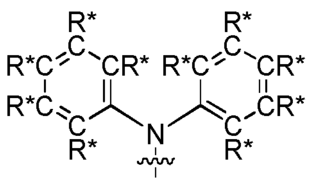

,

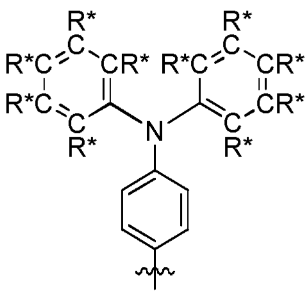

,

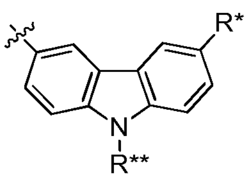

,

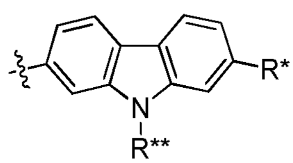

,

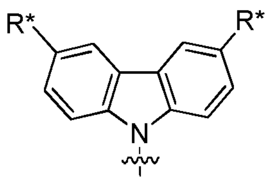

,

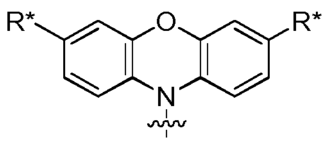

,

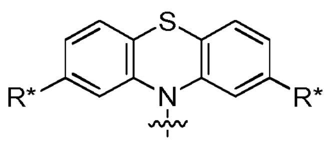

,

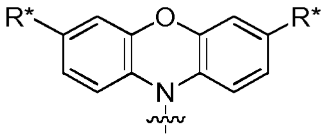

,

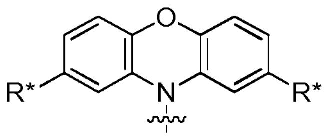

;

and wherein R** and R* are defined as in claim 1.

**3.** The organic molecule according to claim 1 or 2, wherein m is 0.

**4.** The organic molecule according to claim 1, comprising one of the structures 3.1, 3.2, 3.5, or 3.6, wherein optionally all $C_{sp2}$-H groups may also be $C_{sp2}$-R* groups and otherwise the definitions given in claim 1 apply:

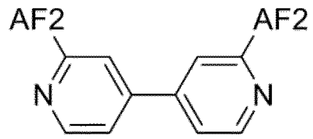

3.1

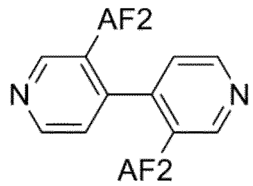

3.2

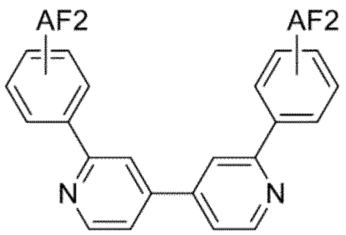

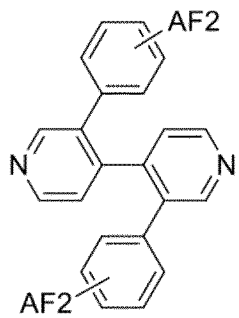

**5.** The organic molecule according to claim 1 to 4, wherein the organic molecule at at least one chemically substitutable position comprises at least one radical R, particularly for increasing the solubility, wherein:
R at each occurrence independently of one another is selected from the group consisting of H, deuterium, phenyl, naphthyl, F, Cl, Br, I, $N(R^2)_2$, -SCN, $-CF_3$, $-NO_2$, -OH, $Si(R^4)_3$, a linear alkyl, alkoxy or thioalkoxy group with 1 to 40 C atoms or a linear alkenyl, each of which may be substituted with one or more radicals $R^9$, wherein an adjacent $CH_2$ group may be replaced by $-Si(R^4)_2-$, $-Ge(R^4)_2-$, $-Sn(R^4)_2$, $-NR^2-$, -O-, or-S- and wherein one or more H atoms may be replaced by deuterium, F, Cl, Br, I, $CF_3$ or $NO_2$, or an aromatic or heteroaromatic ring system with 5 to 60 aromatic ring atoms, which in each case may be substituted with one or more radicals $R^2$, or an aryloxy or heteroaryloxy group with 5 to 60 aromatic ring atoms, which may be substituted with one or more radicals $R^9$, or a diarylamino group, diheteroarylamino group or arylheteroarylamino group with 10 to 40 aromatic ring atoms, which may be substituted with one or more radicals $R^9$, or a combination of these systems; wherein $R^2$ to $R^9$ are defined as in claim 1.

**6.** The use of an organic molecule according to claim 1 to 5 as a luminescent emitter and/or as a host material and/or as an electron transport material and/or as a hole injection material and/or as a hole blocking material in an optoelectronic component.

**7.** The use according to claim 6, wherein the optoelectronic component is selected from the group consisting of:

- organic light-emitting diodes (OLEDs),
- light-emitting electrochemical cells,
- OLED sensors, particularly in gas and vapor sensors that are not hermetically sealed toward the outside,
- organic diodes

- organic solar cells,
- organic transistors
- organic field effect transistors,
- organic lasers and
- down-conversion elements.

**8.** The use according to claim 6 or 7, wherein the fraction of the organic molecule in the emitter 1 % amounts to 99 %.

**9.** The use according to claim 6, 7 or 8, wherein the concentration of the organic molecule as an emitter in optical light-emitting components, particularly in OLEDs, is between 5 % and 80 %.

**10.** The optoelectronic component, comprising an organic molecule according to claim 1 to 5, particularly formed as a component selected from the group consisting of an organic light-emitting diode (OLED), light-emitting electrochemical cell, OLED sensor, particularly in gas and vapor sensors not hermetically sealed toward the outside, organic diode, organic solar cell, organic transistor, organic field effect transistor, organic laser and down-conversion element.

**11.** The optoelectronic component according to claim 10, comprising

- a substrate,
- an anode and
- a cathode, wherein the anode and the cathode are applied to the substrate, and
- at least one light-emitting layer, which is disposed between the anode and cathode and which contains an organic molecule according to claim 1 to 5.

**12.** The optoelectronic component according to claim 11, in which the light-emitting layer at comprises at least one host material, wherein the activated singlet state ($S_1$) and/or the activated triplet state ($T_1$) of the at least one host material is higher than the activated singlet state ($S_1$) and/or activated triplet state ($T_1$) of the organic molecule according to claim 1 to 5.

**13.** The optoelectronic component according to claim 10 to 12, comprising at least one host material consisting of a material according to claim 1 to 5.

**14.** The optoelectronic component according to claim 10 to 13, wherein the light-emitting layer comprises fluorescent or phosphorescent materials and wherein the materials of the light-emitting layer are organic molecules according to claim 1 to 5.

**15.** The optoelectronic component according to claim 14, in which an organic molecule according to claim 1 to 5 together with a functional material forms an exciplex.

**16.** The optoelectronic component according to claim 10 to 15, in which an organic molecule according to claim 1 to 5 is used as a charge transport layer.

**17.** The method for producing an optoelectronic component in which an organic molecule according to claim 1 to 5 is used.

**18.** The method according to claim 17, wherein the processing of the organic molecule takes place using a vacuum evaporation method or from a solution.

## Revendications

**1.** Molécule organique, présentant une structure de formule 3b

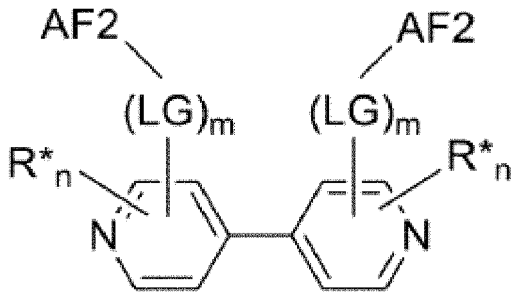

formule 3b

m étant 0 ou 1 ;
n étant 1, 2 ou 3 ;
LG étant un groupe lieur divalent, choisi dans le groupe constitué par :

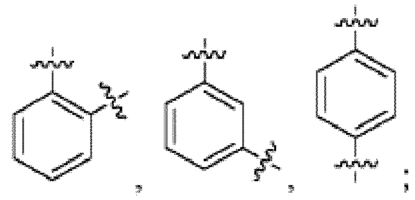

ou LG étant une liaison simple élément-élément ;
AF2 présentant une structure de formule 2 :

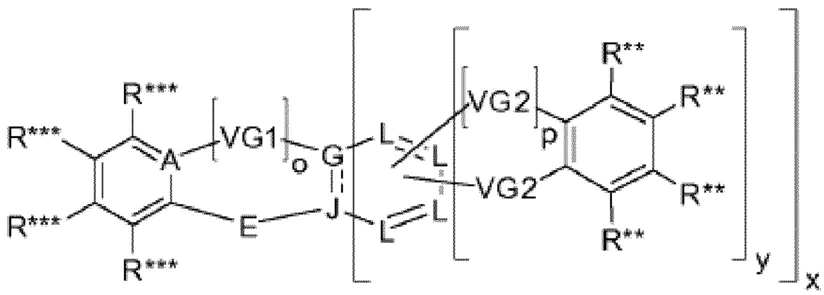

formule 2

x étant 1 ;
y étant 0 ;
o étant 0 ou 1 ;
A étant CR*** lorsque o = 0, sinon C ;
VG1 étant un groupe pontant et étant choisi dans le groupe constitué par

- NR**, $CR^{**}_2$, O, S, une simple liaison C-C, BR**, AsR**, $SiR^{**}_2$, $GeR^{**}_2$,

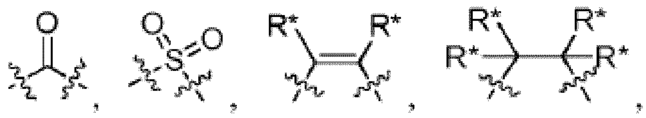

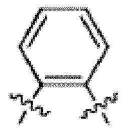, 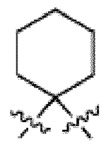, 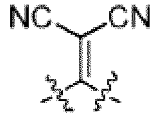, 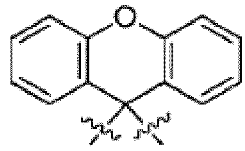,

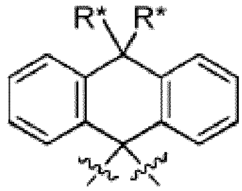, 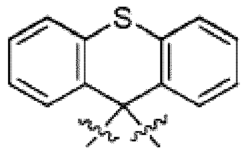 et 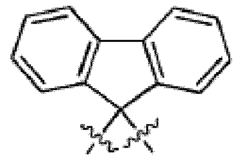;

E étant NR**,

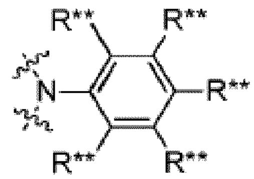,

O ou S;
G étant C lorsque o = 1 ; G étant CR** lorsque o = 0 ;
J étant C ;
L étant CR*** ;
R*** étant R** ou étant choisi parmi les motifs suivants, au maximum deux des radicaux R*** étant en même temps égaux à un des motifs suivants :

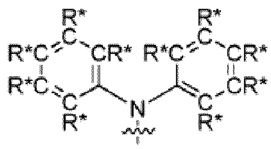, 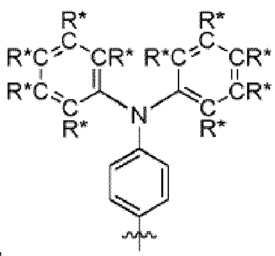, 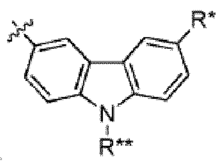, 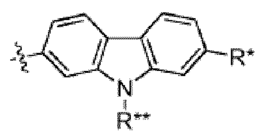,

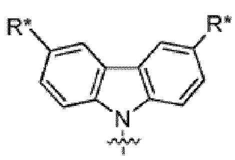, 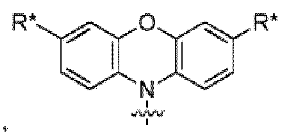, 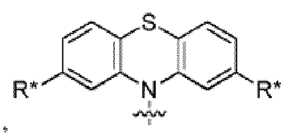,

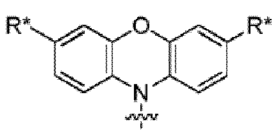, 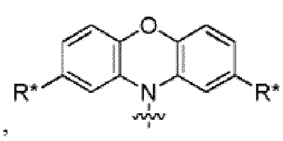;

R** étant en chaque occurrence indépendamment les uns des autres un radical R* et/ou marquant le point de liaison au groupe lieur LG ou, lorsque m = 0, au motif pyridine de formule 3b ;
R* étant en chaque occurrence indépendamment les uns des autres choisis dans le groupe constitué par H, deutérium, phényle, naphtyle, $N(R^2)_2$, -SCN, $-CF_3$,$-NO_2$, $Si(R^4)_3$, un groupe alkyle, alcoxy ou thioalcoxy linéaire comportant 1 à 40 atome(s) de C, qui peut à chaque fois être substitué par un ou plusieurs radicaux $R^9$, un

groupe $CH_2$ voisin pouvant être remplacé par -Si($R^4$)$_2$-, -Ge($R^4$)$_2$-, -Sn($R^4$)$_2$, -$NR^2$-, -O-, ou -S- et un ou plusieurs atomes de H pouvant être remplacés par deutérium, F, Cl, Br, I, $CF_3$ ou $NO_2$, ou un système cyclique aromatique ou hétéroaromatique comportant 5 à 60 atomes de cycle aromatiques, qui peut à chaque fois être substitué par un ou plusieurs radicaux $R^2$, ou un groupe aryloxy ou hétéroaryloxy comportant 5 à 60 atomes de cycle aromatiques, qui peut être substitué par un ou plusieurs radicaux $R^9$, ou un groupe diarylamino, un groupe dihétéroarylamino ou un groupe arylhétéroarylamino comportant 10 à 40 atomes de cycle aromatiques, qui peut être substitué par un ou plusieurs radicaux $R^9$, ou une combinaison de ces systèmes ;

$R^2$ étant en chaque occurrence indépendamment les uns des autres choisis dans le groupe constitué par H, deutérium, phényle, naphtyle, $CF_3$, -Si($R^4$)$_3$, un groupe alkyle, alcoxy ou thioalcoxy linéaire comportant 1 à 40 atome(s) de C, qui peut à chaque fois être substitué par un ou plusieurs radicaux $R^9$, un groupe $CH_2$ voisin pouvant être remplacé par -Si($R^4$)$_2$-, -Ge($R^4$)$_2$-, -Sn($R^4$)$_2$-, -$NR^2$-, -O-, ou -S- et un ou plusieurs atomes de H pouvant être remplacés par deutérium, F, Cl, Br, I, $CF_3$ ou $NO_2$, ou un système cyclique aromatique ou hétéroaromatique comportant 5 à 60 atomes de cycle aromatiques, qui peut à chaque fois être substitué par un ou plusieurs radicaux $R^9$, ou un groupe aryloxy ou hétéroaryloxy comportant 5 à 60 atomes de cycle aromatiques, qui peut être substitué par un ou plusieurs radicaux $R^9$, ou un groupe diarylamino, un groupe dihétéroarylamino ou un groupe arylhétéroarylamino comportant 10 à 40 atomes de cycle aromatiques, qui peut être substitué par un ou plusieurs radicaux $R^9$, ou une combinaison de ces systèmes ;

$R^4$ étant en chaque occurrence indépendamment les uns des autres choisis dans le groupe constitué par H, deutérium, phényle, naphtyle, N($R^2$)$_2$, $CF_3$, OH, un groupe alkyle, alcoxy ou thioalcoxy linéaire comportant 1 à 40 atome(s) de C, qui peut à chaque fois être substitué par un ou plusieurs radicaux $R^9$, un groupe $CH_2$ voisin pouvant être remplacé par -Si($R^4$)$_2$-, -Ge($R^4$)$_2$-, -Sn($R^4$)$_2$, -$NR^2$-, -O-, ou -Set un ou plusieurs atomes de H pouvant être remplacés par deutérium, F, Cl, Br, I, $CF_3$ ou $NO_2$, ou un système cyclique aromatique ou hétéroaromatique comportant 5 à 60 atomes de cycle aromatiques, qui peut à chaque fois être substitué par un ou plusieurs radicaux $R^8$, ou un groupe aryloxy ou hétéroaryloxy comportant 5 à 60 atomes de cycle aromatiques, qui peut être substitué par un ou plusieurs radicaux $R^9$, ou un groupe diarylamino, un groupe dihétéroarylamino ou un groupe arylhétéroarylamino comportant 10 à 40 atomes de cycle aromatiques, qui peut être substitué par un ou plusieurs radicaux $R^9$, ou une combinaison de ces systèmes ;

$R^8$ étant en chaque occurrence indépendamment les uns des autres choisis dans le groupe constitué par H, deutérium, phényle, naphtyle, F, $CF_3$ ou un radical hydrocarboné aliphatique, aromatique et/ou hétéroaromatique comportant 1 à 20 atome(s) de C, dans lequel également un ou plusieurs atomes de H peuvent être remplacés par F ou $CF_3$ ;

$R^9$ étant en chaque occurrence indépendamment les uns des autres choisis dans le groupe constitué par H, deutérium, phényle, naphtyle, N($R^2$)$_2$, $CF_3$, $NO_2$, OH,-Si($R^4$)$_3$, un groupe alkyle, alcoxy ou thioalcoxy linéaire comportant 1 à 40 atome(s) de C, qui peut à chaque fois être substitué par un ou plusieurs radicaux $R^8$, un groupe $CH_2$ voisin pouvant être remplacé par -Si($R^4$)$_2$-, -Ge($R^4$)$_2$-, -Sn($R^4$)$_2$, -$NR^2$-, -O-, ou -S- et un ou plusieurs atomes de H pouvant être remplacés par deutérium, F, Cl, Br, I, $CF_3$ ou $NO_2$, ou un système cyclique aromatique ou hétéroaromatique comportant 5 à 60 atomes de cycle aromatiques, qui peut à chaque fois être substitué par un ou plusieurs radicaux $R^8$, ou un groupe aryloxy ou hétéroaryloxy comportant 5 à 60 atomes de cycle aromatiques, qui peut être substitué par un ou plusieurs radicaux $R^3$, ou un groupe diarylamino, un groupe dihétéroarylamino ou un groupe arylhétéroarylamino comportant 10 à 40 atomes de cycle aromatiques, qui peut être substitué par un ou plusieurs radicaux $R^8$, ou une combinaison de ces systèmes.

**2.** Molécule organique selon la revendication 1, AF2 présentant une structure de formule 4 :

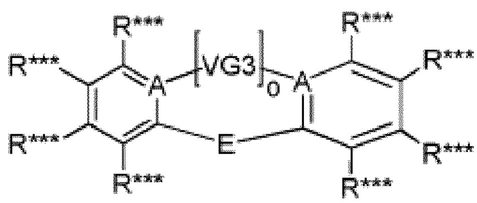

formule 4

o étant 0 ou 1 ;
A étant CR*** lorsque o = 0, sinon C ;
VG3 = groupe pontant étant NR**, CR**$_2$, O, S ou une simple liaison C-C,
E étant NR** ou

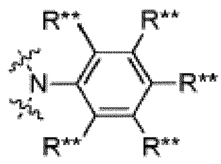

;

R*** étant R** ou étant choisi parmi les motifs suivants, au maximum deux des radicaux R*** étant en même temps égaux à un des motifs suivants :

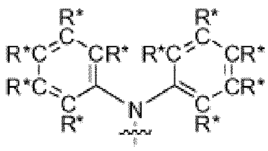

,

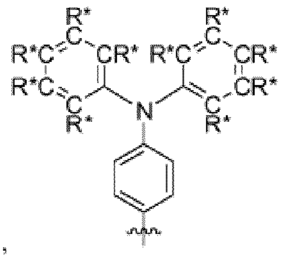

,

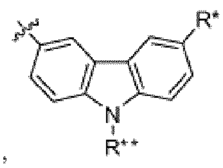

,

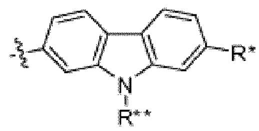

,

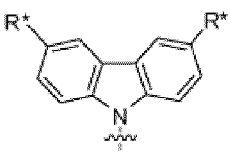

,

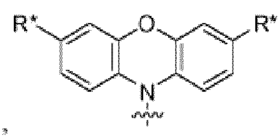

,

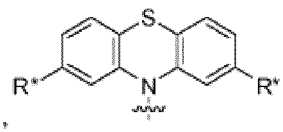

,

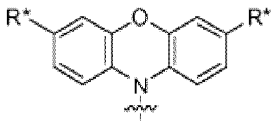

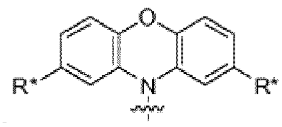

.

et R** et R* étant tels que définis dans la revendication 1.

**3.** Molécule organique selon la revendication 1 ou 2, m étant égal à 0.

**4.** Molécule organique selon la revendication 1, présentant une des structures 3.1, 3.2, 3.5 ou 3.6, éventuellement tous les groupes $C_{sp2}$-H pouvant être également des groupes $C_{sp2}$-R* et pour le reste les définitions indiquées dans la revendication 1 étant appliquées :

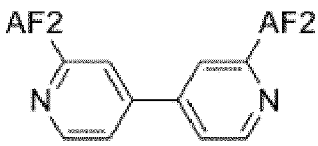

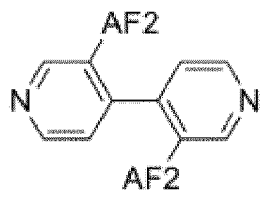

3.1 3.2

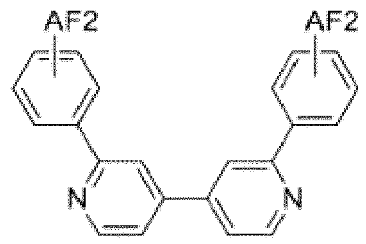

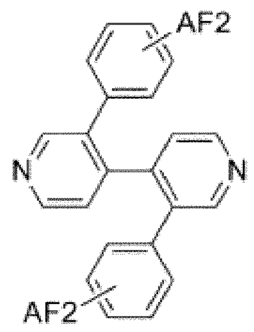

3.5 3.6

5. Molécule organique selon les revendications 1 à 4, la molécule organique présentant au moins un radical R au niveau d'au moins une position substituable chimiquement, en particulier pour l'augmentation de la solubilité :
R étant en chaque occurrence indépendamment les uns des autres choisis dans le groupe constitué par H, deutérium, phényle, naphtyle, F, Cl, Br, I, $N(R^2)_2$, -SCN, $-CF_3$, $-NO_2$, -OH, $-Si(R^4)_3$, un groupe alkyle, alcoxy ou thioalcoxy linéaire comportant 1 à 40 atome(s) de C, qui peut à chaque fois être substitué par un ou plusieurs radicaux $R^9$, un groupe $CH_2$ voisin pouvant être remplacé par $-Si(R^4)_2-$, $-Ge(R^4)_2-$, $-Sn(R^4)_2$, $-NR^2-$, -O-, ou -S- et un ou plusieurs atomes de H pouvant être remplacés par deutérium, F, Cl, Br, I, $CF_3$ ou $NO_2$, ou un système cyclique aromatique ou hétéroaromatique comportant 5 à 60 atomes de cycle aromatiques, qui peut à chaque fois être substitué par un ou plusieurs radicaux $R^2$, ou un groupe aryloxy ou hétéroaryloxy comportant 5 à 60 atomes de cycle aromatiques, qui peut être substitué par un ou plusieurs radicaux $R^9$, ou un groupe diarylamino, un groupe dihétéroarylamino ou un groupe arylhétéroarylamino comportant 10 à 40 atomes de cycle aromatiques, qui peut être substitué par un ou plusieurs radicaux $R^9$, ou une combinaison de ces systèmes ; $R^2$ à $R^9$ étant tels que définis dans la revendication 1.

6. Utilisation d'une molécule organique selon les revendications 1 à 5 en tant que qu'émetteur luminescent et/ou en tant que matériau hôte et/ou en tant que matériau de transport d'électrons et/ou en tant que matériau d'injection de trou et/ou en tant que matériau de blocage de trou dans un composant optoélectronique.

7. Utilisation selon la revendication 6, le composant optoélectronique étant choisi dans le groupe constitué par :

- des diodes organiques luminescentes (OLED),
- des cellules électrochimiques luminescentes,
- des capteurs OLED, en particulier dans des capteurs de gaz et des capteurs de vapeur non protégés hermétiquement vers l'extérieur,
- des diodes organiques
- des cellules solaires organiques,
- un transistor organique
- des transistors organiques à effet de champ,
- des lasers organiques et
- des éléments de conversion d'abaissement.

8. Utilisation selon la revendication 6 ou 7, la proportion de la molécule organique dans l'émetteur étant de 1 % à 99 %.

9. Utilisation selon la revendication 6, 7 ou 8, la concentration de la molécule organique en tant qu'émetteur dans des composants optiques luminescents, en particulier dans des OLED, étant comprise entre 5 % et 80 %.

10. Composant optoélectronique, présentant une molécule organique selon les revendications 1 à 5, en particulier formé en tant que composant choisi dans le groupe constitué par une diode organique luminescente (OLED), une cellule électrochimique luminescente, un capteur OLED, en particulier dans des capteurs de gaz et un capteur de vapeur non protégés hermétiquement vers l'extérieur, des diodes organiques, des cellules solaires organiques, un transistor organique, un transistor organique à effet de champ, un laser organique et un élément de conversion d'abaissement.

11. Composant optoélectronique selon la revendication 10, présentant

- un substrat,
- une anode et
- une cathode, l'anode et la cathode étant appliquées sur le substrat, et
- au moins une couche luminescente, qui est disposée entre l'anode et la cathode et qui contient une molécule organique selon les revendications 1 à 5.

**12.** Composant optoélectronique selon la revendication 11, dans lequel la couche luminescente présente au moins un matériau hôte, l'état singulet excité ($S_1$) et/ou l'état triplet excité ($T_1$) de l'au moins un matériau hôte étant plus haut que l'état singulet excité ($S_1$) et/ou l'état triplet excité ($T_1$) de la molécule organique selon les revendications 1 à 5.

**13.** Composant optoélectronique selon les revendications 10 à 12, présentant au moins un matériau hôte constitué d'un matériau selon les revendications 1 à 5.

**14.** Composant optoélectronique selon les revendications 10 à 13, la couche luminescente présentant des matériaux fluorescents ou phosphorescents et les matériaux de la couche luminescente étant des molécules organiques selon les revendications 1 à 5.

**15.** Composant optoélectronique selon la revendication 14, dans lequel une molécule organique selon les revendications 1 à 5, conjointement avec un matériau fonctionnel, forment un exciplexe.

**16.** Composant optoélectronique selon les revendications 10 à 15, dans lequel une molécule organique selon les revendications 1 à 5 est utilisée en tant que couche de transport de charge.

**17.** Procédé pour la préparation d'un composant optoélectronique, une molécule organique selon les revendications 1 à 5 étant utilisée.

**18.** Procédé selon la revendication 17, le traitement de la molécule organique est effectué à l'aide d'un procédé d'évaporation sous vide ou à partir d'une solution.

Figur 1

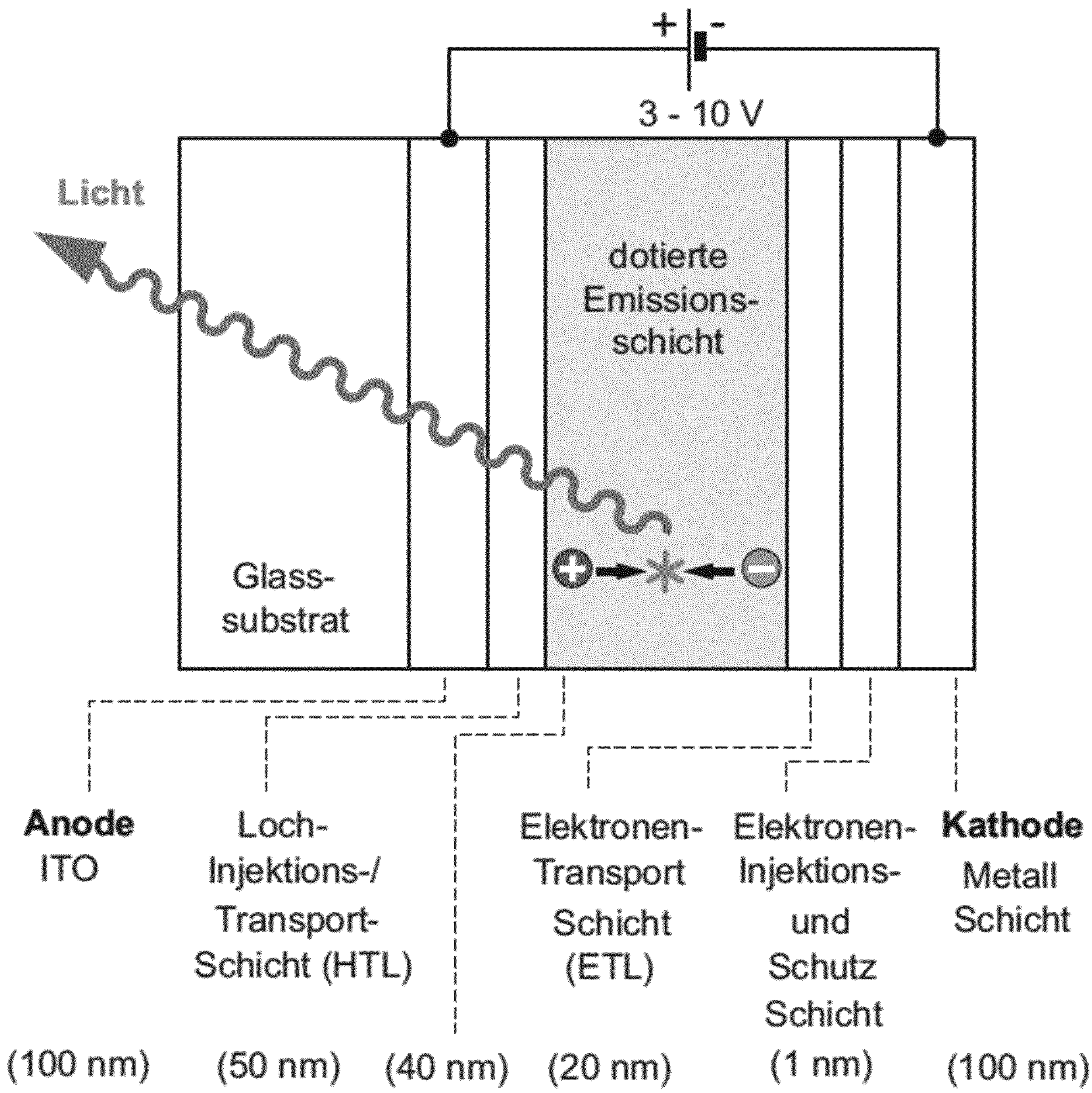
+
-
3 - 10 V
Licht
dotierte Emissions-schicht
Glass-substrat
Anode ITO (100 nm)
Loch-Injektions-/Transport-Schicht (HTL) (50 nm)
(40 nm)
Elektronen-Transport Schicht (ETL) (20 nm)
Elektronen-Injektions- und Schutz Schicht (1 nm)
Kathode Metall Schicht (100 nm)

Figur 2

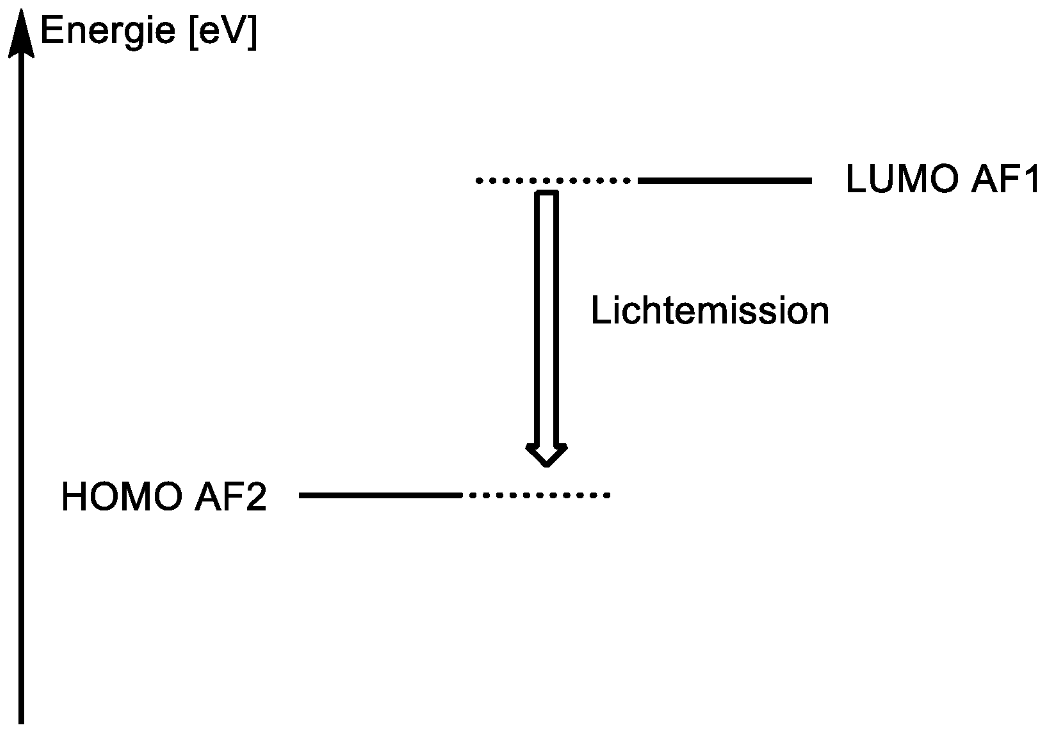

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2010090925 A1


### In der Beschreibung aufgeführte Nicht-Patentliteratur


- **H. YERSIN.** Top. Curr. Chem. 2004, vol. 241, 1
- **H. YERSIN.** Highly Efficient OLEDs with Phosphorescent Materials. Wiley-VCH, 2008
- **TANG et al.** *Appl. Phys. Lett.,* 1987, vol. 51, 913
- **SIEHE DAZU ; H. YERSIN.** *Top. Curr. Chem.,* 2004, vol. 241, 1
- **M. A. BALDO ; D. F. O'BRIEN ; M. E. THOMPSON ; S. R. FORREST.** *Phys. Rev. B,* 1999, vol. 60, 14422
- **BECKE, A. D.** *Phys. Rev.,* vol. A1988 (38), 3098-3100
- **PERDEW, J. P.** *Phys. Rev. B,* 1986, vol. 33, 8822-8827
- **WEIGEND, F. ; AHLRICHS, R.** *Phys. Chem. Chem. Phys.,* 2005, vol. 7, 3297-3305
- **RAPPOPORT, D. ; FURCHE, F.** *J. Chem. Phys.,* 2010, vol. 133, 134105, , 1-134105, 11
- **HÄSER, M. ; AHLRICHS, R.** *J. Comput. Chem.,* 1989, vol. 10, 104-111
- **WEIGEND, F. ; HÄSER, M.** *Theor. Chem. Acc.,* 1997, vol. 97, 331-340
- **SIERKA, M. ; HOGEKAMP, A. ; AHLRICHS, R.** *J. Chem. Phys.,* 2003, vol. 118, 9136-9148
- **SIERKA, M. ; HOGEKAMP, A. ; AHLRICHS, R.** *J. Chem. Phys.,* 2003, vol. 118, 9136-9148
- **BECKE, A.D.** *J.Chem.Phys.,* 1993, vol. 98, 5648-5652
- **LEE, C ; YANG, W ; PARR, R.G.** *Phys. Rev. B,* 1988, vol. 37, 785-789
- **VOSKO, S. H. ; WILK, L. ; NUSAIR, M.** *Can. J. Phys.,* 1980, vol. 58, 1200-1211
- **STEPHENS, P. J. ; DEVLIN, F. J. ; CHABALOWSKI, C. F. ; FRISCH, M. J.** *J.Phys.Chem.,* 1994, vol. 98, 11623-11627
- **RAPPOPORT, D. ; FURCHE, F. J.** *Chem. Phys.,* 2010, vol. 133, 134105, , 1-134105, 11